# EUROPÄISCHE PATENTSCHRIFT

(11) **EP 2 344 609 B1**
(45) Veröffentlichungstag und Bekanntmachung des Hinweises auf die Patenterteilung: **15.07.2015**
(21) Anmeldenummer: 09778889.7
(22) Anmeldetag: 14.10.2009
(51) Int. Cl.: C09K 11/06, C07F 7/00, C07F 7/02, C07F 7/10, C07F 7/12, C07F 7/22, C07F 7/30, C09B 57/00, H01L 51/50, C09B 57/10, H01L 51/00

(54) **MATERIALIEN FÜR ORGANISCHE ELEKTROLUMINESZENZVORRICHTUNGEN**
MATERIALS FOR ORGANIC ELECTROLUMINESCENCE DEVICES
MATIÈRES POUR DES DISPOSITIFS ÉLECTROLUMINESCENTS ORGANIQUES

(30) Priorität: 11.11.2008 DE 102008056688
(43) Veröffentlichungstag der Anmeldung: 20.07.2011
(73) Patentinhaber: Merck Patent GmbH, 64293 Darmstadt (DE)
(72) Erfinder: STOESSEL, Philipp, 60487 Frankfurt (DE); HEIL, Holger, 60389 Frankfurt (DE); JOOSTEN, Dominik, 60487 Frankfurt (DE); PFLUMM, Christof, 60316 Frankfurt (DE); GERHARD, Anja, 63329 Egelsbach (DE)
(86) Internationale Anmeldenummer: PCT/EP2009/007361
(87) Internationale Veröffentlichungsnummer: WO 2010/054729

(56) Entgegenhaltungen:
- DE-A1- 1 595 978
- DE-A1- 19 711 154
- JP-A- 9 237 927
- JP-A- 2001 338 768
- JP-A- 2007 096 102
- US-A- 5 866 471
- ALVAREZ R ET AL: "NEMATIC TRIBENZOSILATRANES" LIQUID CRYSTALS, TAYLOR AND FRANCIS, ABINGDON, GB, Bd. 32, Nr. 4, 1. April 2005 (2005-04-01), Seiten 469-476, XP001228422 ISSN: 0267-8292
- HILL N J ET AL: "Recent developments in the chemistry of stable silylenes" JOURNAL OF ORGANOMETALLIC CHEMISTRY, ELSEVIER-SEQUOIA S.A. LAUSANNE, CH, Bd. 689, Nr. 24, 29. November 2004 (2004-11-29), Seiten 4165-4183, XP004650662 ISSN: 0022-328X
- HEINICKE J ET AL: "Synthesis of silicon heterocycles via gas phase cycloaddition of aminomethylsilylenes" JOURNAL OF ORGANOMETALLIC CHEMISTRY, ELSEVIER-SEQUOIA S.A. LAUSANNE, CH, Bd. 561, Nr. 1-2, 30. Juni 1998 (1998-06-30), Seiten 121-129, XP004128638 ISSN: 0022-328X
- MATTHIAS WENZEL: "A Novel Synthesis of Tetraaminoethenes by Reduction of Oxalic Amidines and Subsequent Electrophilic Substitution" EUROPEAN JOURNAL OF ORGANIC CHEMISTRY, 1998, Seiten 183-187, XP002570269 Weinheim
- MING-DER SU: "Theoretical Study of Halophilic Reactions of Stable Silylenes with Bromocarbons" JOURNAL OF THE AMERICAN CHEMICAL SOCIETY, Bd. 125, 23. Januar 2002 (2002-01-23), Seiten 1714-1715, XP002570270 USA
- KATSUMI KUBOTA: "Strained silacycle-catalyzed asymmetric Diels-Alder cycloadditions" TETRAHEDRON, Bd. 62, 12. Juli 2006 (2006-07-12), Seiten 11397-11401, XP002570271 USA
- ANTHONY J. ARDUENGO: "Photoelectron Spectroscopy of a Carbene/Silylene/Germylene Series" JOURNAL OF THE AMERICAN CHEMICAL SOCIETY, Bd. 116, 1994, Seiten 6641-6649, XP002570272 usa
- XIAOPING CAI: "Reactions of the stable bis(amino)silylene S8[{N(CH2tBu)}2C6H4-1,2] with group 3 or lanthanide metal organic compounds" CANADIAN JOURNAL OF CHEMISTRY, Bd. 78, 2. November 2000 (2000-11-02), Seiten 1484-1490, XP002570273 Canada
- PHILIP BLAKEMAN ET AL: "Electronic structure of stable benzodiazasilylenes: photoelectron spectra and quantum-chemical investigations" JOURNAL OF THE CHEMICAL SOCIETY, DALTON TRANSACTIONS, CHEMICAL SOCIETY. LETCHWORTH, GB, Nr. 8, 1. Januar 1996 (1996-01-01), Seiten 1475-1480, XP008119271 ISSN: 1472-7773
- OHMORI YASUHARU ET AL: "Chromatographic resolution mechanism of a tris(1,10-phenanthroline)si licon(IV) complex" JOURNAL OF COORDINATION CHEMISTRY, TAYLOR & FRANCIS, LONDON, Bd. 39, Nr. 3-4, 1. Januar 1996 (1996-01-01), Seiten 219-230, XP008119473 ISSN: 0095-8972
- GEHRHUS BARBARA ET AL: "Cycloaddition of thermolytically generated methoxymethylsilylene to .alpha.,.beta.-unsaturated ketones and imines" MAIN GROUP METAL CHEMISTRY, TEL AVIV, IL, Bd. 21, Nr. 2, 1. Januar 1998 (1998-01-01), Seiten 99-104, XP008119477 ISSN: 0792-1241
- NICHOLAS J. HILL: "Reactions of Stable Silylenes with Organic Azides" ORGANOMETALLICS, Bd. 24, 14. Mai 2005 (2005-05-14), Seiten 3346-3349, XP002570274 USA
- DANIEL F. MOSER: "Formation of Disilanes in the Reaction of Stable Silylenes with Halocarbons" JOURNAL OF THE AMERICAN CHEMICAL SOCIETY, Bd. 127, 2005, Seiten 14730-14738, XP002570275 USA
- HEINDIRK TOM DIECK ET AL: "Reaktionen mit Radikalanionen, I. Synthese offenkettiger und cyclischer, silylierter 1,2-Ethendiamine" CHEMISCHE BERICHTE, VERLAG CHEMIE GMBH. WEINHEIM, DE, Bd. 116, Nr. 1, 1. Januar 1983 (1983-01-01), Seiten 136-145, XP008119270 ISSN: 0009-2940 [gefunden am 2006-01-23]
- HEINDIRK TOM DIECK: "[2+2]-Cycloadditionen" CHEMISCHE BERICHTE, Bd. 120, 1987, Seiten 795-801, XP002570276 Weinheim
- JOACHIM HEINICKE: "Zur Chemie der Silylene" JOURNAL OF ORGANOMETALLIC CHEMISTRY, Bd. 423, 1992, Seiten 13-21, XP002570285 Lausanne
- KARSCH HANS H ET AL: "A new route to silaheterocycles: heterobutadiene cycloaddition" ORGANOSILICON CHEMISTRY III : FROM MOLECULES TO MATERIALS, WEINHEIM [U.A.] : WILEY-VCH, 1. Januar 1998 (1998-01-01), Seiten 53-57, XP008119491 ISBN: 978-3-527-29450-3

## Beschreibung

Die vorliegende Erfindung betrifft neue Materialien für organische Elektrolumineszenzvorrichtungen sowie organische Elektrolumineszenzvorrichtungen enthaltend derartige Materialien.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Dabei wird generell zwischen fluoreszierenden und phosphoreszierenden OLEDs unterschieden. Als emittierende Materialien werden hierbei zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, insbesondere auch bei OLEDs, die Triplettemission zeigen, jedoch immer noch Verbesserungsbedarf. So sind bei den physikalischen Eigenschaften von phosphoreszierenden OLEDs im Hinblick auf Effizienz, Betriebsspannung und Lebensdauer noch Verbesserungen wünschenswert für die Verwendung von Triplettemittern in hochwertigen und langlebigen Elektrolumineszenzvorrichtungen. Dies gilt insbesondere für OLEDs, welche im kürzerwelligen Bereich, also grün und insbesondere blau, emittieren. So sind bislang keine Devices mit blau emittierenden Triplettemittern bekannt, welche die technischen Anforderungen für eine industrielle Anwendung erfüllen.

Gemäß dem Stand der Technik werden in phosphoreszierenden OLEDs als Triplettemitter insbesondere Iridiumkomplexe eingesetzt. Die Eigenschaften von phosphoreszierenden OLEDs werden nicht nur von den eingesetzten Triplettemittern bestimmt. Hier sind insbesondere auch die anderen verwendeten Materialien, wie Matrixmaterialien, Lochblockiermaterialien, Lochtransportmaterialien und Elektronen- bzw. Exzitonenblockiermaterialien von besonderer Bedeutung. Verbesserungen dieser Materialien können somit auch zu deutlichen Verbesserungen der OLED-Eigenschaften führen. Auch für fluoreszierende OLEDs gibt es bei diesen Materialien noch Verbesserungsbedarf.

Die JP 2001 338768 offenbart OLEDs mit einer Schicht zwischen den Elektroden, die einen Metallkomplex umfasst, der einem tetradentaten Ligand enthält, der ein Tetrapyrol-Ligand oder Tetrapyrolderivat-Ligand ist.

In der US 2004/0048101 werden elektronenblockierende Schichten und diese enthaltende OLEDs offenbart, die einen Metallkomplex umfassen, der zwischen einem und drei bidentaten Liganden enthalten kann. Diese Liganden bestehen aus einem Pyrazolring, der in 1-Position mit einem Phenylring verknüpft ist. Die Liganden binden jeweils über die 2-Position der beiden Ringe an das Metallatom. Der Metallkomplex enthält gegebenenfalls weitere mono- oder bidentate Liganden. Das Metallatom ist bevorzugt Iridium.

Die US 2008/0093988 offenbart einen bestimmten OLED-Aufbau mit mehreren emittierenden Schichten. Dabei ist dieser Device-Aufbau durch die Anwesenheit einer elektronen- bzw. exzitonenblockierenden Schicht zwischen den emittierenden Schichten charakterisiert. Für diese Schicht wird ein Lochtransportmaterial in Kombination mit Ir(ppy)₃ eingesetzt.

Die WO 04/084260 offenbart OLEDs umfassend eine Schicht, die ein Lochtransportmaterial und ein elektronenblockierendes Material enthält, wobei diese Schicht bevorzugt Verbindungen mit einer Triarylstruktur enthält, die auch als sich wiederholende Einheit in einem Polymer auftreten kann.

Die WO 07/120788 offenbart OLEDs mit einer zwischen den Elektroden befindlichen organischen Schicht, die eine Phthalimidverbindung enthält. Dabei wird die Phthalimidverbindung unter anderem in einer Exzitonenblockierschicht eingesetzt.

Aus der WO 08/034758 sind OLEDs bekannt, die in mindestens einer der Schichten mindestens eine Verbindung mit wenigstens einem Strukturelement des Carbazols enthalten, wobei das Stickstoffatom des Carbazols mit verschiedenen organischen Resten substituiert oder selbst gänzlich durch andere Heteroatome oder funktionelle Gruppen, die Heteroatome enthalten, ersetzt sein kann. Die vorgenannte Verbindung kann dabei die Funktion eines Lochblockier- und/oder Exzitonenblockiermaterials erfüllen. Aufgabe der vorliegenden Erfindung ist die Bereitstellung von Verbindungen, welche sich für den Einsatz in einer fluoreszierenden oder phosphoreszierenden OLED, insbesondere einer phosphoreszierenden OLED, eignen, beispielsweise als Matrixmaterial oder als Lochtransport-/ Elektronenblockiermaterial bzw. Exzitonenblockiermaterial. Insbesondere ist die Aufgabe, Exzitonenblockiermaterialien bzw. Elektronenblockiermaterialien und Matrixmaterialien bereitzustellen, welche sich für blau und grün phosphoreszierende OLEDs eignen.

Überraschend wurde gefunden, dass bestimmte, unten näher beschriebene Verbindungen diese Aufgabe lösen und zu deutlichen Verbesserungen der organischen Elektrolumineszenzvorrichtung führen, insbesondere hinsichtlich der Lebensdauer, der Effizienz und der Betriebsspannung. Dies gilt insbesondere für blau und grün phosphoreszierende Elektrolumineszenzvorrichtungen. Diese Verbindungen und organische Elektrolumineszenzvorrichtungen, welche derartige Verbindungen enthalten, sind daher der Gegenstand der vorliegenden Erfindung.

Gegenstand der vorliegenden Erfindung sind somit Verbindungen gemäß Formel (9), 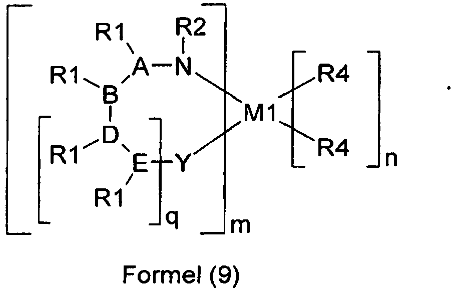 worin
- M1: Si, Ge oder Sn ist;
- q: 0 oder 1 ist
- A, B, D und E: jeweils ein C-Atom ist; dabei liegt zwischen A und B eine Doppelbindung bzw. eine aromatische Bindung vor, wenn A nicht mit N ein aromatisches System aufspannt, und es liegt zwischen A und B eine Einfachbindung vor, wenn A mit N ein aromatisches System aufspannt; weiterhin liegt zwischen D und E eine Doppelbindung bzw. eine aromatische Bindung vor, wenn E nicht mit Y ein aromatisches System aufspannt, und es liegt zwischen D und E eine Einfachbindung vor, wenn E mit Y ein aromatisches System aufspannt;
- Y: ausgewählt ist aus der Gruppe bestehend aus NR2, O und S;
- R1: ausgewählt ist aus der Gruppe bestehend aus H, D, F, Cl, Br, I, CN, NO₂, N(R3)₂, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder eine Alkenylgruppe mit 2 bis 40 C-Atomen, die jeweils mit einem oder mehreren Resten R3 substituiert sein kann, wobei eine oder mehrere nicht-benachbarte CH₂-Gruppen durch R3C=CR3, C=C, Si(R3)₂, Ge(R3)₂, Sn(R3)₂, C=O, C=S, C=Se, C=NR3, P(=O)(R3), SO, SO₂, NR3, O, S oder CONR3 ersetzt sein können und wobei ein oder mehrere H-Atome durch D, F, Cl, Br, I, CN oder NO₂ ersetzt sein können, einem aromatischen oder heteroaromatischen Ringsystem mit 5 bis 60 aromatischen Ringatomen, das jeweils mit einem oder mehreren Resten R3 substituiert sein kann, einer Aryloxy- oder Heteroaryloxygruppe mit 5 bis 60 aromatischen Ringatomen, die mit einem oder mehreren Resten R3 substituiert sein können, und einer Kombination dieser Systeme, wobei optional jeweils zwei in der Verbindung gemäß Formel (9) in 1,2-Stellung zueinander benachbart stehende Substituenten R1 ein monocyclisches oder polycyclisches, gerade oder angular anelliertes, aliphatisches, aromatisches oder heteroaromatisches Ringsystem bilden können, das mit einem oder mehreren Resten R3 substituiert sein kann;
- R2: ausgewählt ist aus der Gruppe bestehend aus einer geradkettigen Alkylgruppe mit 1 bis 40 C-Atomen oder einer verzweigten oder cyclischen Alkylgruppe mit 3 bis 40 C-Atomen, die jeweils mit einem oder mehreren Resten R3 substituiert sein kann, wobei eine oder mehrere nicht-benachbarte CH₂-Gruppen durch R3C=CR3, C=C oder C=O ersetzt sein können und wobei ein oder mehrere H-Atome durch F, Cl, Br, I, CN oder NO₂ ersetzt sein können, einem aromatischen oder heteroaromatischen Ringsystem mit 5 bis 60 aromatischen Ringatomen, das jeweils mit einem oder mehreren Resten R3 substituiert sein kann, und einer Kombination dieser Systeme; mit der Maßgabe, dass in der Struktur gemäß Formel (9) mindestens eine Gruppe R2 vorhanden ist, welche ein aromatisches oder heteroaromatisches Ringsystem darstellt, das jeweils mit einem oder mehreren Resten R3 substituiert sein kann; dabei können optional solche R1 und R2, die in der Verbindung gemäß Formel (9) in 1,2-Position zueinander benachbart stehen, ein monocyclisches oder polycyclisches, gerade oder angular anelliertes, aliphatisches, aromatisches oder heteroaromatisches Ringsystem bilden, das mit einem oder mehreren Resten R3 substituiert sein kann;
- R4: bei jedem Auftreten gleich oder verschieden ist und ausgewählt ist aus der Gruppe bestehend aus N(R3)₂, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder Alkenylgruppe mit 2 bis 40 C-Atomen, die jeweils mit einem oder mehreren Resten R3 substituiert sein kann, wobei eine oder mehrere nicht-benachbarte CH₂-Gruppen durch R3C=CR3, C=C, Si(R3)₂, Ge(R3)₂, Sn(R3)₂, C=O, C=S, C=Se, C=NR3, P(=O)(R₃), SO, SO₂, NR3, O, S oder CONR3 ersetzt sein können und wobei ein oder mehrere H-Atome durch D, F, Cl, Br, I, CN oder NO₂ ersetzt sein können, einem aromatischen oder heteroaromatischen Ringsystem mit 5 bis 60 aromatischen Ringatomen, das jeweils mit einem oder mehreren Resten R3 substituiert sein kann, einer Aryloxy- oder Heteroaryloxygruppe mit 5 bis 60 aromatischen Ringatomen, die mit einem oder mehreren Resten R3 substituiert sein können, und einer Kombination dieser Systeme, wobei optional zwei oder mehr Substituenten R4 ein monocyclisches oder polycyclisches, gerade oder angular anelliertes, aliphatisches, aromatisches oder heteroaromatisches Ringsystem bilden können, das mit einem oder mehreren Resten R3 substituiert sein kann;
- R3: ausgewählt ist aus der Gruppe bestehend aus H, D, aliphatischem Kohlenwasserstoffrest mit 1 bis 20 C-Atomen, aromatischem oder heteroaromatischem Ringsystem mit 5 bis 30 aromatischen Ringatomen, in dem ein oder mehrere H-Atome durch D, F, Cl, Br, I, CN oder NO₂ ersetzt sein können;
- m: ist 1 oder 2;
- n: ist (2 - m);
dabei sind die folgenden Verbindungen von der Erfindung ausgeschlossen:

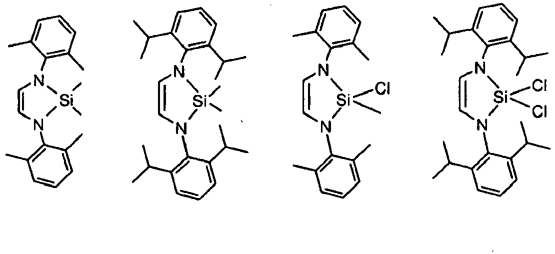

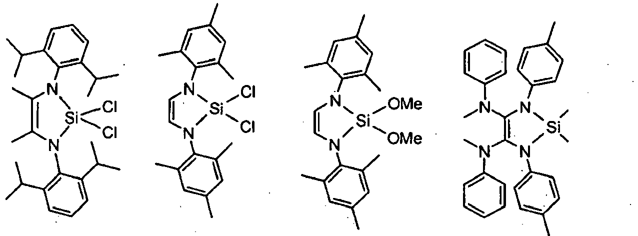

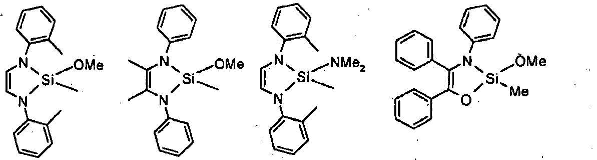

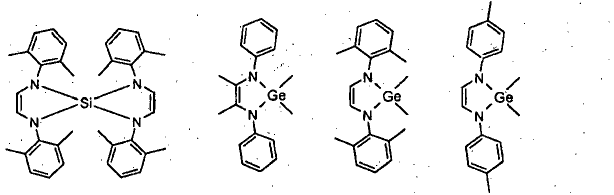

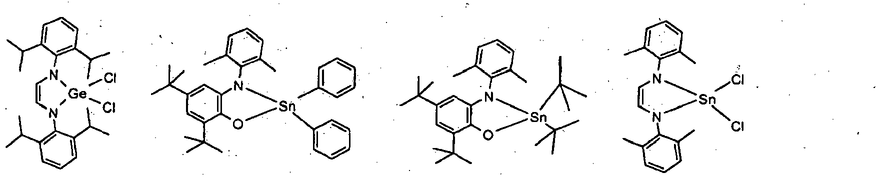

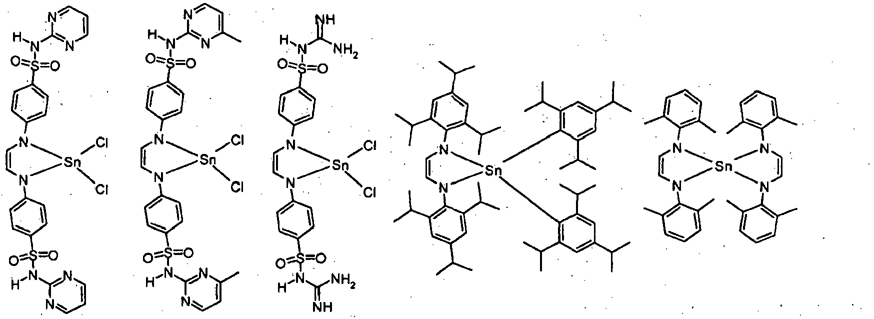

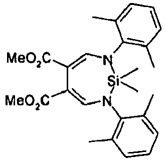

Dabei kann die Bindung zwischen M1 und N bzw. Y entweder koordinativ, also wie in einem Ligandenfeld, oder kovalent sein, wobei die Bindungsart durch das Metall bzw. Halbmetall M bestimmt wird.

Bevorzugt ist der Ligand bzw. die Gruppe, die an M bindet bzw. koordiniert, nicht Teil einer Porphinstruktur bzw. eines Porphyrinderivats. Bevorzugt enthält diese Struktur also keine vier Pyrrolgruppen bzw. Pyrrol-derivate, welche zu einer cyclischen Struktur gebunden sind.

Eine Arylgruppe im Sinne dieser Erfindung enthält 6 bis 60 C-Atome; eine Heteroarylgruppe im Sinne dieser Erfindung enthält 2 bis 60 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Aryl-gruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte (anellierte) Aryl- oder Heteroarylgruppe, beispielsweise Naphthalin, Anthracen, Phenanthren, Chinolin, Isochinolin, Carbazol, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroaryl-gruppen enthält, sondern in dem auch mehrere Aryl- oder Heteroarylgruppen durch eine nicht-aromatische Einheit (bevorzugt weniger als 10 % der von H verschiedenen Atome), wie z. B. ein sp³-hybridisiertes C-, N-oder O-Atom, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind.

Im Rahmen der vorliegenden Erfindung werden unter einem aliphatischem Kohlenwasserstoffrest bzw. einer Alkylgruppe, die typischerweise 1 bis 40 oder auch 1 bis 20 C-Atome enthalten kann, und in der auch einzelne H-Atome oder CH₂-Gruppen durch die oben genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl, Heptinyl oder Octinyl verstanden. Unter einer Alkoxygruppe mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy und 2,2,2-Trifluorethoxy verstanden. Unter einer Thioalkylgruppe mit 1 bis 40 C-Atomen werden insbesondere Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden. Allgemein können Alkyl-, Alkoxy- oder Thioalkylgruppen gemäß der vorliegenden Erfindung geradkettig, verzweigt oder cyclisch sein, wobei eine oder mehrere nicht-benachbarte CH₂-Gruppen durch R3C=CR3, C=C, Si(R3)₂, Ge(R3)₂, Sn(R3)₂, C=O, C=S, C=Se, C=NR3, P(=O)(R3), SO, SO₂, NR3, O, S oder CONR3 ersetzt sein können; weiterhin können auch ein oder mehrere H-Atome durch F, Cl, Br, I, CN oder NO₂, bevorzugt F, Cl oder CN, weiter bevorzugt F oder Cl, besonders bevorzugt F ersetzt sein. Unter einem aromatischen oder heteroaromatischen Ringsystem mit 5 - 60 aromatischen Ringatomen, welches noch jeweils mit den oben genannten Resten R2 oder einem Kohlenwasserstoffrest substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Pyren, Chrysen, Perylen, Fluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benz-imidazol, Naphthimidazol, Phenanthrimidazol, Pyridimidazol, Pyrazin-imidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugt sind erfindungsgemäße Verbindungen, die nicht geladen, d. h. elektrisch neutral, sind. Dies wird auf einfache Weise dadurch erreicht, dass die Ladung der an M1 koordinierenden oder kovalent bindenden Reste bzw. Liganden so gewählt wird, dass sie die Ladung von M kompensieren.

In den Verbindungen der vorliegenden Erfindung können R1, R2, R3 und Y jeweils unabhängig voneinander bei jedem Auftreten in einer Struktur entweder gleich oder verschieden sein. Insbesondere können solche R1 und R2, die in der Verbindung gemäß Formel (9) in 1,2-Position zueinander benachbart stehen, ein monocyclisches oder polycyclisches, gerade oder angular anelliertes, aliphatisches, aromatisches oder heteroaromatisches Ringsystem bilden. Bevorzugt bilden in diesen Fällen in 1,2-Position zueinander benachbart stehende R1 dann miteinander kein Ringsystem.

Durch die vorliegende Erfindung werden insbesondere Verbindungen bereitgestellt, enthaltend die oben aufgeführte Verbindung der Formel (9), wobei q = 0 ist, zwischen A und B eine Einfachbindung besteht, solche R1 und R2, die in der Verbindung gemäß Formel (9) in 1,2-Position zueinander benachbart stehen, ein monocyclisches oder polycyclisches, aromatisches oder heteroaromatisches Ringsystem bilden.

Durch die vorliegende Erfindung werden weiterhin insbesondere Verbindungen bereitgestellt, enthaltend die oben aufgeführte Verbindung der Formel (9), wobei q = 0 ist, zwischen A und B eine Doppelbindung besteht, und die zwei in der Verbindung gemäß Formel (9) zueinander benachbart stehenden Substituenten R1 ein monocyclisches oder polycyclisches, gerade oder angular anelliertes, aliphatisches, aromatisches oder heteroaromatisches Ringsystem, insbesondere ein aromatisches bzw. heteroaromatisches Ringsystem, bilden.

Durch die vorliegende Erfindung werden weiterhin insbesondere Verbindungen bereitgestellt, enthaltend die oben aufgeführte Verbindung der Formel (9), wobei q = 1 ist, zwischen A und B eine Doppelbindung besteht, zwischen D und E eine Doppelbindung besteht, zwei oder jeweils zwei in der Verbindung gemäß Formel (9) in 1,2-Stellung zueinander benachbart stehende Substituenten R1 ein monocyclisches oder polycyclisches, gerade oder angular anelliertes, aliphatisches, aromatisches oder heteroaromatisches Ringsystem, insbesondere ein aromatisches bzw. heteroaromatisches Ringsystem bilden.

In einer bevorzugten Ausführungsform der Formel (9) ist q = 0.

Bevorzugte Verbindungen der Formel (9) sind weiterhin die Verbindungen gemäß einer der Formeln (10) bis (17), 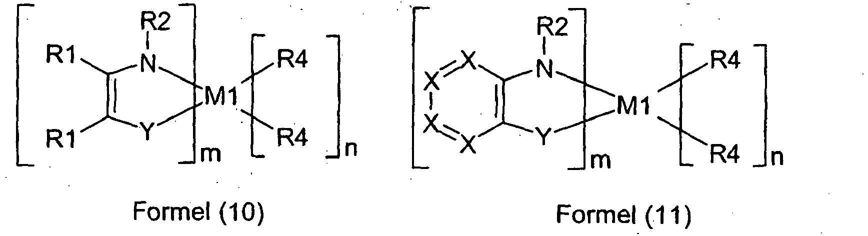 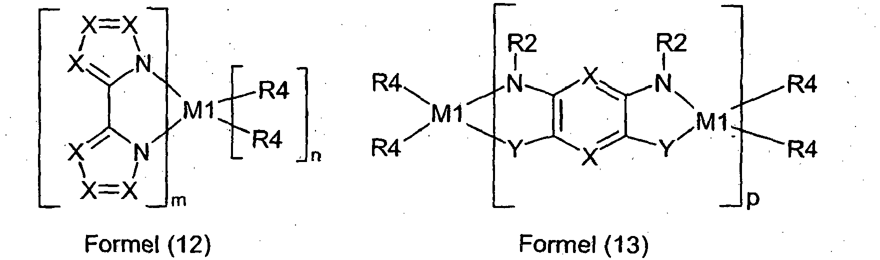 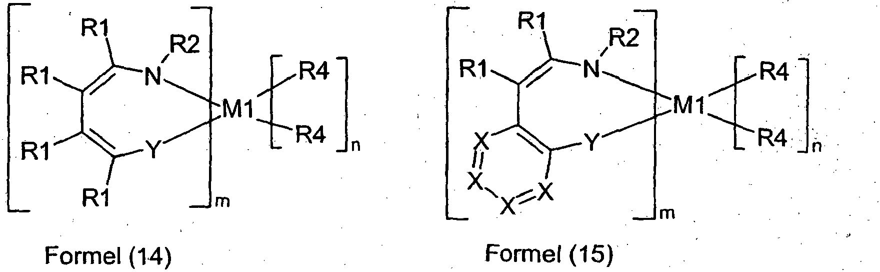 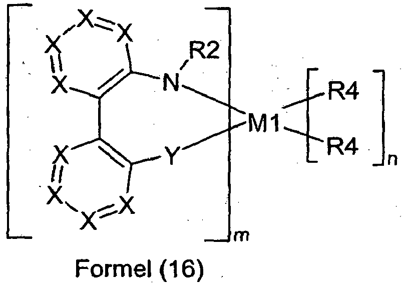 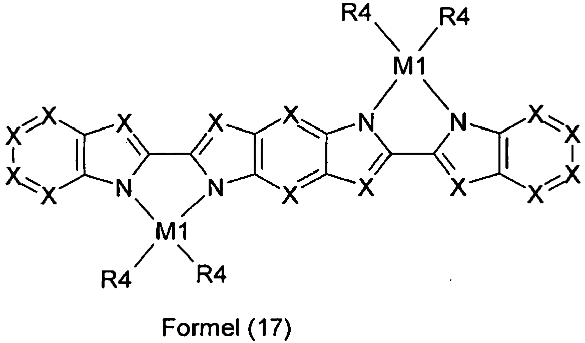 worin M1, R1, R2, R3, R4, Y, m und n wie oben definiert sind, X gleich oder verschieden bei jedem Auftreten ausgewählt ist aus der Gruppe bestehend aus CR1 und N, und p eine ganze Zahl von 1 bis 100.000, bevorzugt 1 bis 10.000, besonders bevorzugt 1 bis 100, ganz besonders bevorzugt 1 ist.

In einer bevorzugten Ausführungsform der Verbindungen gemäß Formel (9) bis (17) ist m = 2 und n = 0.

Bevorzugt sind Verbindungen gemäß Formel (9) bis (17), in denen M1 für Si oder Ge steht, insbesondere Si.

Bevorzugt sind weiterhin Verbindungen gemäß Formel (9) bis (17), in denen Y für NR2 oder O steht, insbesondere NR2.

Bevorzugt sind weiterhin Verbindungen gemäß Formel (9) bis (17), in denen X für CR1 steht.

Bevorzugt sind weiterhin Verbindungen gemäß Formel (9) bis (17), in denen R4 bei jedem Auftreten gleich oder verschieden ausgewählt ist aus der Gruppe bestehend aus einer geradkettigen Alkylgruppe mit 1 bis 20 C-Atomen oder einer verzweigten oder cyclischen Alkylgruppe mit 3 bis 20 C-Atomen, die jeweils mit einem oder mehreren Resten R3 substituiert sein kann, wobei eine oder mehrere nicht-benachbarte CH₂-Gruppen durch R3C=CR3, C≡C, Si(R3)₂, Ge(R3)₂, Sn(R3)₂, C=O, C=S, C=Se, C=NR3, P(=O)(R3), SO, SO₂, NR3, O, S oder CONR3 ersetzt sein können und wobei ein oder mehrere H-Atome durch F, Cl, Br, I, CN oder NO₂ ersetzt sein können, einem aromatischen oder heteroaromatischen Ringsystem mit 5 bis 60 aromatischen Ringatomen, das jeweils mit einem oder mehreren Resten R3 substituiert sein kann, und einer Kombination dieser Systeme, wobei optional zwei oder mehr Substituenten R4 ein mono-cyclisches oder polycyclisches, gerade oder angular anelliertes, aliphatisches, aromatisches oder heteroaromatisches Ringsystem bilden können, das mit einem oder mehreren Resten R3 substituiert sein kann.

Bevorzugt sind weiterhin Verbindungen gemäß Formel (9) bis (17), wobei
(i) q = 0 ist und zwischen A und B ein Einfachbindung besteht;
(ii) M1 ausgewählt ist aus der Gruppe bestehend aus Si, Ge, Sn, bevorzugt ausgewählt ist aus der Gruppe bestehend aus Si, Ge, am meisten bevorzugt Si ist;
(iii) Y gleich NR2 ist;
(iv) R1 und R2, die in der Struktur gemäß Formel (9) in 1,2-Position zueinander benachbart stehen, bevorzugt zusammen mit dem zu R1 sich in 1-Stellung befindlichen C-Atom und dem zu R2 sich in 1-Stellung befindlichen N-Atom, ein monocyclisches oder polycyclisches, gerade oder angular anelliertes, aliphatisches, aromatisches oder heteroaromatisches Ringsystem bilden, weiter bevorzugt zusammen mit dem zu R1 sich in 1-Stellung befindlichen C-Atom und dem zu R2 sich in 1-Stellung befindlichen N-Atom ein mono-cyclisches heteroaromatisches Ringsystem, am meisten bevorzugt einen Pyrrolring bilden, wobei das Ringsystem mit einem oder mehreren Kohlenwasserstoffresten mit 1 bis 20 C-Atomen, in dem ein oder mehrere H-Atome durch F, Cl oder CN, bevorzugt F oder Cl, am meisten bevorzugt F ersetzt sein können, substituiert sein kann, wobei das Ringsystem bevorzugt unsubstituiert ist; und
(v) m 1 oder 2 und n = (2 - m), bevorzugt m = 2 und n = 0 ist.

Bevorzugte Ausführungsformen sind weiterhin Verbindungen gemäß einer der oben genannten Formeln, wobei
(i) q = 1 ist, zwischen A und B eine Doppelbindung bzw. aromatische Bindung besteht und zwischen D und E eine Doppelbindung bzw. aromatische Bindung besteht;
(ii) M1 ausgewählt ist aus der Gruppe bestehend aus Si, Ge, Sn, bevorzugt bestehend aus Si oder Ge, am meisten bevorzugt Si ist;
(iii) Y gleich NR2 ist;
(iv) R2 ausgewählt ist aus der Gruppe bestehend aus aliphatischem Kohlenwasserstoffrest mit 1 bis 20 C-Atomen, aromatischem oder heteroaromatischem Ringsystem mit 5 bis 30 aromatischen Ringatomen, in dem ein oder mehrere H-Atome durch F-Atome ersetzt sein können, wobei zwei oder mehr benachbarte Substituenten R2 miteinander ein mono- oder polycyclisches, gerade oder angular anelliertes, aliphatisches, aromatisches oder heteroaromatisches Ringsystem bilden können, bevorzugt R2 ausgewählt ist aus der Gruppe bestehend aus aromatischem Ringsystem mit 5 bis 30 aromatischen Ringatomen, in dem ein oder mehrere H-Atome durch F-Atome ersetzt sein können, am meisten bevorzugt R2 ein Phenylring ist, wobei das Ringsystem mit einem oder mehreren Kohlenwasserstoffresten mit 1 bis 20 C-Atomen, in dem ein oder mehrere H-Atome durch F, Cl oder CN, bevorzugt F oder Cl, am meisten bevorzugt F ersetzt sein können, substituiert sein kann, wobei das Ringsystem bevorzugt unsubstituiert ist;
(v) die zwei an A und B benachbarten Substituenten R1, bevorzugt zusammen mit A und B, und die zwei an D und E benachbarten Substituenten R1, bevorzugt zusammen mit D und E, jeweils ein monocyclisches oder polycyclisches, gerade oder angular anelliertes, aliphatisches, aromatisches oder heteroaromatisches Ringsystem bilden, weiter bevorzugt die zwei an A und B benachbarten Substituenten R1 zusammen mit A und B, und die zwei an D und E benachbarten Substituenten R1 zusammen mit D und E, jeweils ein monocyclisches aromatisches Ringsystem, am meisten bevorzugt jeweils einen Phenylenring bilden, wobei das Ringsystem mit einem oder mehreren Kohlenwasserstoffresten mit 1 bis 20 C-Atomen, in dem ein oder mehrere H-Atome durch F, Cl oder CN, bevorzugt F oder Cl, am meisten bevorzugt F ersetzt sein können, substituiert sein kann, wobei das Ringsystem bevorzugt unsubstituiert ist; und
(vi) m 1 oder 2 und n = (2 - m), bevorzugt m = 2 und n = 0 ist.

Bevorzugt sind weiterhin Verbindungen der oben aufgeführten Formeln, in denen:
- M1: ausgewählt ist aus der Gruppe bestehend aus Si, Ge, bevorzugt Si;
- R1: definiert wie oben definiert ist;
- R2: ein aromatisches oder heteroaromatisches Ringsystem mit 5 bis 30 aromatischen Ringatomen ist, in dem optional ein oder mehrere H-Atome durch F-Atome ersetzt sind, welches jeweils durch einen oder mehrere Reste R3 substituiert sein kann;
- X: gleich CR1 ist;
- Y: gleich NR2 ist.

In einer besonders bevorzugten Ausführungsform der Erfindung steht R2 für Phenyl, Naphthyl oder Biphenyl, welches jeweils mit einem oder mehreren Resten R3 substituiert sein kann.

Bevorzugt sind weiterhin Verbindungen, welche symmetrisch aufgebaut sind und gleich substituiert sind. Diese Bevorzugung lässt sich durch die leichtere synthetische Zugänglichkeit dieser Verbindungen begründen.

Zur Herstellung der erfindungsgemäßen Verbindungen hat sich das im Folgenden beschriebene Verfahren als besonders gut geeignet herausgestellt. Dazu wird eine Verbindung M1(Hal)₂ₘ(R4)₂ₙ, insbesondere eine Verbindung M1(Hal)₄, wobei Hal für Cl, Br oder I steht, mit einem entsprechenden Diamin, einem Aminoalkohol, einem Aminothiol oder der jeweiligen deprotonierten Verbindung umgesetzt.

Ein weiterer Gegenstand der vorliegenden Erfindung ist daher ein Verfahren zur Herstellung der oben aufgeführten erfindungsgemäßen Verbindungen durch Umsetzung von M1(Hal)₂ₘ(R4)₂ₙ, insbesondere M1Hal₄, wobei M, m und n die oben genannte Bedeutung haben und Hal für Cl, Br oder I steht, mit einem entsprechenden Diamin, einem Aminoalkohol, einem Aminothiol oder der jeweiligen deprotonierten Verbindung.

Die oben beschriebenen erfindungsgemäßen Verbindungen, insbesondere Verbindungen, welche mit reaktiven Abgangsgruppen, wie Brom, Iod, Boronsäure oder Boronsäureester, oder mit polymerisierbaren Gruppen, wie Olefinen oder Oxetanen, substituiert sind, können als Monomere zur Erzeugung entsprechender Oligomere, Dendrimere oder Polymere Verwendung finden. Die Oligomerisation bzw. Polymerisation erfolgt dabei bevorzugt über die Nalogenfunktionalität bzw. die Boronsäurefunktionalität.

Eine weitere Möglichkeit der Polymerisation besteht in der Umsetzung einer Verbindung M1Hal₄, wobei Hal für Cl, Br oder I steht, beispielsweise SiCl₄, mit einem Tetramin, welches dann den Liganden bildet.

Eine weitere Möglichkeit zur Polymerisation besteht darin, die oben genannten erfindungsgemäßen Verbindungen mit reaktiven, polymerisierbaren Gruppen zu funktionalisieren und diese dann zu polymerisieren. Beispiele für solche funktionellen Gruppen sind Alkene bzw. Alkenderivate oder Oxetane Es ist weiterhin möglich, die Polymere über derartige Gruppen zu vernetzen.

Die erfindungsgemäßen Verbindungen bzw. Polymere können als vernetzte oder unvernetzte Schicht eingesetzt werden.

Weiterer Gegenstand der Erfindung sind daher Oligomere, Polymere oder Dendrimere enthaltend eine oder mehrere der oben aufgeführten erfindungsgemäßen Verbindungen, wobei ein oder mehrere Bindungen der erfindungsgemäßen Verbindung zum Polymer, Oligomer oder Dendrimer vorhanden sind. Je nach Verknüpfung der erfindungsgemäßen Verbindung bildet diese daher eine Seitenkette des Oligomers oder Polymers oder ist in der Hauptkette verknüpft. Die Polymere, Oligomere oder Dendrimere können konjugiert, teilkonjugiert oder nicht-konjugiert sein. Die Oligomere oder Polymere können linear, verzweigt oder dendritisch sein. Für die Wederholeinheiten der erfindungsgemäßen Verbindungen in Oligomeren, Dendrimeren und Polymeren gelten dieselben Bevorzugungen, wie oben beschrieben.

Zur Herstellung der Oligomere oder Polymere werden die erfindungsgemäßen Monomere homopolymerisiert oder mit weiteren Monomeren copolymerisiert. Bevorzugt sind Homopolymere oder Copolymere, wobei die Einheiten gemäß Formel (1) bis (17) zu 0.01 bis 99.9 mol%, bevorzugt 5 bis 90 mol%, besonders bevorzugt 20 bis 80 mol% vorhanden sind. Geeignete und bevorzugte Comonomere, welche das Polymergrundgerüst bilden, sind gewählt aus Fluorenen (z. B. gemäß EP 842208 oder WO 00/22026), Spirobifluorenen (z. B. gemäß EP 707020, EP 894107 oder WO 06/061181), Para-phenylenen (z. B. gemäß WO 92/18552), Carbazolen (z. B. gemäß WO 04/070772 oder WO 04/113468), Thiophenen (z. B. gemäß EP 1028136), Dihydrophenanthrenen (z. B. gemäß WO 05/014689), cis- und trans-Indenofluorenen (z. B. gemäß WO 04/041901 oder WO 04/113412), Ketonen (z. B. gemäß WO 05/040302), Phenanthrenen (z. B. gemäß WO 05/104264 oder WO 07/017066) oder auch mehreren dieser Einheiten. Die Polymere, Oligomere und Dendrimere können noch weitere Einheiten enthalten, beispielsweise Lochtransporteinheiten, insbesondere solche basierend auf Triarylaminen, und/oder Elektrönentransporteinheiten. Außerdem können die Polymere entweder einpolymerisiert oder als Blend eingemischt Triplett-Emitter enthalten. Gerade die Kombination von Einheiten gemäß den Formeln (1) bis (17) mit Triplett-Emittern führt zu besonders guten Ergebnissen.

Weiterhin können die erfindungsgemäßen Verbindungen auch weiter funktionalisiert werden und so zu erweiterten Strukturen umgesetzt werden. Hier ist als Beispiel die Funktionalisierung mit Arylboronsäuren gemäß SUZUKI oder mit primären oder sekundären Aminen gemäß HARTWIG-BUCHWALD zu nennen.

Verbindungen, in welchen ein Hauptgruppenelement oder ein Übergangsmetall mit einem oder mehreren Substituenten bzw. Liganden, wie oben beschrieben, substituiert bzw. koordiniert ist, insbesondere die oben aufgeführten erfindungsgemäßen Verbindungen, eignen sich besonders für die Verwendung in einem organischen elektronischen Bauteil. Dabei wird unter einem organischen elektronischen Bauteil eine Vorrichtung verstanden, welche mindestens eine Schicht enthält, die mindestens eine organische Verbindung enthält. Das Bauteil kann dabei aber auch anorganische Materialien enthalten.

Ein weiterer Gegenstand der vorliegenden Erfindung ist daher die Verwendung einer Verbindung enthaltend mindestens eine Verbindung gemäß Formel (9*) 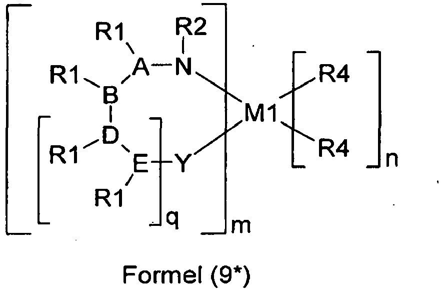 worin gilt:
- M1: ist ausgewählt ist aus Si, Ge, Sn, Ti, Zr, Hf, Cr, Mo und W,
- m: ist 1 oder 2 für M1 = Si, Ge, Sn, Ti, Zr oder Hf, und 1, 2 oder 3 für M1 = Cr, Mo oder W;
- n: ist (2 - m) für M1 = Si, Ge, Sn, Ti, Zr oder Hf, und (3 - m) für M1 = Cr, Mo oder W;
- R2: ist bei jedem Auftreten gleich oder verschieden eine geradkettige Alkylgruppe mit 1 bis 40 C-Atomen oder eine verzweigten oder cyclische Alkylgruppe mit 3 bis 40 C-Atomen, die jeweils mit einem oder mehreren Resten R3 substituiert sein kann, wobei eine oder mehrere nicht-benachbarte CH₂-Gruppen durch R3C=CR3, C=C oder C=O ersetzt sein können und wobei ein oder mehrere H-Atome durch D, F, Cl, Br, I, CN oder NO₂ ersetzt sein können, ein aromatisches
oder heteroaromatisches Ringsystem mit 5 bis 60 aromatischen Ringatomen, das jeweils mit einem oder mehreren Resten R3 substituiert sein kann, und einer Kombination dieser Systeme; mit der Maßgabe, dass in der Struktur gemäß Formel (9*) mindestens eine Gruppe R2 vorhanden ist, welche ein aromatisches oder heteroaromatisches Ringsystem darstellt, das jeweils mit einem oder mehreren Resten R3 substituiert sein kann; dabei können optional solche R1 und R2, die in der Verbindung gemäß Formel (9*) in 1,2-Position zueinander benachbart stehen, ein monocyclisches oder polycyclisches, gerade oder angular anelliertes, aliphatisches, aromatisches oder heteroaromatisches Ringsystem bilden, das mit einem oder mehreren Resten R3 substituiert sein kann;
die weiteren verwendeten Symbole und Indizes haben die oben genannten. Bedeutungen;
oder eines Oligomers, Polymers oder Dendrimers enthaltend diese Verbindung in organischen elektronischen Bauteilen.

Nochmals ein weiterer Gegenstand der Erfindung sind organische elektronische Bauteile, insbesondere organische integrierte Schaltungen (O-ICs), organische Feld-Effekt-Transistoren (O-FETs), organische Dünnfilmtransistoren (O-TFTs), organische lichtemittierende Transistoren (O-LETs), organische Solarzellen (O-SCs), organische optische Detektoren, organische Photorezeptoren, organische Feld-Quench-Devices (O-FQDs), lichtemittierende elektrochemische Zellen (LECs), organische Laserdioden (O-Laser) und "organic plasmon emitting device" (D. M. Koller et al., Nature Photonics 2008, 1-4), insbesondere aber organische Elektrolumineszenzvorrichtungen (OLEDs), besonders bevorzugt phosphoreszierende OLEDs, enthaltend eine oder mehrere Verbindungen mit einer Verbindung der oben abgebildeten Formel (9*) bzw. Oligomere, Polymere oder Dendrimere enthaltend diese Verbindung.

Besonders bevorzugt sind organische elektronische Vorrichtungen, enthaltend Verbindungen der Formeln (10*) bis (17*), 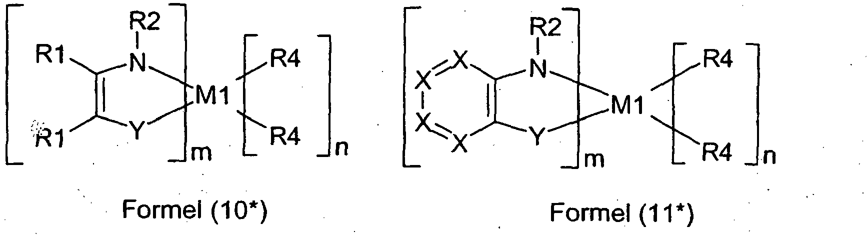 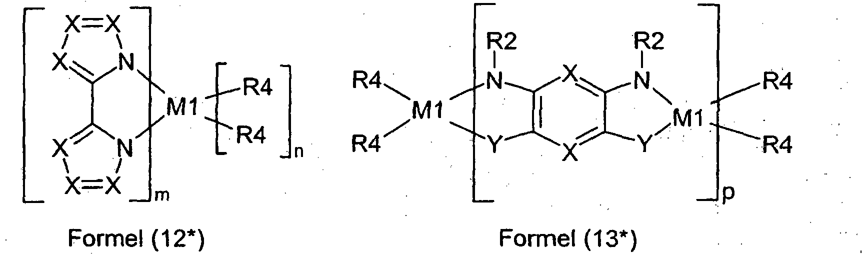 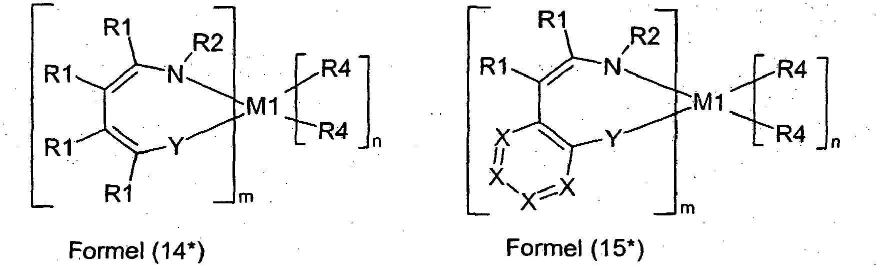 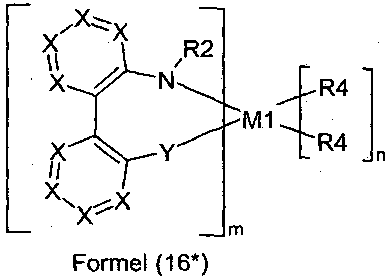 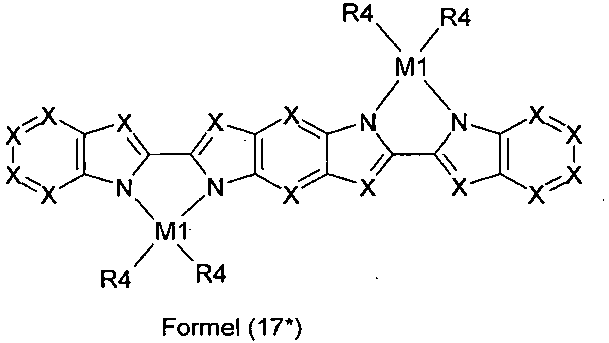 worin R2 die oben bei Formel (9*) aufgeführten Bedeutungen hat, M1 ausgewählt ist aus Si, Ge, Sn, Ti, Zr, Hf, Cr, Mo und W und die weiteren verwendeten Symbole und Indizes die oben bei Formel (9) bis (17) genannten Bedeutungen haben und weiterhin gilt:
- m: ist 1 oder 2 für M1 = Si, Ge, Sn, Ti, Zr oder Hf, und 1, 2 oder 3 für M 1 = Cr, Mo oder W;
- n: ist (2 - m) für M1 = Si, Ge, Sn, Ti, Zr oder Hf, und (3 - m) für M1 = Cr, Mo oder W.

Für die verwendeten Symbole gilt dieselbe Bevorzugung, wie oben beim Stoffschutz ausgeführt.

Bevorzugt sind daher Verbindungen gemäß den Formeln (9*) bis (17*) mit m = 2 und n = 0.

Bevorzugt sind weiterhin Verbindungen gemäß Formel (9*) bis (17*), in denen M1 für Si oder Ge steht, insbesondere Si.

Bevorzugt sind weiterhin Verbindungen gemäß Formel (9*) bis (17*), in denen Y für NR2 oder O steht, insbesondere NR2.

Bevorzugt sind weiterhin Verbindungen gemäß Formel (9*) bis (17*), in denen X für CR1 steht.

Bevorzugt sind weiterhin Verbindungen gemäß Formel (9*) bis (17*), in denen R4 bei jedem Auftreten gleich oder verschieden ausgewählt ist aus der Gruppe bestehend aus einer geradkettigen Alkylgruppe mit 1 bis 20 C-Atomen oder einer verzweigten oder cyclischen Alkylgruppe mit 3 bis 20 C-Atomen, die jeweils mit einem oder mehreren Resten R3 substituiert sein kann, wobei eine oder mehrere nicht-benachbarte CH₂-Gruppen durch R3C=CR3, C=C, Si(R3)₂, Ge(R3)₂, Sn(R3)₂, C=O, C=S, C=Se, C=NR3, P(=O)(R3), SO, SO₂, NR3, O, S oder CONR3 ersetzt sein können und wobei ein oder mehrere H-Atome durch F, Cl, Br, I, CN oder NO₂ ersetzt sein können, einem aromatischen oder heteroaromatischen Ringsystem mit 5 bis 60 aromatischen Ringatomen, das jeweils mit einem oder mehreren Resten R3 substituiert sein kann, und einer Kombination dieser Systeme, wobei optional zwei oder mehr Substituenten R4 ein monocyclisches oder polycyclisches, gerade oder angular anelliertes, aliphatisches, aromatisches oder heteroaromatisches Ringsystem bilden können, das mit einem oder mehreren Resten R3 substituiert sein kann.

Bevorzugt sind weiterhin Verbindungen gemäß Formel (9*) bis (17*), in denen:
- M1: ausgewählt ist aus der Gruppe bestehend aus Si und Ge, bevorzugt Si;
- R1: definiert wie oben definiert ist;
- R2: ein aromatisches oder heteroaromatisches Ringsystem mit 5 bis 30 aromatischen Ringatomen ist, in dem optional ein oder mehrere H-Atome durch F-Atome ersetzt sind, welches jeweils durch einen oder mehrere Reste R3 substituiert sein kann;
- X: gleich CR1 ist;
- Y: gleich NR2 ist.

In einer besonders bevorzugten Ausführungsform der Verbindungen gemäß Formel (9*) bis (17*) steht R2 für Phenyl, Naphthyl oder Biphenyl, welches jeweils mit einem oder mehreren Resten R3 substituiert sein kann.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten und/oder Ladungserzeugungsschichten (Charge-Generation Layers, IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer*).* Ebenso können zwischen zwei emittierende Schichten Interlayers eingebracht sein, welche beispielsweise eine Exzitonen-blockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 05/011013).

Die Verbindung gemäß den oben aufgeführten Ausführungsformen kann dabei in unterschiedlichen Schichten eingesetzt werden, je nach genauer Struktur. Bevorzugt ist eine organische Elektrolumineszenzvorrichtung, enthaltend eine erfindungsgemäße Verbindung in einer elektronenblockierenden bzw. exzitonenblockierenden Schicht und/oder in einer Lochtransportschicht und/oder als Matrixmaterial für fluoreszierende oder phosphoreszierende Emitter. In einer bevorzugten Ausführungsform der Erfindung werden die Verbindungen gemäß den Formeln (9*) bis (17*) in einer elektronenblockierenden bzw. exzitonenblockierenden Schicht in einer phosphoreszierenden OLED oder in einer emittierenden Schicht als Matrix für phosphoreszierende Emitter eingesetzt. Dabei gelten die oben aufgeführten bevorzugten Ausführungsformen für die Verbindungen auch für die Verwendung der Materialien in organischen elektronischen Vorrichtungen. Besonders bevorzugt ist die Verwendung der erfindungsgemäßen Verbindungen gemäß den Formeln (9) bis (17).

In einer bevorzugten Ausführungsform der Erfindung wird die Verbindung gemäß Formel (1*) bzw. gemäß Formel (9*) bis (17*) als Matrixmaterial für eine fluoreszierende oder phosphoreszierende Verbindung in einer emittierenden Schicht eingesetzt. Dabei kann die organische Elektrolumineszenzvorrichtung eine emittierende Schicht enthalten, oder sie kann mehrere emittierende Schichten enthalten, wobei mindestens eine emittierende Schicht mindestens eine Verbindung gemäß Formel (9*) bis (17*) als Matrixmaterial enthält. Wenn mehrere Emissionsschichten vorhanden sind, gilt hierfür das oben ausgeführte.

Wenn die Verbindung gemäß Formel (1*) bzw. (9*) bis (17*) als Matrixmaterial für eine emittierende Verbindung in einer emittierenden Schicht eingesetzt wird, wird sie bevorzugt in Kombination mit einem oder mehreren phosphoreszierenden Materialien (Triplettemitter) eingesetzt. Unter Phosphoreszenz im Sinne dieser Erfindung wird die Lumineszenz aus einem angeregten Zustand mit höherer Spinmultiplizität verstanden, also einem Spinzustand > 1, insbesondere aus einem angeregten Triplettzustand. Im Sinne dieser Anmeldung sollen alle lumineszierenden Iridium- und Platinkomplexe als phosphoreszierende Verbindungen angesehen werden. Die Mischung aus der Verbindung gemäß Formel (1*) bzw. (9*) bis (17*) und der emittierenden Verbindung enthält dann zwischen 99 und 1 Vol.-%, vorzugsweise zwischen 98 und 10 Vol.-%, besonders bevorzugt zwischen 97 und 60 Vol.-%, insbesondere zwischen 95 und 85 Vol.-% der Verbindung gemäß Formel (1*) bzw. (9*) bis (17*) bezogen auf die Gesamtmischung aus Emitter und Matrixmaterial. Entsprechend enthält die Mischung zwischen 1 und 99 Vol.-%, vorzugsweise zwischen 2 und 90 Vol.-%, besonders bevorzugt zwischen 3 und 40 Vol.-%, insbesondere zwischen 5 und 15 Vol.-% des Emitters bezogen auf die Gesamtmischung aus Emitter und Matrixmaterial.

Eine weitere bevorzugte Ausführungsform der vorliegenden Erfindung ist der Einsatz der erfindungsgemäßen Verbindung als Matrixmaterial für einen phosphoreszierenden Emitter in Kombination mit einem weiteren Matrixmaterial. Besonders geeignete Matrixmaterialien, welche in Kombination mit den erfindungsgemäßen Verbindungen eingesetzt werden können, sind aromatische Ketone, aromatische Phosphinoxide oder aromatische Sulfoxide oder Sulfone, z. B. gemäß WO 04/013080, WO 04/093207, WO 06/005627 oder der nicht offen gelegten Anmeldung DE 102008033943.1, Triarylamine, Carbazolderivate, z. B. CBP (N,N-Bis-carbazolylbiphenyl) oder die in WO 05/039246, US 2005/0069729, JP 2004/288381, EP 1205527 oder WO 08/086851 offenbarten Carbazolderivate, Indolocarbazolderivate, z. B. gemäß WO 07/063754 oder WO 08/056746, Azacarbazolderivate, z. B. gemäß EP 1617710, EP 1617711, EP 1731584, JP 2005/347160, bipolare Matrixmaterialien, z. B. gemäß WO 07/137725, Silane, z. B. gemäß WO 05/111172, Azaborole oder Boronester, z. B. gemäß WO 06/117052, Triazinderivate, z. B. gemäß der nicht offen gelegten Anmeldung DE 102008036982.9, WO 07/063754 oder WO 08/056746 oder Zinkkomplexe, z. B. gemäß EP 652273 oder WO 09/062578.

Als phosphoreszierende Verbindungen (= Triplettemitter) eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten. Bevorzugt werden als Phosphoreszenzemitter Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium oder Platin enthalten.

Beispiele der oben beschriebenen Emitter können den Anmeldungen WO 00/70655, WO 01/41512, WO 02/02714, WO 02/15645, EP 1191613, EP 1191612, EP 1191614, WO 05/033244, WO 05/019373 und US 2005/0258742 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden. Bevorzugte Liganden sind 2-Phenylpyridin-Derivate, 7,8-Benzochinolin-Derivate, 2-(2-Thienyl)pyridinDerivate, 2-(1-Naphthyl)pyridin-Derivate, 1-Phenylisochinolin-Derivate oder 2-Phenylchinolin-Derivate. Alle diese Verbindungen können substituiert sein, z. B. für Blau mit Fluor-, Cyano- und/oder Trifluormethylsubstituenten. Auxiliäre Liganden sind bevorzugt Acetylacetonat oder Pikrinsäure.

Insbesondere geeignet sind auch Komplexe von Pt oder Pd mit tetradentaten Liganden (US 2007-0087219 A1), Pt-Porphyrinkomplexe mit vergrößertem Ringsystem (US 2009/0061681 A1) und Ir-Komplexe geeignet, z. B. 2,3,7,8,12,13,17,18-Octaethyl-21H, 23H-porphyrin-Pt(II), Tetraphenyl-Pt(II)-tetrabenzoporphyrin (US 2009/0061681 A1), *Cis*-Bis(2-phenylpyridinato-N,C^{2'})Pt(II), *Cis*-Bis(2-(2'=thienyl)pyridinato-N,C^{3'})Pt(II), *Cis*-Bis-(2-(2'-thienyl)chinolinato-N,C^{5'})Pt(II), (2-(4,6-Difluorophenyl)-pyridinato-N,C^{2'})Pt(II)(acetylacetonat), oder Tris(2-phenylpyridinato-N,C^{2'})-Ir(III) (Ir(ppy)₃), Bis(2-phenylpyridinato-N,C²)Ir(III)(acetylacetonat) (Ir(ppy)₂-acetylacetonat, US 2001/0053462 A1, Baldo, Thompson et.al. Nature 403, (2000), 750-753), Bis(1-phenylisochinolinato-N,C^{2'})(2-phenylpyridinato-N,C^{2'})Iridium(III), Bis(2-phenylpyridinato-N,C^{2'})(1-phenylisochinolinato-N,C^{2'})Iridium(III), Bis(2-(2'-benzothienyl)pyridinato-N,C^{3'})Iridium(III)-(acetylacetonat), Bis(2-(4',6'-difluorophenyl)pyridinato-N,C^{2'})Iridium(III)-(picolinat) (Firpic), Bis(2-(4',6'-difluorophenyl)pyridinato-N,C^{2'})Ir(III)-(tetrakis(1-pyrazolyl)borat), Tris(2-(biphenyl-3-yl)-4-tert-butylpyridin)-iridium(III), (ppz)₂Ir(5phdpym) (US 2009/0061681 A1), (45ooppz)₂Ir(5phdpym) (US 2009/0061681 A1), Derivate von 2-Phenylpyridin-Ir-Komplexen, wie z. B. Tris(2-phenylisochinolinato-N,C)Ir(III), Bis(2-(2'-benzo[4,5-a]thienyl)pyridinato-N,C³)Ir(acetylacetonat) ([Btp₂Ir(acac)], Adachi et al. Appl. Phys. Lett. 78 (2001), 1622-1624). Weitere phosphoreszierende Emitter mit tridentaten Liganden werden beschrieben in US 6824895. Rot emittierende phosphoreszente Komplexe findet man in US 6835469, US 6830828 und US 2001/0053462.

In einer weiteren bevorzugten Ausführungsform der Erfindung wird die Verbindung gemäß Formel (1*) bzw. (9*) bis (17*) als Lochtransportmaterial in einer Lochtransport- oder Lochinjektionsschicht eingesetzt. Dabei wird unter einer Lochinjektionsschicht eine Schicht verstanden, welche direkt an eine elektrisch leitfähige Schicht angrenzt. Unter einer Lochtransportschicht wird eine Schicht verstanden, welche zwischen einer Lochinjektionsschicht und der emittierenden Schicht bzw. einer Elektronenblockierschicht bzw. Exzitonenblockierschicht liegt. Dabei kann die emittierende Schicht fluoreszierend oder phosphoreszierend sein.

In nochmals einer weiteren bevorzugten Ausführungsform der Erfindung wird die Verbindung gemäß Formel (1*) bzw. (9*) bis (17*) in einer Elektronenblockierschicht bzw. einer Exzitonenblockierschicht eingesetzt. Unter einer Elektronenblockierschicht wird eine Schicht verstanden, welche auf Anodenseite direkt an eine emittierende Schicht angrenzt. Diese kann auch Exzitonen-blockierende Eigenschaften aufweisen. Durch die Lage von HOMO und LUMO des Materials der Elektronenblockierschicht wird der Übertritt von Elektronen aus der emittierenden Schicht in die Lochtransportschicht verringert. Insbesondere bei phosphoreszierenden OLEDs kann die Verwendung einer solchen Elektronenblockierschicht zu Vorteilen führen.

Es ist weiterhin möglich, die erfindungsgemäße Verbindung sowohl in einer Elektronenblockierschicht bzw. Exzitonenblockierschicht als auch als Matrix in einer emittierenden Schicht zu verwenden.

In einer weiteren Ausführungsform der Erfindung enthält die erfindungsgemäße organische Elektrolumineszenzvorrichtung keine separate Lochinjektionsschicht und/oder Lochtransportschicht und/oder Lochblockierschicht und/oder Elektronentransportschicht, d. h. die emittierende Schicht grenzt direkt an die Lochinjektionschicht oder die Anode an, und/ oder die emittierende Schicht grenzt direkt an die Elektronentransportschicht oder die Elektroneninjektionsschicht oder die Kathode an, wie zum Beispiel in WO 05/053051 beschrieben. Weiterhin ist es möglich, einen Metallkomplex, der gleich oder ähnlich dem Metallkomplex in der emittierenden Schicht ist, direkt angrenzend an die emittierende Schicht als Lochtransport- bzw. Lochinjektionsmaterial zu verwenden, wie z. B. in WO 09/030981 beschrieben.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist aber auch möglich, dass der Anfangsdruck noch geringer ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Diese Verfahren sind dem Fachmann generell bekannt und können von ihm ohne Probleme auf organische Elektrolumineszenzvorrichtungen enthaltend die erfindungsgemäßen Verbindungen angewandt werden.

Beispiele für bevorzugte erfindungsgemäße Verbindungen gemäß den oben aufgeführten Ausführungsformen bzw. Verbindungen, wie sie bevorzugt in organischen elektronischen Vorrichtungen eingesetzt werden können, sind die Verbindungen der folgenden Strukturen (1) bis (284).

| | | |
|---|---|---|
| 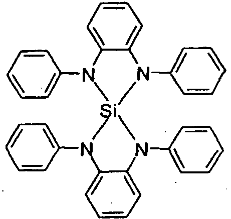 | 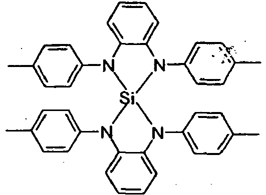 | 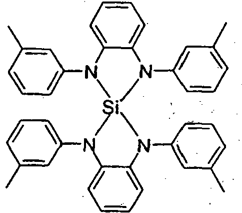 |
| (1) | (2) | (3) |
| 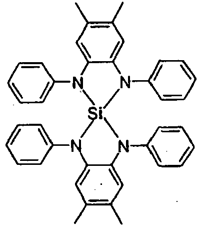 | 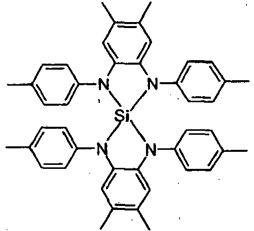 | 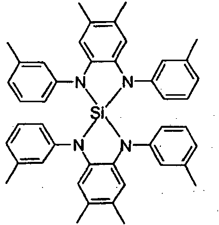 |
| (4) | (5) | (6) |
| 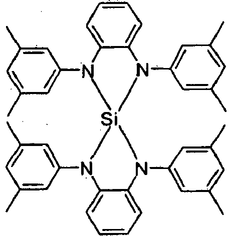 | 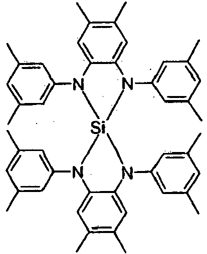 | 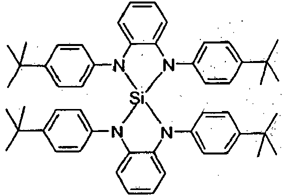 |
| (7) | (8) | (9) |
| 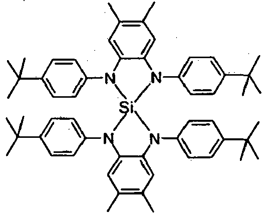 | 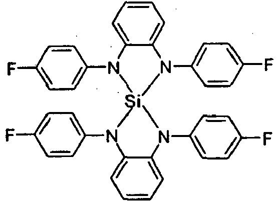 | 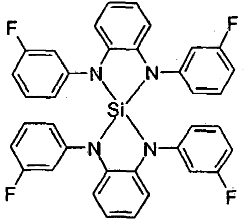 |
| (10) | (11) | (12) |
| 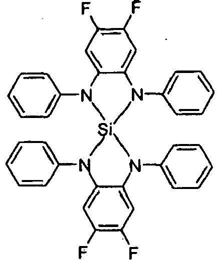 | 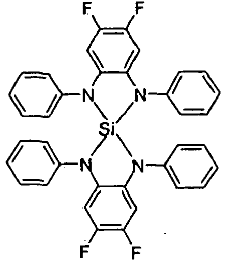 | 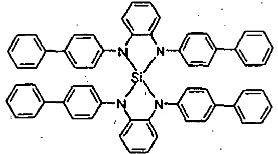 |
| (13) | (14) | (15) |
| 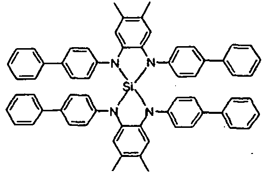 | 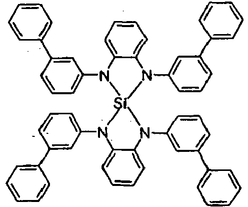 | 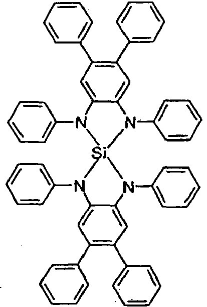 |
| (16) | (17) | (18) |
| 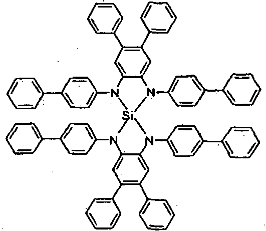 | 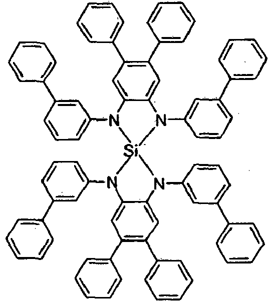 | 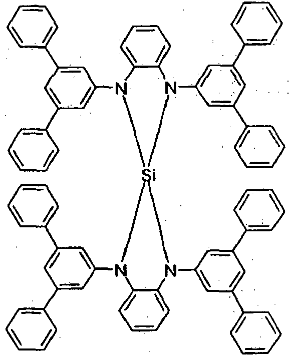 |
| (19) | (20) | (21) |
| 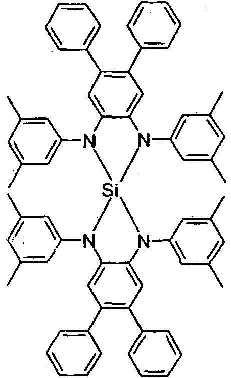 | 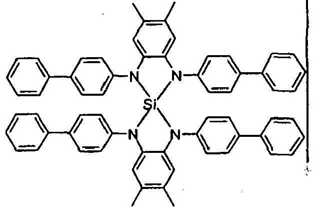 | 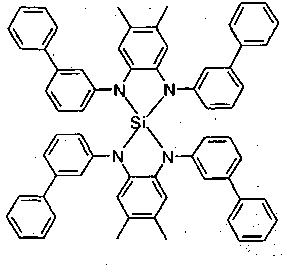 |
| (22) | (23) | (24) |
| 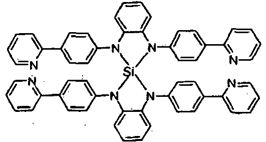 | 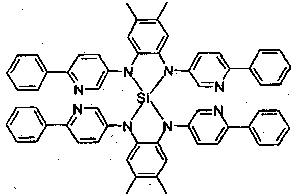 | 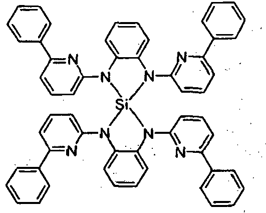 |
| (25) | (26) | (27) |
| 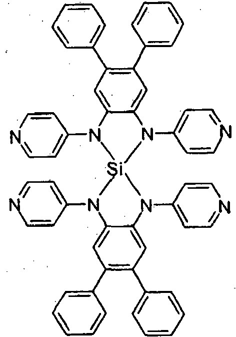 | 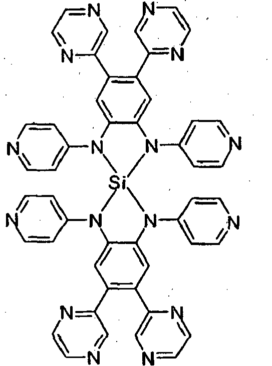 | 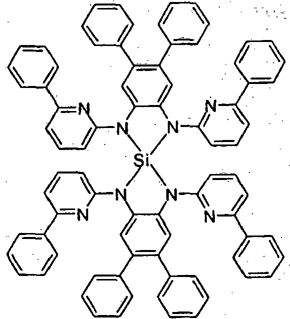 |
| (28) | (29) | (30) |
| 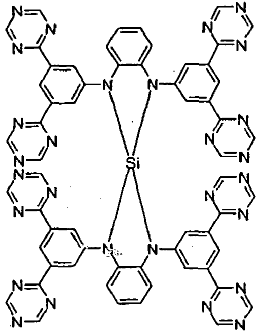 | 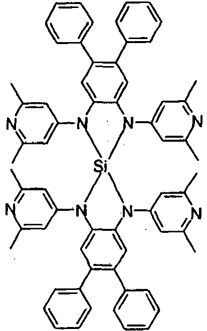 | 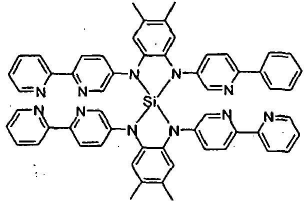 |
| (31) | (32) | (33) |
| 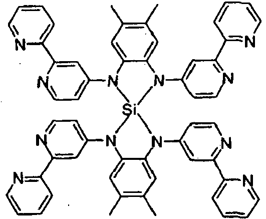 | 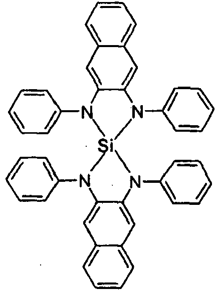 | 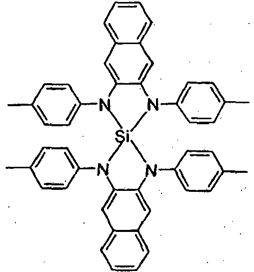 |
| (34) | (35) | (36) |
| 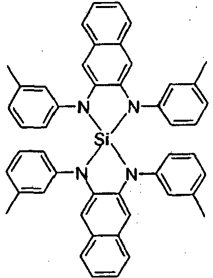 | 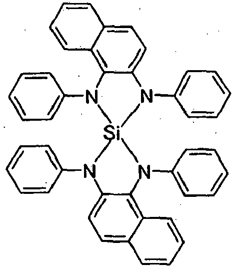 | 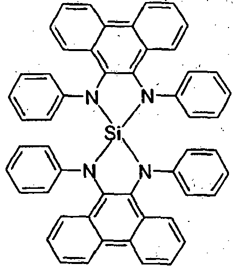 |
| (37) | (38) | (39) |
| 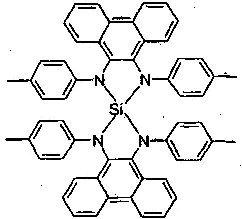 | 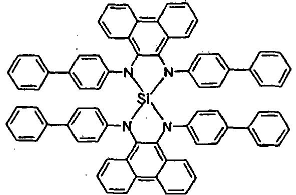 | 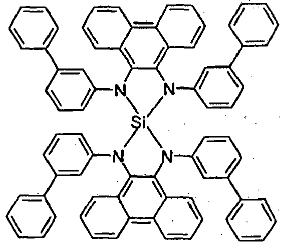 |
| (40) | (41) | (42) |
| 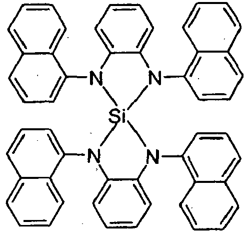 | 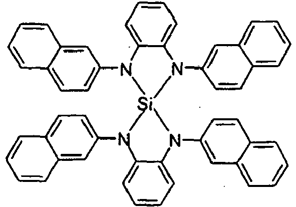 | 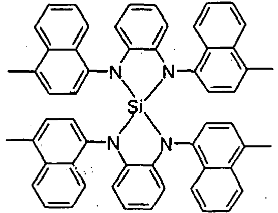 |
| (43) . | (44) | (45) |
| 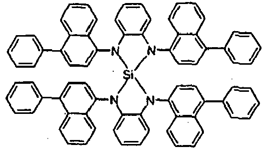 | 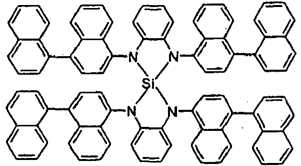 | 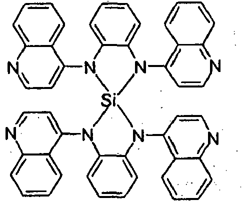 |
| (46) | (47) | (48) |
| 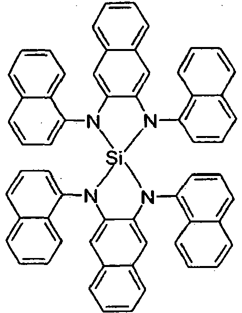 | 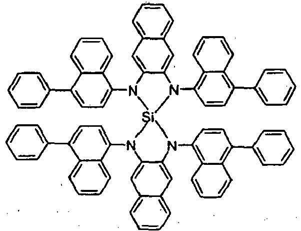 | 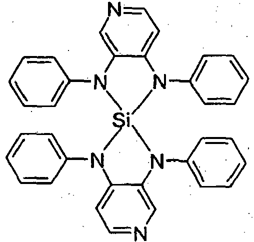 |
| (49) | (50) | (51) |
| 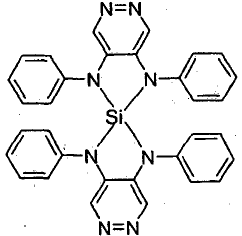 | 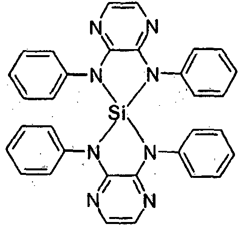 | 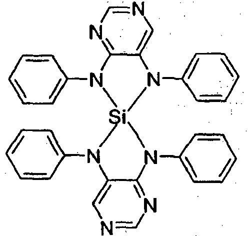 |
| (52) | (53) | (54) |
| 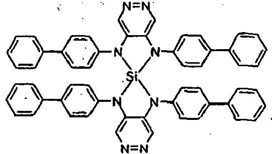 | 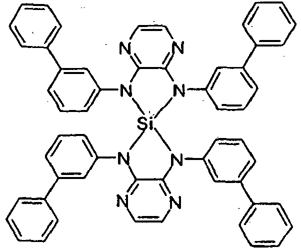 | 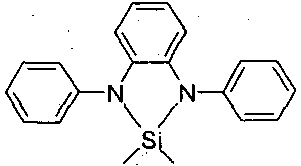 |
| (55) | (56) | (57) |
| 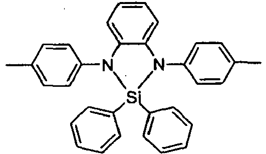 | 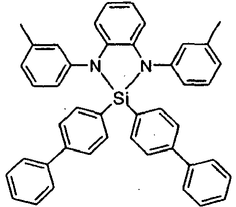 | 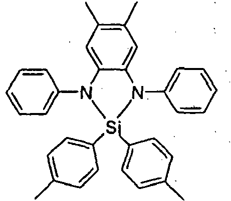 |
| (58) | (59) | (60) |
| 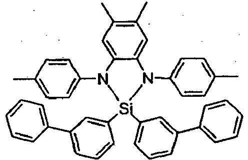 | 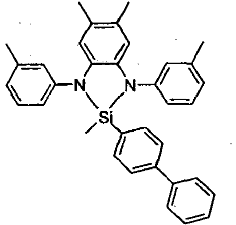 | 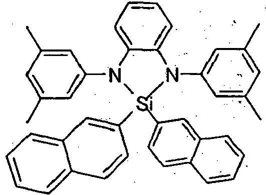 |
| (61) | (62) | (63) |
| 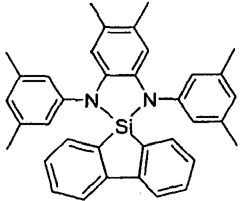 | 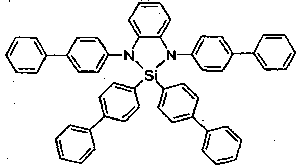 | 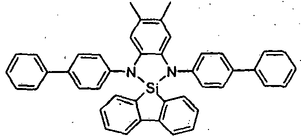 |
| (64) | (65) | (66) |
| 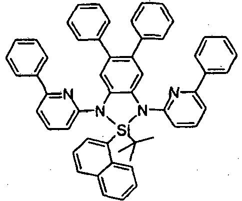 | 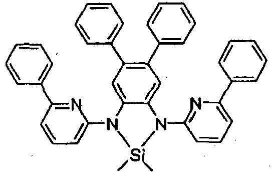 | 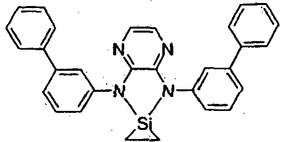 |
| (67) | (68) | (69) |
| 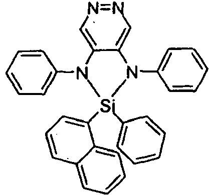 | 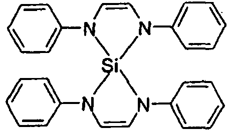 | 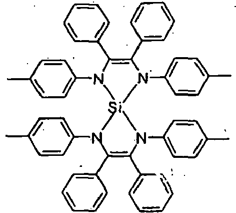 |
| (70) | (71) | (72) |
| 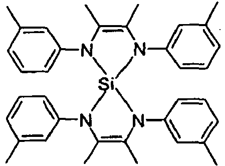 | 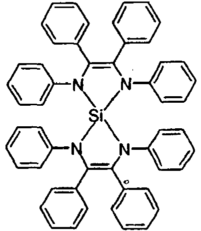 | 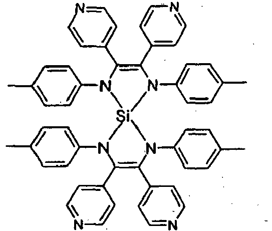 |
| (73) | (74) | (75) |
| 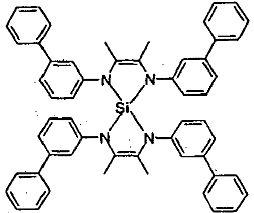 | 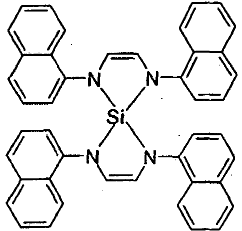 | 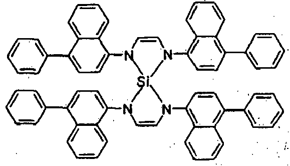 |
| (76) | (77) | (78) |
| 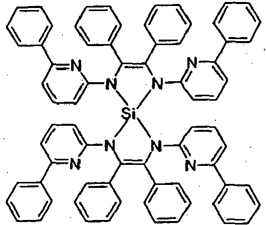 | 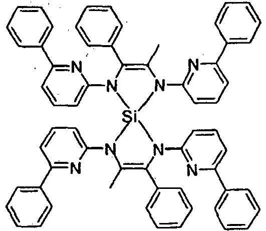 | 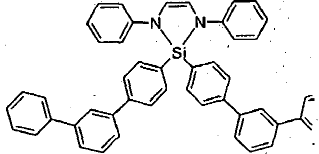 |
| (79) | (80) | (81) |
| 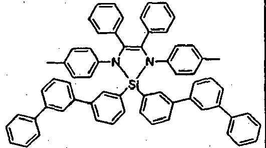 | 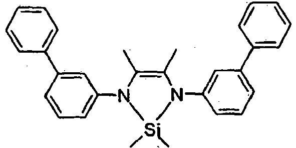 | 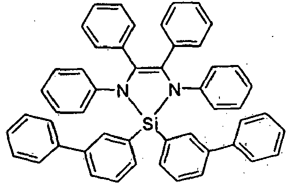 |
| (82) | (83) | (84) |
| 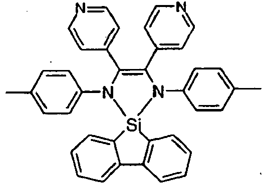 | 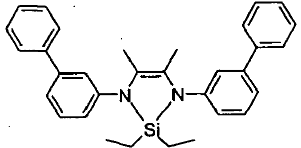 | 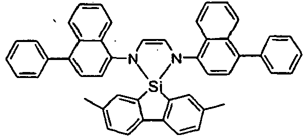 |
| (85) | (86) | (87) |
| 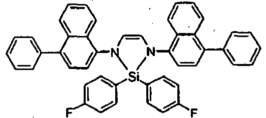 | 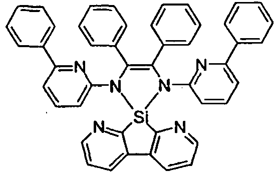 | 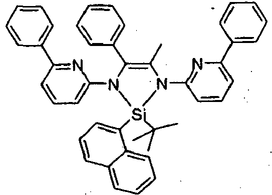 |
| (88) | (89) | (90) |
| 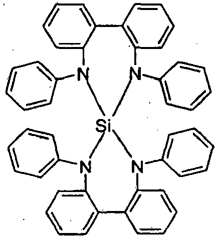 | 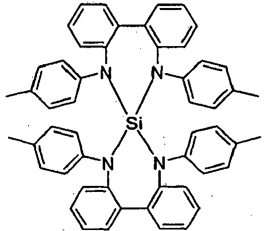 | 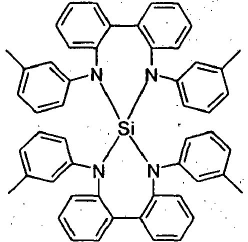 |
| (91) | (92) | (93) |
| 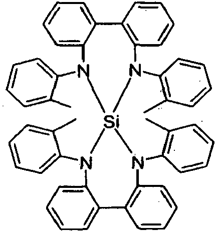 | 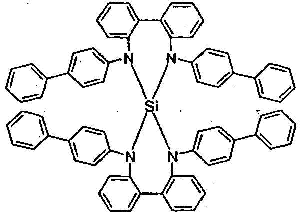 | 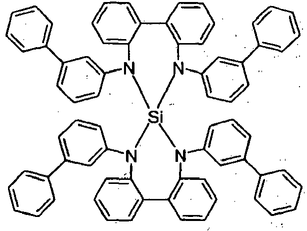 |
| (94) | (95) | (96) |
| 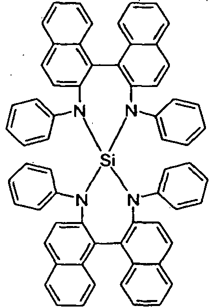 | 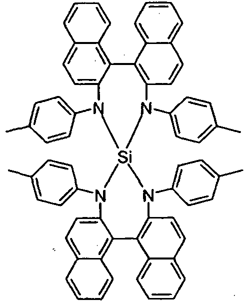 | 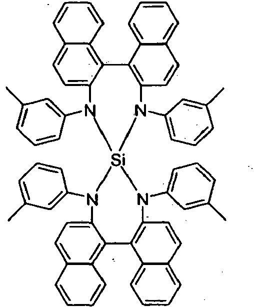 |
| (97) | (98) | (99) |
| 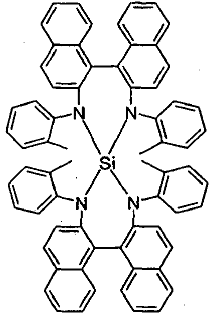 | 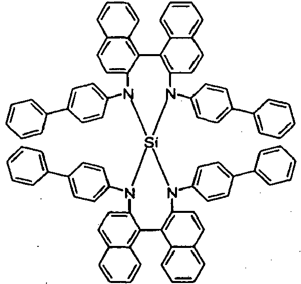 | 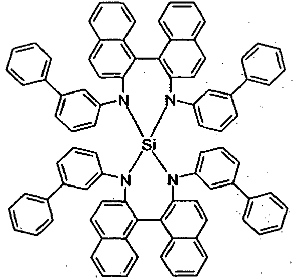 |
| (100) | (101) | (102) |
| 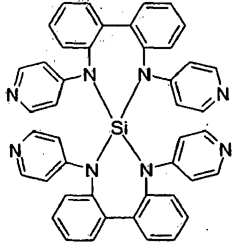 | 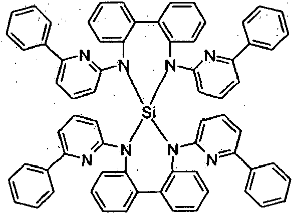 | 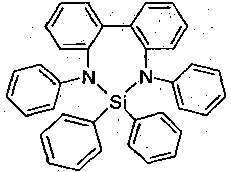 |
| (103) | (104) | (105) |
| 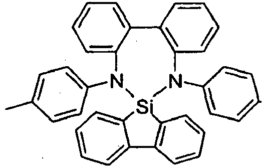 | 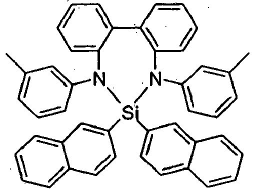 | 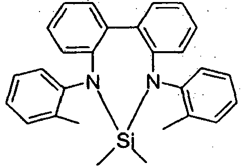 |
| (106) | (107) | (108) |
| 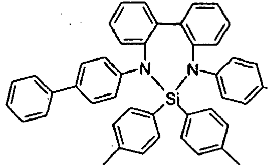 | 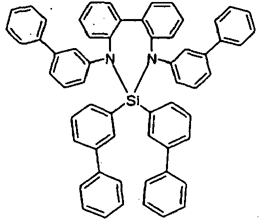 | 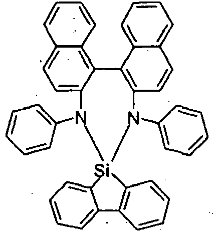 |
| (109) | (110) | (111) |
| 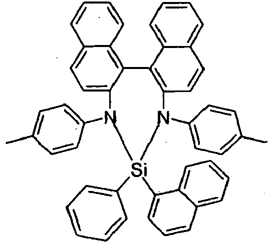 | 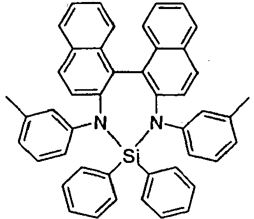 | 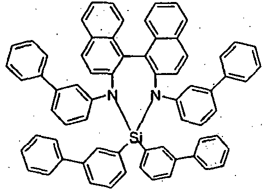 |
| (112) | (113) | (114) |
| 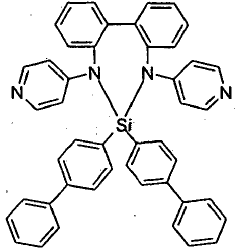 | 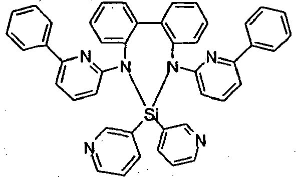 | 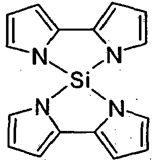 |
| (115) | (116) | (117) |
| 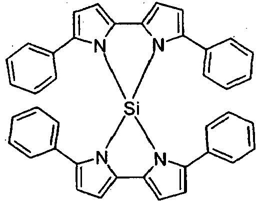 | 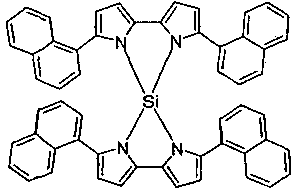 | 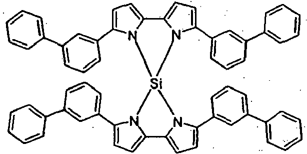 |
| (118) | (119) | (120) |
| 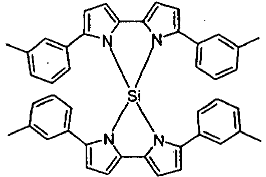 | 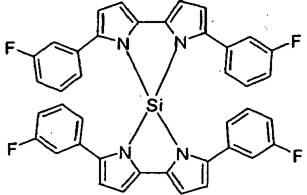 | 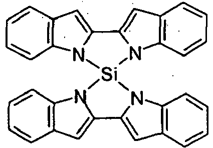 |
| (121) | (122) | (123) |
| 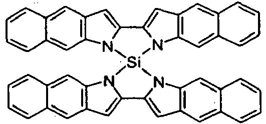 | 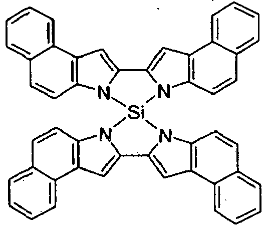 | 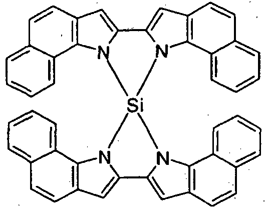 |
| (124) | (125) | (126) |
| 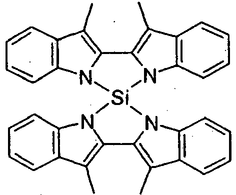 | 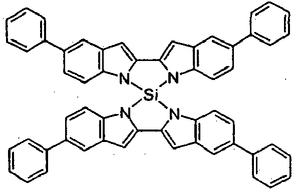 | 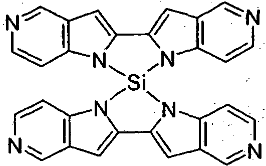 |
| (127) | (128) | (129) |
| 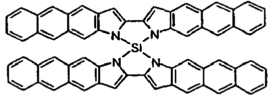 | 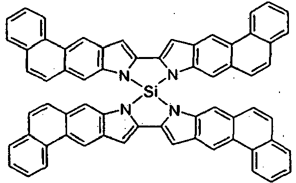 | 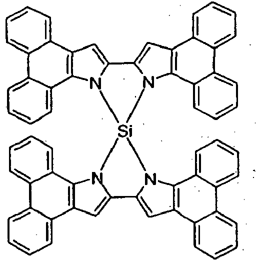 |
| (130) | (131) | (132) |
| 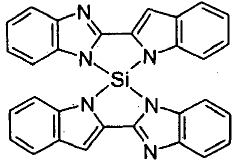 | 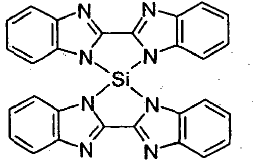 | 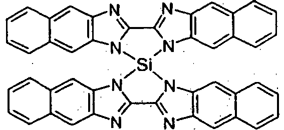 |
| (133) | (134) | (135) |
| 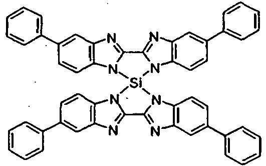 | 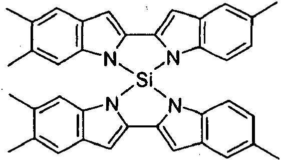 | 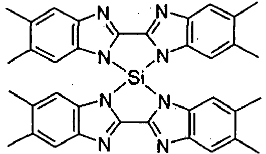 |
| (136) | (137) | (138) |
| 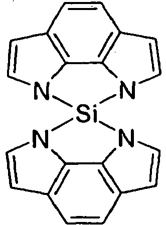 | 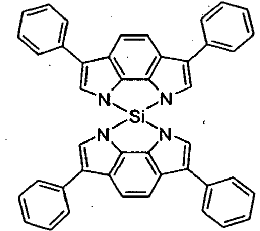 | 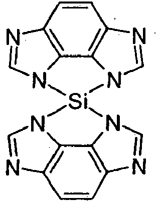 |
| (139) | (140) | (141) |
| 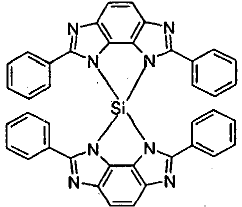 | 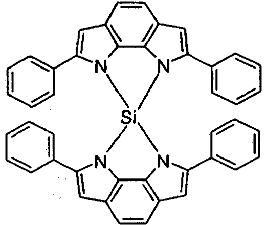 | 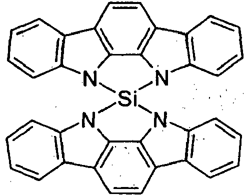 |
| (142) | (143) | (144) |
| 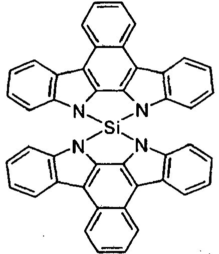 | 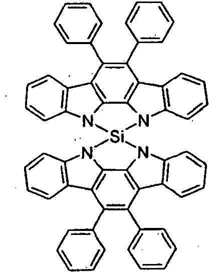 | 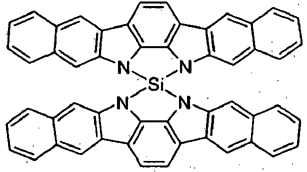 |
| (145) | (146) | (147) |
| 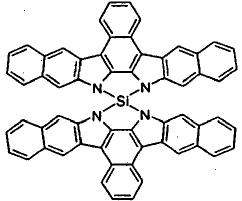 | 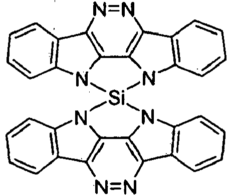 | 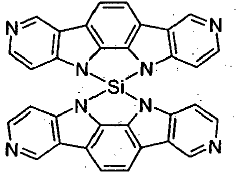 |
| (148) | (149) | 150) |
| 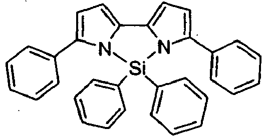 | 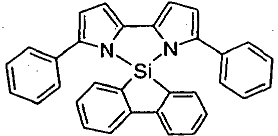 | 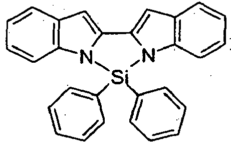 |
| (151) | (152) | (153) |
| 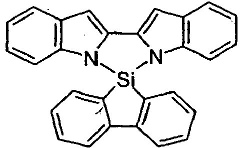 | 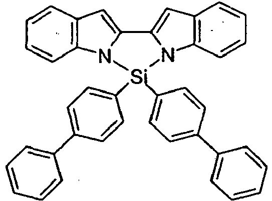 | 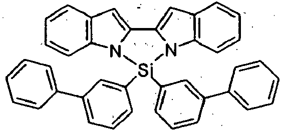 |
| (154) | (155) | (156) |
| 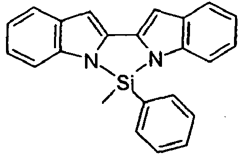 | 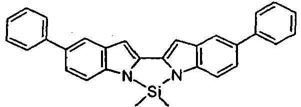 | 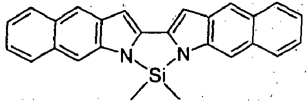 |
| (157) | (158) | (159) |
| 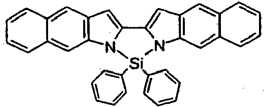 | 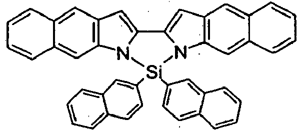 | 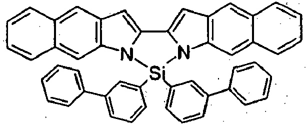 |
| (160) | (161) | (162) |
| 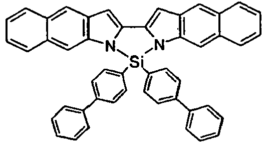 | 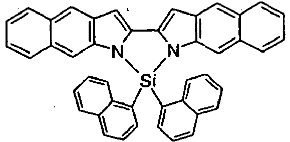 | 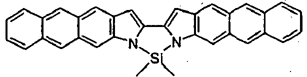 |
| (163) | (164) | (165) |
| 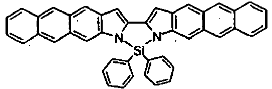 | 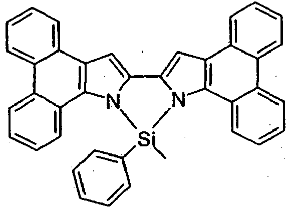 | 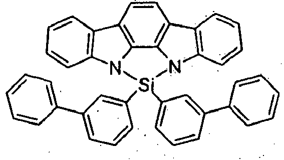 |
| (166) | (167) | (168) |
| 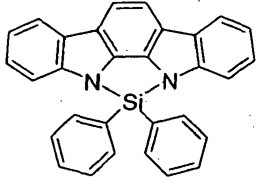 | 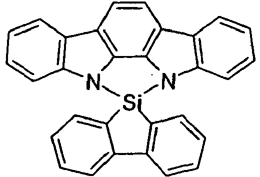 | 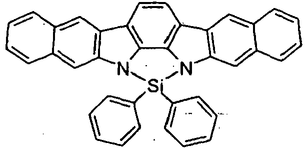 |
| (169) | (170) | (171) |
| 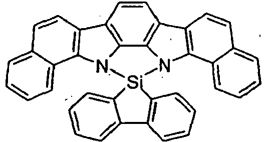 | 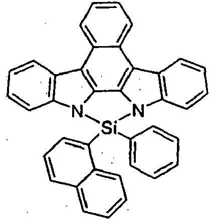 | 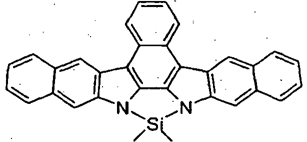 |
| (172) | (173) | (174) |
| 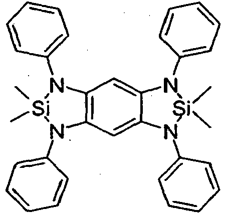 | 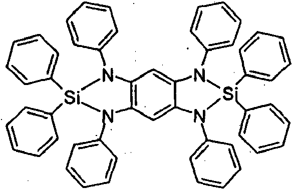 | 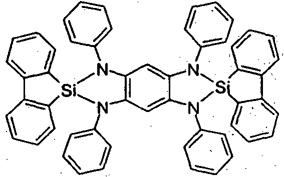 |
| (175) | (176) | (177) |
| 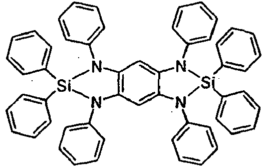 | 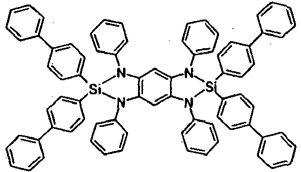 | 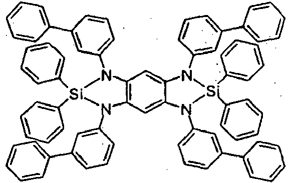 |
| (178) | (179) | (180) |
| 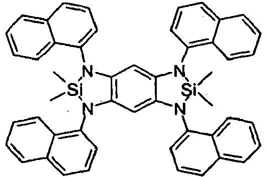 | 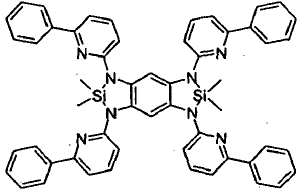 | 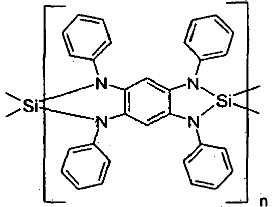 |
| (181) | (182) | (183) |
| 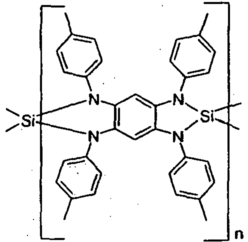 | 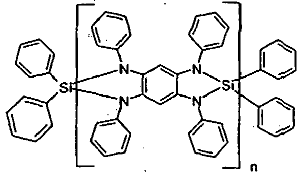 | 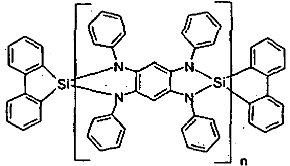 |
| (184) | (185) | (186) |
| 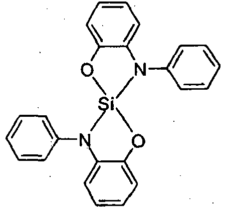 | 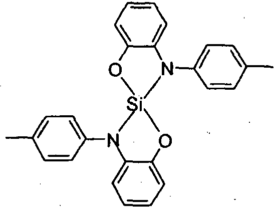 | 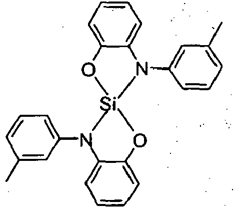 |
| (187) | (188) | (189) |
| 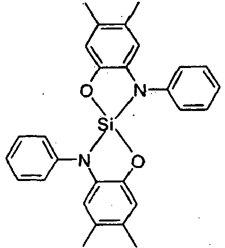 | 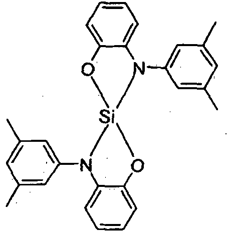 | 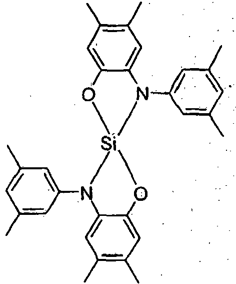 |
| (190) | (191) | (192) |
| 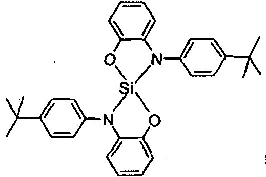 | 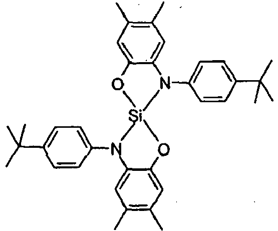 | 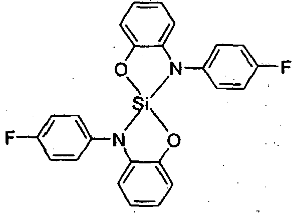 |
| (193) | (194) | (195) |
| 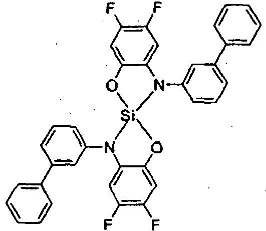 | 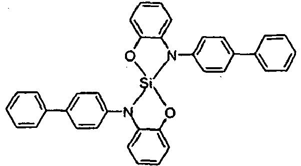 | 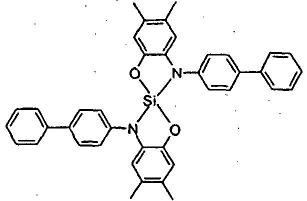 |
| (196) | (197) | (198) |
| 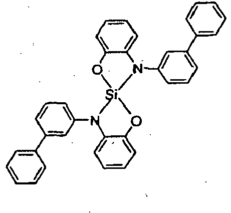 | 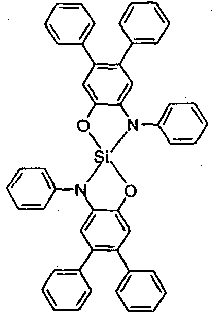 | 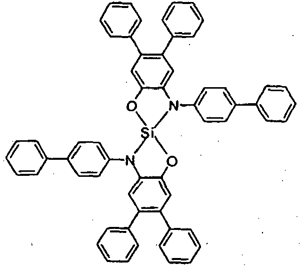 |
| (199) | (200) | (201) |
| 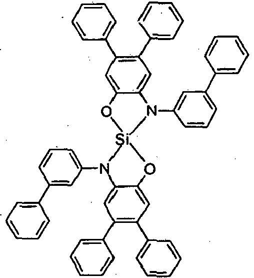 | 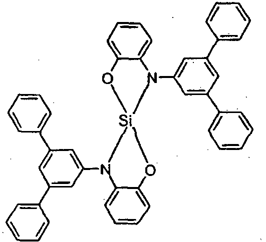 | 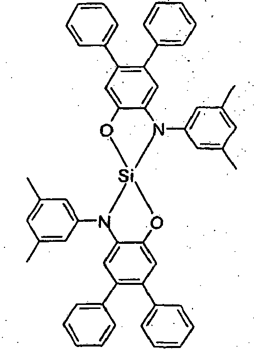 |
| (202) | (203) | (204) |
| 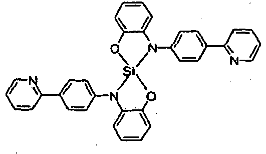 | 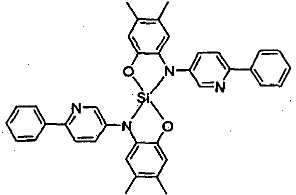 | 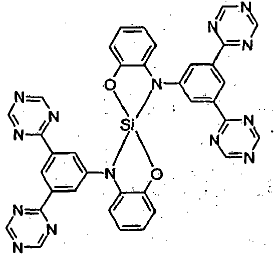 |
| (205) | (206) | (207) |
| 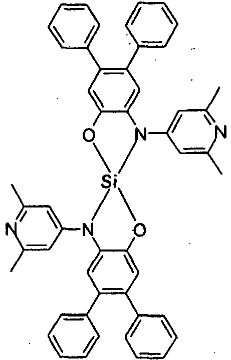 | 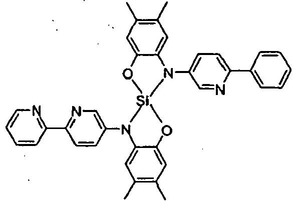 | 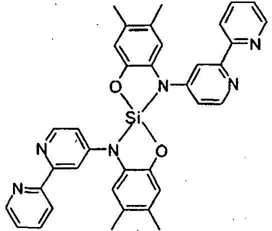 |
| (208) | (209) | (210) |
| 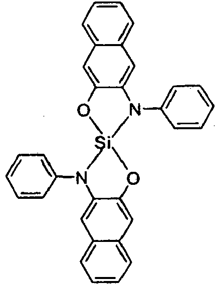 | 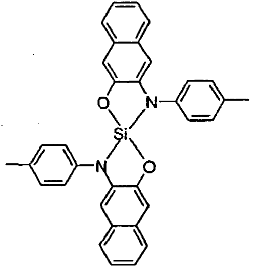 | 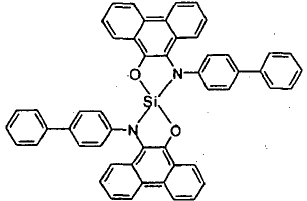 |
| (211) | (212) | (213) |
| 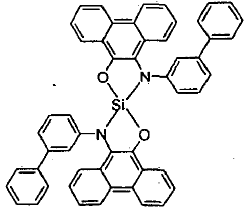 | 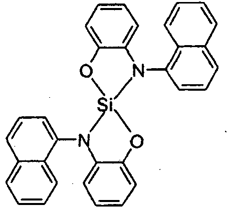 | 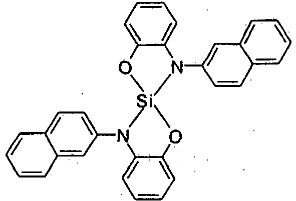 |
| (214) | (215) | (216) |
| 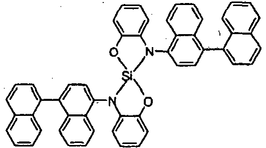 | 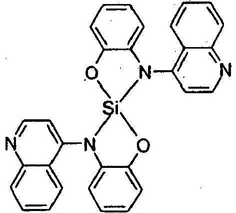 | 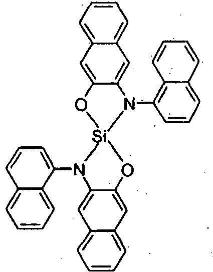 |
| (217) | (218) | (219) |
| 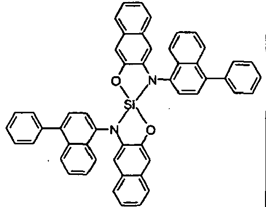 | 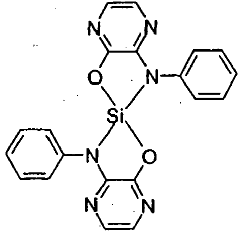 | 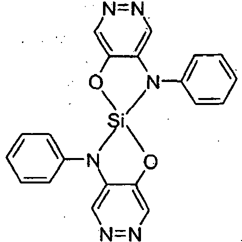 |
| (220) | (221) | (222) |
| 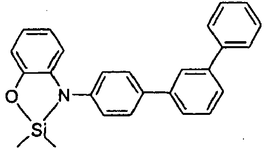 | 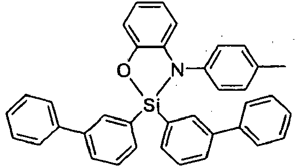 | 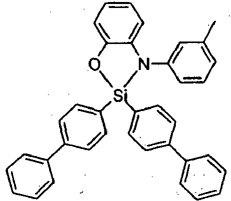 |
| (223) | (224) | (225) |
| 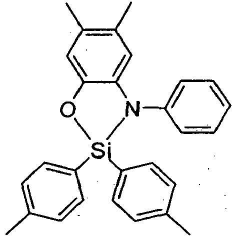 | 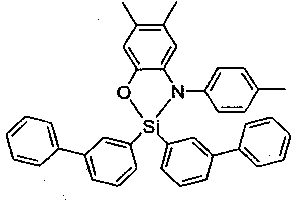 | 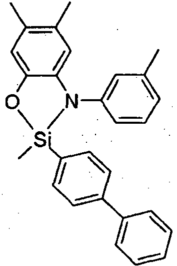 |
| (226) | (227) | (228) |
| 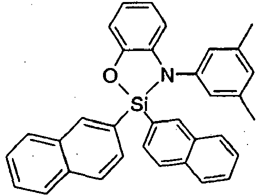 | 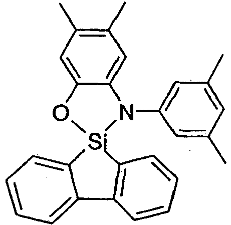 | 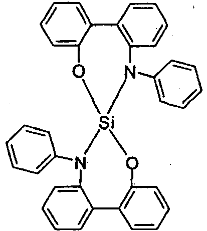 |
| (229) | (230) | (231) |
| 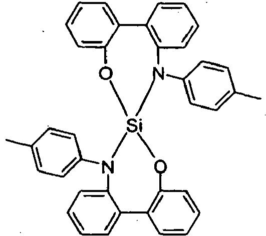 | 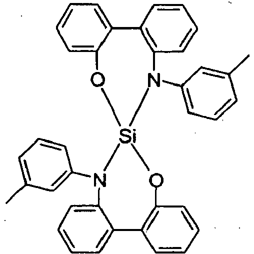 | 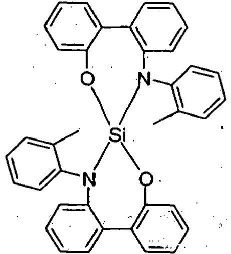 |
| (232) | (233) | (234) |
| 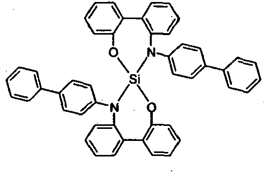 | 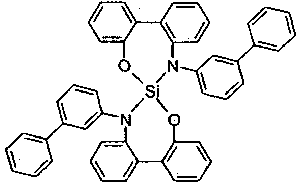 | 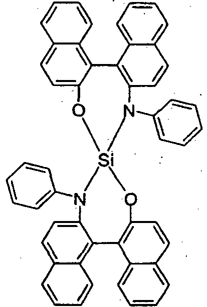 |
| (235) | (236) | (237) |
| 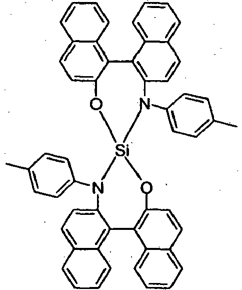 | 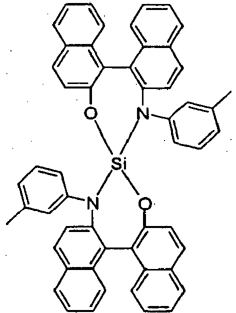 | 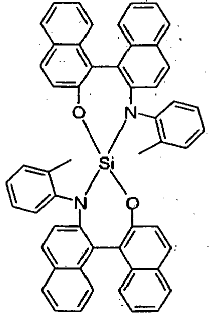 |
| (238) | (239) | (240) |
| 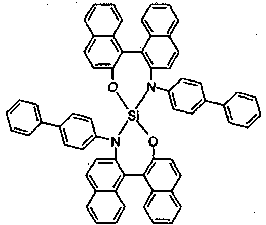 | 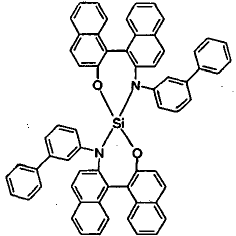 | 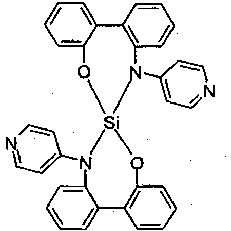 |
| (241) | (242) | (243) |
| 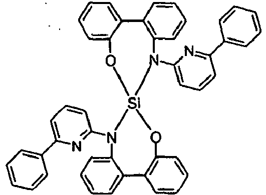 | 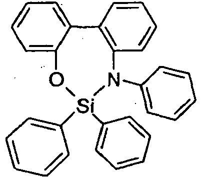 | 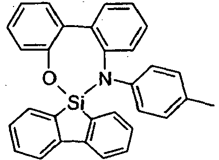 |
| (244) | (245) | (246) |
| 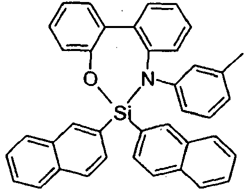 | 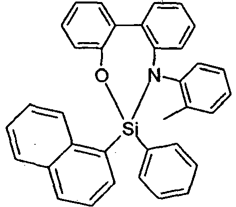 | 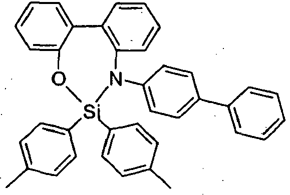 |
| (247) | (248) | (249) |
| 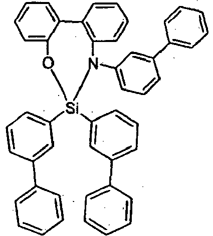 | 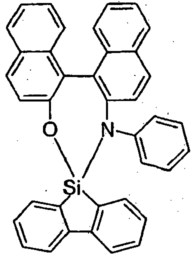 | 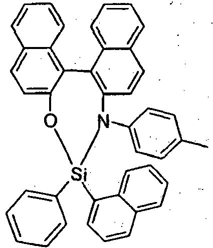 |
| (250) | (251) | (252) |
| 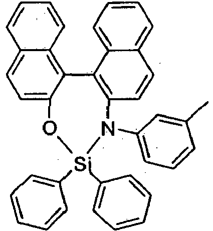 | 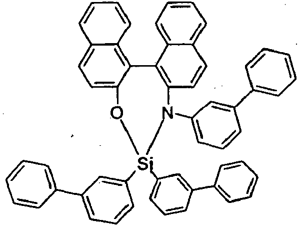 | 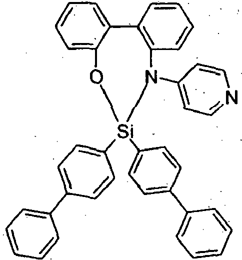 |
| (253) | (254) | (255) |
| 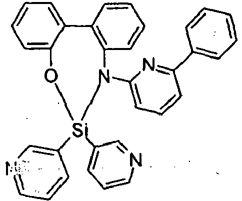 | 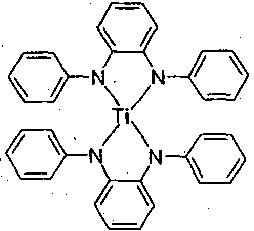 | 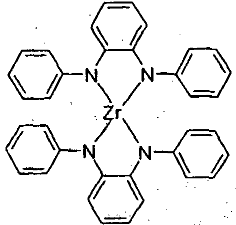 |
| (256) | (257) | (258) |
| 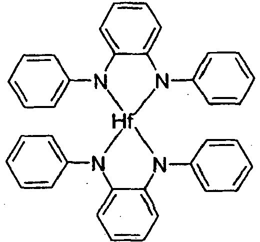 | 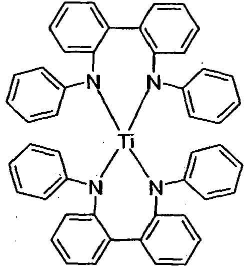 | 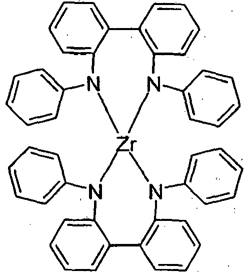 |
| (259) | (260) | (261) |
| 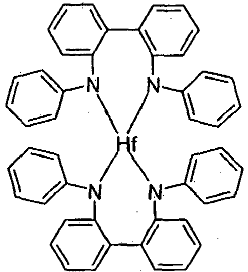 | 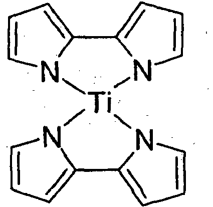 | 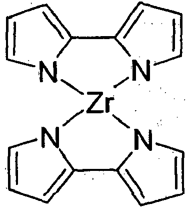 |
| (262) | (263) | (264) |
| 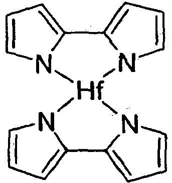 | 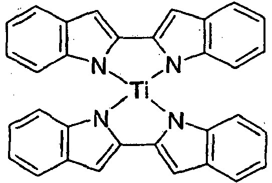 | 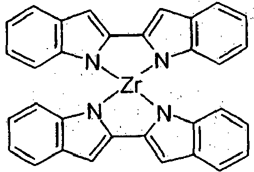 |
| (265) | (266) | (267) |
| 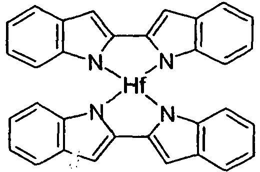 | 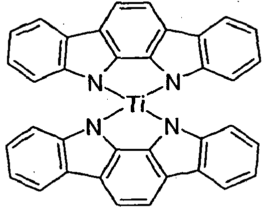 | 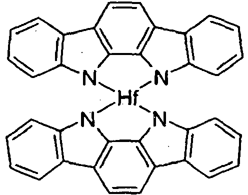 |
| (268) | (269) | (270) |
| 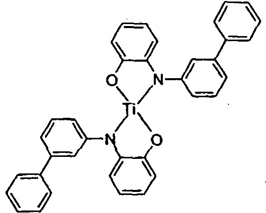 | 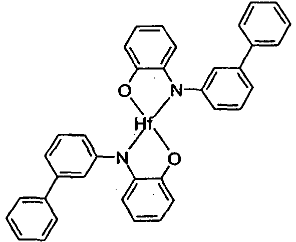 | 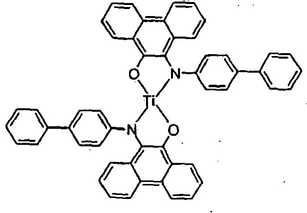 |
| (271) | (272) | (273) |
| 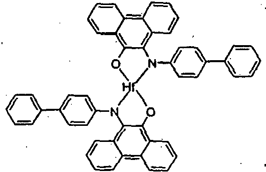 | 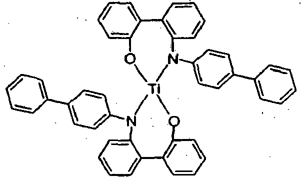 | 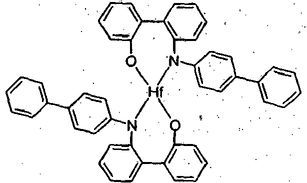 |
| (274) | (275) | (276) |
| 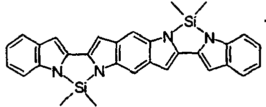 | 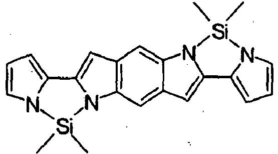 | 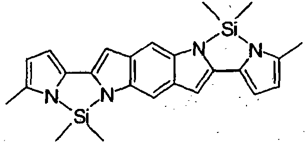 |
| (277) | (278) | (279) |
| 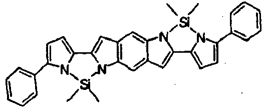 | | |
| (280) | | |

Die erfindungsgemäßen Verbindungen und die damit hergestellten organischen Elektrolumineszenzvorrichtungen zeichnen sich durch folgende überraschende Vorteile gegenüber dem Stand der Technik aus:
1. Im Gegensatz zu vielen Verbindungen gemäß dem Stand der Technik, die der teilweisen oder vollständigen pyrolytischen Zersetzung bei Sublimation unterliegen, weisen die erfindungsgemäßen Verbindungen bzw. die Verbindungen gemäß Formel (9*) bis (17*) eine hohe thermische Stabilität auf.
2. Die erfindungsgemäßen Verbindungen bzw. die Verbindungen gemäß Formel (9*) bis (17*), eingesetzt in organischen Elektrolumineszenzvorrichtungen, führen zu hohen Effizienzen und zu steilen Strom-Spannungs-Kurven mit niedrigen Einsatzspannungen.
3. Die erfindungsgemäßen Verbindungen bzw. die Verbindungen gemäß Formel (9*) bis (17*), eingesetzt in der elektronenblockierenden bzw. exzitonenblockierenden Schicht einer organischen Elektrolumineszenzvorrichtungen, führen insbesondere zu sehr hohen Effizienzen von phosphoreszierenden OLEDs.
4. Die erfindungsgemäßen Verbindungen bzw. die Verbindungen gemäß Formel (9*) bis (17*), eingesetzt als Matrixmaterial für fluoreszierende oder phosphoreszierende Emitter, führen zu hohen Effizienzen sowie zu langen Lebensdauern. Dies gilt insbesondere, wenn die Verbindungen in Kombination mit einem weiteren Hostmaterial und einem phosphoreszierenden Emitter eingesetzt werden.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße Komplexe herstellen und diese in organischen elektronischen Vorrichtungen verwenden bzw. das erfindungsgemäße Verfahren anwenden und so die Erfindung im gesamten offenbarten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Lösungsmittel und Reagenzien können von ALDRICH bzw. ABCR bezogen werden.

### Beispiel 1-9: Synthese der Diamine

Die nachfolgend aufgeführten Diamine können aus den entsprechenden Dibrom-Aromaten durch Umsetzung mit den entsprechenden Arylaminen analog zu T. Wenderski et al., Tetrahedron Letters, 45(37), 2004, 6851 dargestellt werden.

| **Bsp.** | **Anilin** | **o-Phenylendiamin** | **Ausbeute** |
|---|---|---|---|
| 1 | 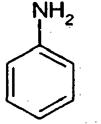 | 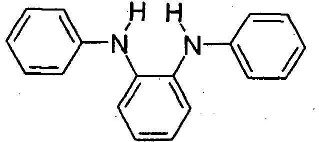 | 85.0 % |
| 2 | 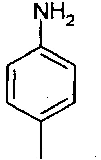 | 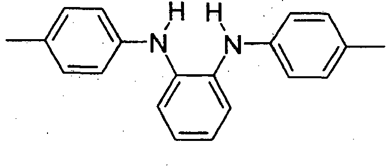 | 88.5 % |
| 3 | 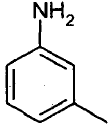 | 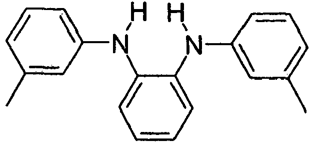 | 72.3 % |
| 4 | 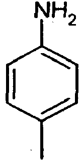 | 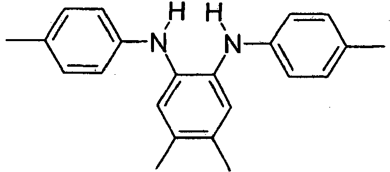 | 61.4 % |
| 5 | 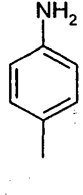 | 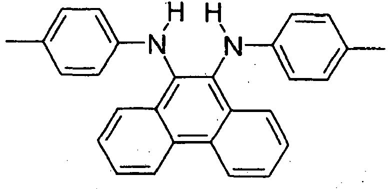 | 77.5 % |
| 6 | 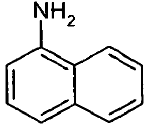 | 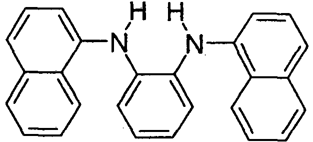 | 41.2 % |
| 7 | 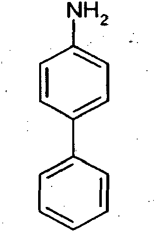 | 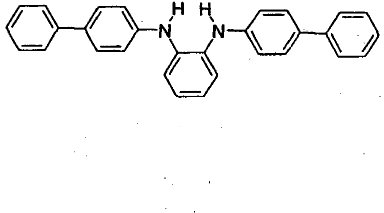 | 76.9 % |
| 8 | 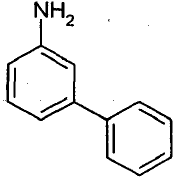 | 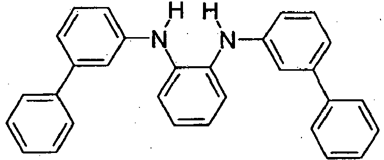 | 67.1 % |
| 9 | 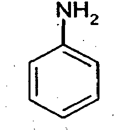 | 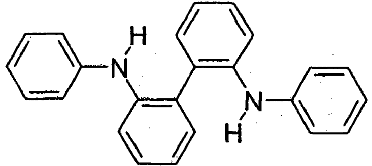 | 53.3 % |

### Beispiel 10-18: Synthese von erfindungsgemäßen Verbindungen

Eine Lösung von 300 mmol des entsprechenden Diamins gemäß Beispiel 1 bis 9 in 2000 ml Diethylether wird bei Raumtemperatur unter Rühren mit 240 ml (600 mmol) *n*-Buthyllitium, 2.5 molar in *n*-Hexan versetzt. Nach vollendeter Zugabe und Abklingen der exothermen Reaktion wird 1 h nachgerührt und dann tropfenweise mit einem Gemisch von 25.5 g (150 mmol) Siliciumtetrachlorid und 100 ml Diethylether versetzt. Nach vollendeter Zugabe und Abklingen der exothermen Reaktion wird 1 h nachgerührt, dann wird der Diethylether im Vakuum entfernt, der Rückstand wird in ca. 300 ml Toluol aufgenommen und an Aluminumoxid, basisch, Aktivitätsstufe 1 chromatographiert. Das so erhaltene Rohprodukt wird anschließend viermal aus Toluol / Ethanol (1:2, ca. 6 ml / g) umkristallisiert und dann zweimal im Hochvakuum (p = 10 ⁻⁵ mbar) sublimiert. *

| **Bsp.** | **Diamin** | **Erfindungsgemäße Verbindung** | **Ausbeute** |
|---|---|---|---|
| 10 | 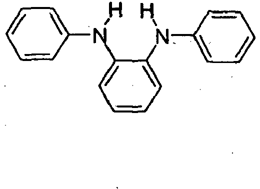 | 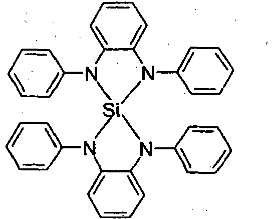 | 44.0 % |
| 11 | 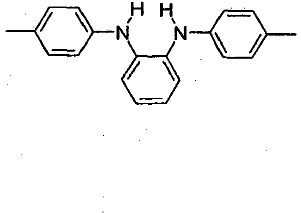 | 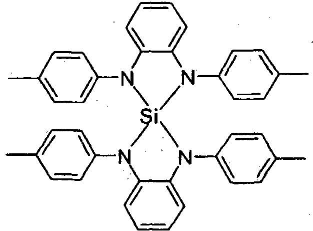 | 33.8 % |
| 12 | 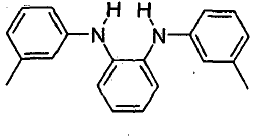 | 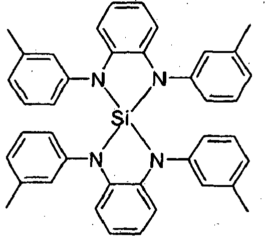 | 27.1 % |
| 13 | 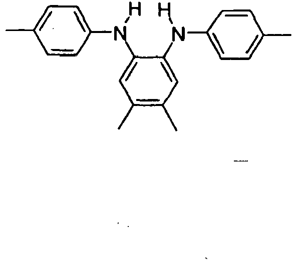 | 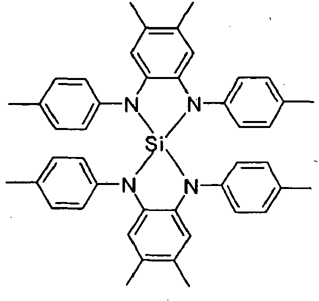 | 36.8 % |
| 14 | 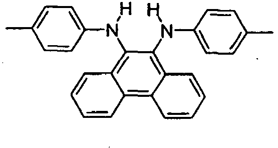 | 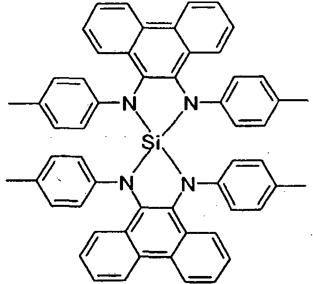 | 53.3 % |
| 15 | 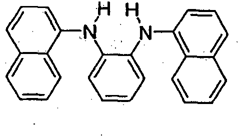 | 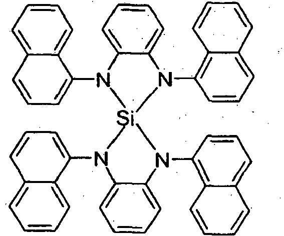 | 61.0 % |
| 16 | 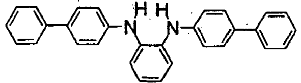 | 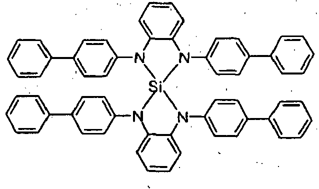 | 55.4 % |
| 17 | 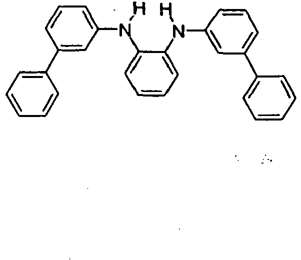 | 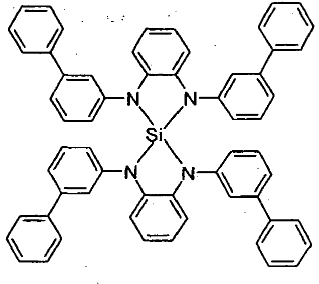 | 32.0 % |
| 18 | 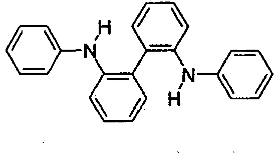 | 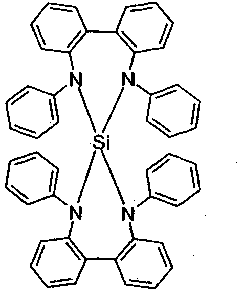 | 17.9 % |

### Beispiel 19-22: Synthese von erfindungsgemäßen Verbindungen

Eine Lösung von 300 mmol des entsprechenden Diamins gemäß Beispiel 1 bzw. 5 in 2000 ml Diethylether wird bei Raumtemperatur unter Rühren mit 240 ml (600 mmol) *n*-Buthyllitium, 2.5 molar in *n*-Hexan versetzt. Nach vollendeter Zugabe und Abklingen der exothermen Reaktion wird 1 h nachgerührt und dann tropfenweise mit einem Gemisch von 150 mmol des entsprechenden Dichlor-diarylsilans bzw. -dialkylsilans und 100 ml Diethylether versetzt. Nach vollendeter Zugabe und Abklingen der exothermen Reaktion wird 1 h nachgerührt, dann wird der Diethylether im Vakuum entfernt, der Rückstand wird in ca. 300 ml Toluol aufgenommen und an Aluminiumoxid, basisch, Aktivitätsstufe 1 chromatographiert. Das so erhaltene Rohprodukt wird anschließend viermal aus Toluol / Ethanol (1:2, ca. 6 ml / g) umkristallisiert und dann zweimal im Hochvakuum (p = 10 ⁻⁵ mbar) sublimiert.

| **Bsp.** | **Diamin** | **Erfindungsgemäße Verbindung** | **Ausbeute** |
|---|---|---|---|
| 19 | 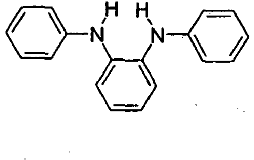 | 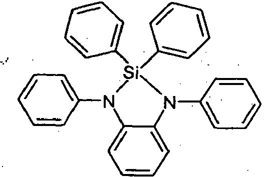 | 71.7 % |
| 20 | 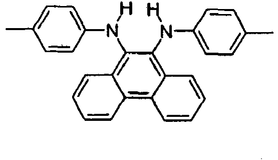 | 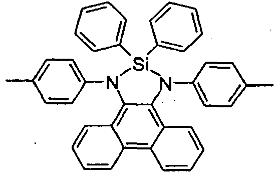 | 58.5 % |
| 21 | 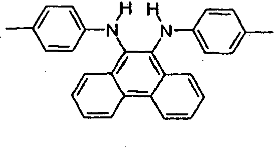 | 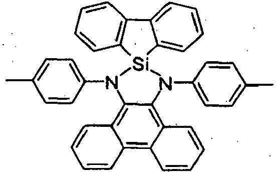 | 72.0 % |
| 22 | 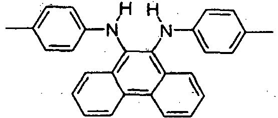 | 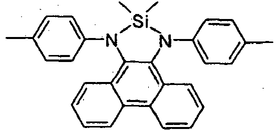 | 66.1 % |

### Herstellung der OLEDs

Die Herstellung von erfindungsgemäßen OLEDs sowie OLEDs nach dem Stand der Technik erfolgt nach einem allgemeinen Verfahren gemäß WO 04/058911, das auf die hier beschriebenen Gegebenheiten (Schichtdickenvariation, verwendete Materialien) angepasst wird.

In den folgenden Beispielen 23 bis 46 (siehe Tabellen 1 und 2) werden die Ergebnisse verschiedener OLEDs vorgestellt. Glasplättchen, die mit strukturiertem ITO (Indium Zinn Oxid) der Dicke 150 nm beschichtet sind werden zur verbesserten Prozessierung mit 20 nm PEDOT beschichtet (Poly(3,4-ethylendioxy-2,5-thiophen), aus Wasser aufgeschleudert; bezogen von H. C. Starck, Goslar, Deutschland). Diese beschichteten Glasplättchen bilden die Substrate, auf welche die OLEDs aufgebracht werden. Die OLEDs haben prinzipiell folgenden Schichtaufbau: Substrat / Lochinjektionsschicht(HIL1, mit HIL1, 20 nm) / Lochtransportschicht (HTL, mit HTM1 20nm) / Elektronenblockerschicht (EBL, 20 nm) / Emissionsschicht (EML, 40 nm) / Elektronentransportschicht (ETL, mit ETL1 20 nm) / Elektroneninjektionsschicht (EIL, mit LiF 1 nm) und abschließend eine Kathode. Die Kathode wird durch eine 100 nm dicke Aluminiumschicht gebildet. Der genaue Aufbau der OLEDs, insbesondere der Aufbau der EBL, EML und HBL, ist Tabelle 1 für grün emittierende OLEDs und Tabelle 2 für blau emittierende OLEDs zu entnehmen. Die zur Herstellung der OLEDs verwendeten Materialien sind in Tabelle 3 gezeigt.

Alle Materialien werden in einer Vakuumkammer thermisch aufgedampft. Dabei besteht die Emissionsschicht immer aus mindestens einem Matrix-material (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie M1:M2:TEG1 (55%:35%:10%) bedeutet hierbei, dass das Material M1 in einem Volumenanteil von 55%, M2 in einem Anteil von 35% und TEG1 in einem Anteil von 10% in der Schicht vorliegt.

Die noch nicht optimierte OLEDs werden standardmäßig charakterisiert. Hierfür werden die Elektrolumineszenzspektren, die Stromeffizienz (gemessen in cd/A), die Leistungseffizienz (gemessen in Im/W) und die externe Quanteneffizienz (EQE, gemessen in Prozent) in Abhängigkeit der Leuchtdichte, berechnet aus Strom-Spannungs-Helligkeits-Kennlinien (IUL-Kennlinien) sowie die Lebensdauer bestimmt. Als Lebensdauer wird die Zeit definiert, nach der die Leuchtdichte von einer bestimmten Startleuchtdichte I₀ auf einen gewissen Anteil abgesunken ist. Die Angabe LD50 bedeutet, dass es sich bei der genannten Lebensdauer um die Zeit handelt, bei der die Leuchtdichte auf 0.5.I₀ (auf 50%) abgefallen ist, also von z.B. 8000 cd/m² auf 4000 cd/m². Die in den Tabellen angegebenen Effizienzen und Spannungen beziehen sich auf die entsprechenden Werte bei einer Betriebshelligkeit von 1000 cd/m².

Wie aus den oben aufgeführten Beispielen deutlich zu erkennen ist, eignen sich die erfindungsgemäßen Materialien besonders gut für die Verwendung als Elektronenblockiermaterialien bzw. Exzitonenblockiermaterialien. In dieser Funktion führen sie in einer phosphoreszierenden OLED zu einer deutlichen Effizienzsteigerung sowie bei blau phosphoreszierenden Emittern zu einer niedrigeren Betriebsspannung.

**Tabelle 1**

| Bsp | EBL | EML | HBL | Effizienz [cd/A] | Spannung [V] | Farbe CIE x/y | LD50 [h] |
|---|---|---|---|---|---|---|---|
| 23 | - (Vgl.) | M1:TEG1 (15%) | - | 32.8 | 4.3 | 0.33/0.61 | 32000 |
| 24 | Bsp. 10 | M1:TEG1 (15%) | - | 53.2 | 4.6 | 0.33/0.61 | 26000 |
| 25 | Bsp. 11 | M1:TEG1 (15%) | - | 43.8 | 4.4 | 0.33/0.61 | 29000 |
| 26 | Bsp. 13 | M1:TEG1 (15%) | - | 49.0 | 4.5 | 0.33/0.61 | 27000 |
| 27 | - | M1: Bsp.10 (10%): TEG1 (10%) | M1 | 38.6 | 4.7 | 0.32/0.62 | 28000 |
| 28 | Bsp. 10 | M1:Bsp.10(10%): TEG1(10%) | M1 | 54.6 | 5.9 | 0.32/0.62 | 15000 |
| 29 | Bsp. 10 | M1: Bsp. 10 (30%): TEG2(10%) | M1 | 48.0 | 4.4 | 0.36/0.60 | 50000 |
| 30 | Bsp. 10 | M1: TEG1 (3%): TEG3(10%) | M1 | 60.5 | 5.6 | 0.34/0.62 | 12000 |
| 31 | Bsp. 10 | M2: Bsp. 10 (10%): TEG1(5%) | M2 | 59.8 | 6.8 | 0.28/0.63 | 10000 |
| 32 | Bsp. 11 | M1: Bsp.11 (20%): TEG1(10%) | M1 | 55.3 | 5.6 | 0.30/0.63 | 28000 |

**Tabelle 2**

| Bsp | EBL | EML | HBL | Effizienz [cd/A] | Spannung [V] | Farbe CIE x/y |
|---|---|---|---|---|---|---|
| 34 | - (Vgl.) | M1:TEB1 (15%) | - | 2.1 | 7.8 | 0.16/0.26 |
| 35 | Bsp. 10 | M1:TEB1 (10%) | - | 16.5 | 8.2 | 0.16/0.27 |
| 36 | Bsp. 11 | M1:TEB1 (15%) | - | 15.9 | 8.8 | 0.16/0.26 |
| 37 | Bsp. 12 | M1:TEB1 (15%) | - | 16.9 | 6.8 | 0.16/0.27 |
| 38 | Bsp. 13 | M1:TEB1 (15%) | - | 15.9 | 6.9 | 0.16/0.26 |
| 39 | Bsp. 14 | M1:TEB1 (15%) | - | 16.3 | 7.0 | 0.16/0.26 |
| 40 | Bsp. 10 | M1:Bsp.10 (10%): TEB1 (5%) | M1 | 21.6 | 8.0 | 0.16/0.28 |
| 41 | Bsp. 10 | M1:Bsp.10 (10%): TEB2 (5%) | M1 | 31.5 | 5.3 | 0.15/0.34 |
| 42 | Bsp. 10 | M2:Bsp.10 (10%): TEB1 (5%) | M2 | 32.1 | 8.0 | 0.14/0.26 |
| 43 | Bsp. 10 | M2:Bsp.10 (10%): TEB2 (5%) | M2 | 39.3 | 6.0 | 0.14/0.32 |
| 44 | Bsp. 11 | M1:Bsp.11 (10%): TEB1 (10%) | M1 | 17.6 | 8.5 | 0.15/0.29 |
| 45 | Bsp. 11 | M2:Bsp.11 (10%): TEB1 (10%) | M2 | 29.9 | 9.2 | 0.15/0.26 |
| 46 | Bsp. 13 | M1:Bsp. 13(10%): TEB1:(10%) | M1 | 6.2 | 8.4 | 0.15/0.25 |

**Tabelle 3: Strukturformeln der verwendeten Materialien**

| | |
|---|---|
| 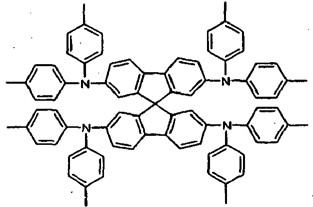 | 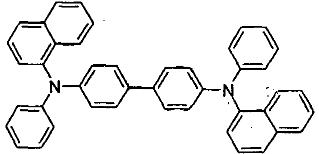 |
| HIL1 | HTM1 (NPB) |
| 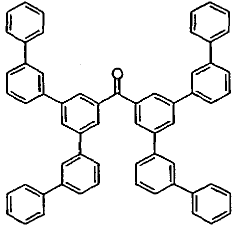 | 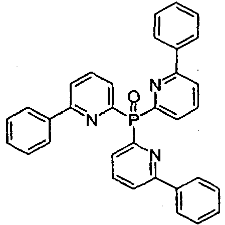 |
| M1 | M2 |
| 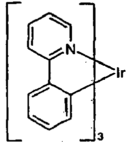 | 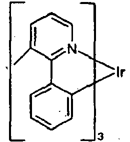 |
| TEG1 | TEG2 |
| 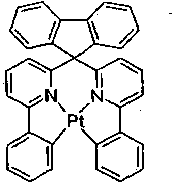 | 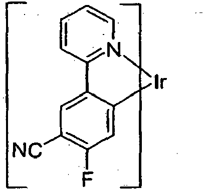 |
| TEG3 | TEB1 |
| 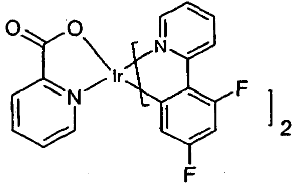 | 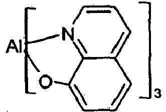 |
| TEB2 | ETM1 (Alq) |

## Patentansprüche

1. Verbindungen gemäß Formel (9), 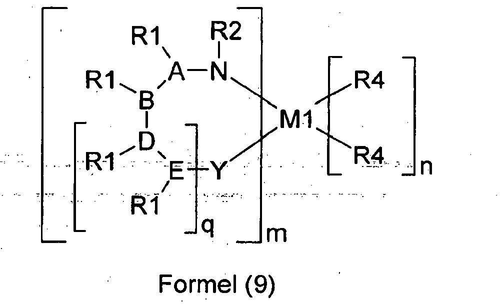 worin
M1 Si, Ge oder Sn ist;
q 0 oder 1 ist;
A, B, D und E jeweils ein C-Atom ist; dabei liegt zwischen A und B eine Doppelbindung bzw. eine aromatische Bindung vor, wenn A nicht mit N ein aromatisches System aufspannt, und es liegt zwischen A und B eine Einfachbindung vor, wenn A mit N ein aromatisches System aufspannt; weiterhin liegt zwischen D und E eine Doppel-bindung bzw. eine aromatische Bindung vor, wenn E nicht mit Y ein aromatisches System aufspannt, und es liegt zwischen D und E eine Einfachbindung vor, wenn E mit Y ein aromatisches System aufspannt;
Y ausgewählt ist aus der Gruppe bestehend aus NR2, O und S;
R1 bei jedem Auftreten gleich oder verschieden ist und ausgewählt ist aus der Gruppe bestehend aus H, D, F, Cl, Br, I, CN, NO₂, N(R3)₂, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder eine Alkenyl-gruppe mit 2 bis 40 C-Atomen, die jeweils mit einem oder mehreren Resten R3 substituiert sein kann, wobei eine oder mehrere nicht-benachbarte CH₂-Gruppen durch R3C=CR3, C=C, Si(R3)₂, Ge(R3)₂, Sn(R3)₂, C=O, C=S, C=Se, C=NR3, P(=O)(R3), SO, SO₂, NR3, O, S oder CONR3 ersetzt sein können und wobei ein oder mehrere H-Atome durch D, F, Cl, Br, I, CN oder NO₂ ersetzt sein können, einem aromatischen oder heteroaromatischen Ringsystem mit 5 bis 60 aromatischen Ringatomen, das jeweils mit einem oder mehreren Resten R3 substituiert sein kann, einer Aryloxy- oder Heteroaryloxygruppe mit 5 bis 60 aromatischen Ringatomen, die mit einem oder mehreren Resten R3 substituiert sein können, und einer Kombination dieser Systeme, wobei optional jeweils zwei in der Teilstruktur gemäß Formel (9) in 1,2-Stellung zueinander benachbart stehende Substituenten R1 ein monocyclisches oder polycyclisches, gerade oder angular anelliertes, aliphatisches, aromatisches oder heteroaromatisches Ringsystem bilden können, das mit einem oder mehreren Resten R3 substituiert sein kann;
R2 bei jedem Auftreten gleich oder verschieden ist und ausgewählt ist aus der Gruppe bestehend.aus einer geradkettigen Alkylgruppe mit 1 bis 40 C-Atomen oder einer verzweigten oder cyclischen Alkylgruppe mit 3 bis 40 C-Atomen, die jeweils mit einem oder mehreren Resten R3 substituiert sein kann, wobei eine oder mehrere nicht-benachbarte CH₂-Gruppen durch R3C=CR3, C=C oder C=O ersetzt sein können und wobei ein oder mehrere H-Atome durch F, Cl, Br, I, CN oder NO₂ ersetzt sein können, einem aromatischen oder heteroaromatischen Ringsystem mit 5 bis 60 aromatischen Ringatomen, das jeweils mit einem oder mehreren Resten R3 substituiert sein kann, und einer Kombination dieser Systeme; mit der Maßgabe, dass in der Struktur gemäß Formel (9) mindestens eine Gruppe R2 vorhanden ist, welche ein aromatisches oder heteroaromatisches Ringsystem darstellt, das jeweils mit einem oder mehreren Resten R3 substituiert sein kann; dabei können optional solche R1 und R2, die in der Teilstruktur gemäß Formel (9) in 1,2-Position zueinander benachbart stehen, ein monocyclisches oder polycyclisches, gerade oder angular anelliertes, aliphatisches, aromatisches oder heteroaromatisches Ringsystem bilden, das mit einem oder mehreren Resten R3 substituiert sein kann;
R4 bei jedem Auftreten gleich oder verschieden ist und ausgewählt ist aus der Gruppe bestehend aus N(R3)₂, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder Alkenylgruppe mit 2 bis 40 C-Atomen, die jeweils mit einem oder mehreren Resten R3 substituiert sein kann, wobei eine oder mehrere nicht-benachbarte CH₂-Gruppen durch R3C=CR3, C=C, Si(R3)₂, Ge(R3)₂, Sn(R3)₂, C=O, C=S, C=Se, C=NR3, P(=O)(R3), SO, SO₂, NR3, O, S oder CONR3 ersetzt sein können und wobei ein oder mehrere H-Atome durch D, F, Cl, Br, I, CN oder NO₂ ersetzt sein können, einem aromatischen oder heteroaromatischen Ringsystem mit 5 bis 60 aromatischen Ringatomen, das jeweils mit einem oder mehreren Resten R3 substituiert sein kann, einer Aryloxy- oder Heteroaryloxygruppe mit 5 bis 60 aromatischen Ringatomen, die mit einem oder mehreren Resten R3 substituiert sein können, und einer Kombination dieser Systeme, wobei optional zwei oder mehr Substituenten R4 ein monocyclisches oder polycyclisches, gerade oder angular anelliertes, aliphatisches, aromatisches oder heteroaromatisches Ringsystem bilden können, das mit einem oder mehreren Resten R3 substituiert sein kann;
R3 bei jedem Auftreten gleich oder verschieden ist und ausgewählt ist aus der Gruppe bestehend aus H, D, aliphatischem Kohlenwasserstoffrest mit 1 bis 20 C-Atomen, aromatischem oder hetero-aromatischem Ringsystem mit 5 bis 30 aromatischen Ringatomen, in dem ein oder mehrere H-Atome durch D, F, Cl, Br, I, CN oder NO₂ ersetzt sein können;
m ist 1 oder 2;
n ist (2 - m);
dabei sind die folgenden Verbindungen von der Erfindung ausgeschlossen:

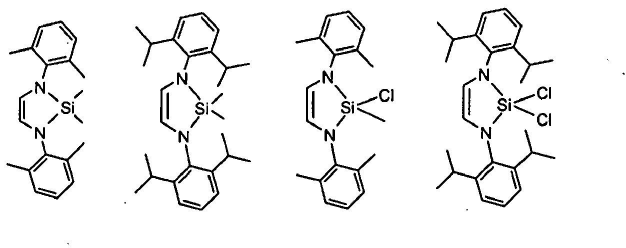

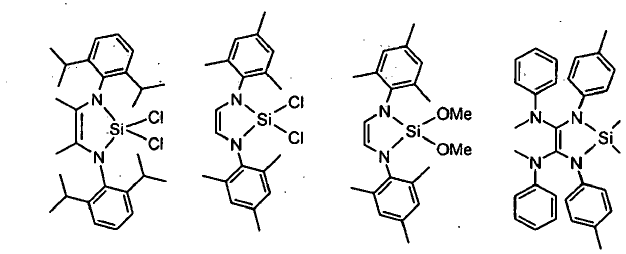

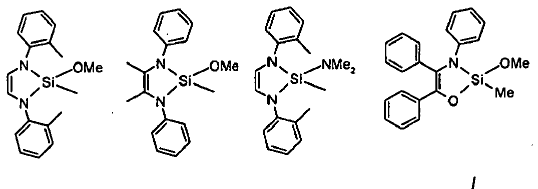

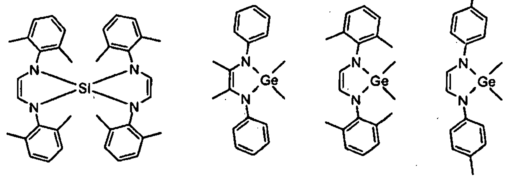

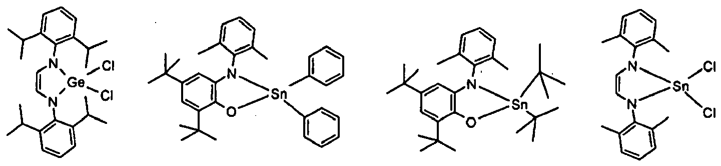

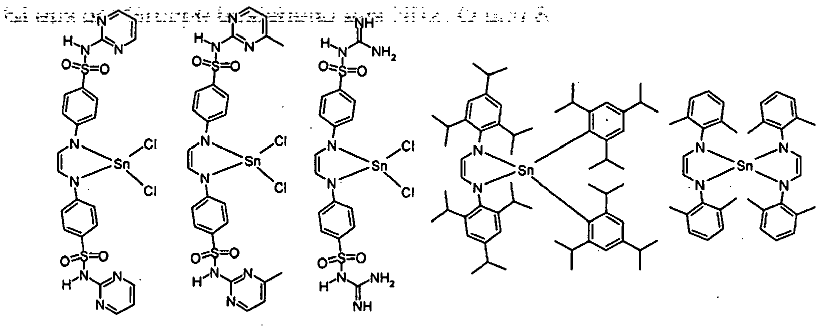

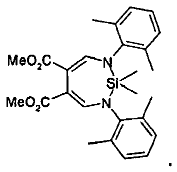

2. Verbindungen nach Anspruch 1 gemäß einer der Formeln (10) bis (17), 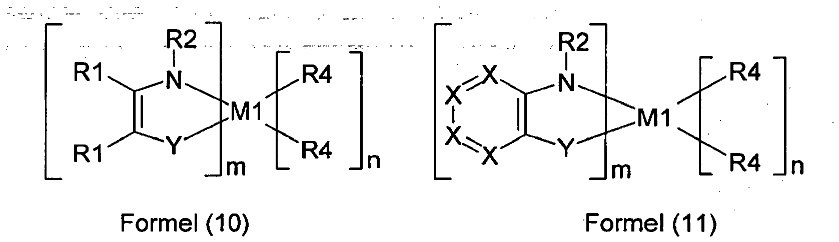 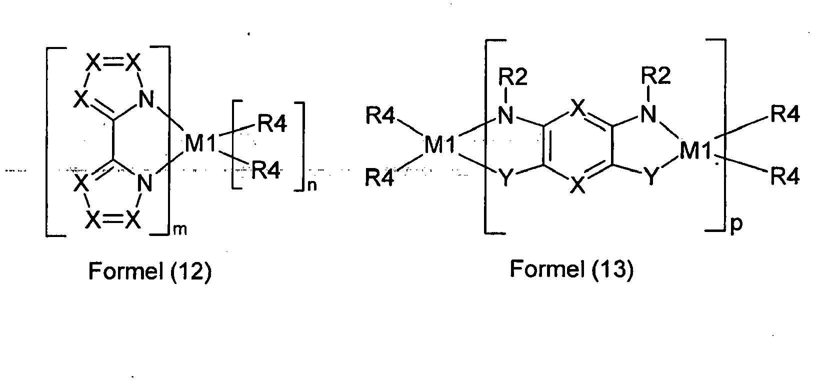 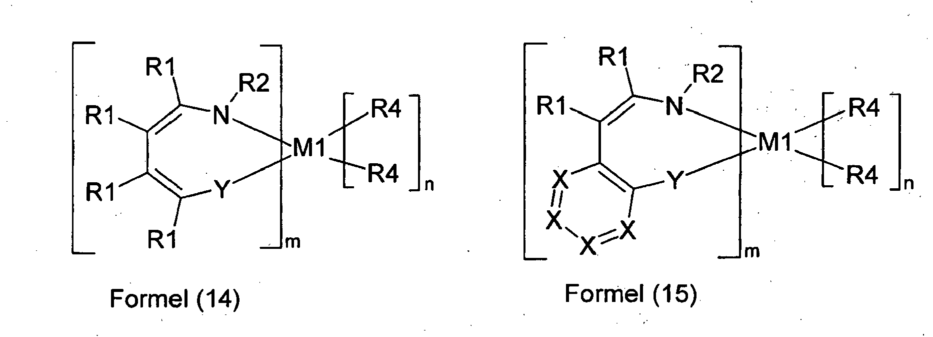 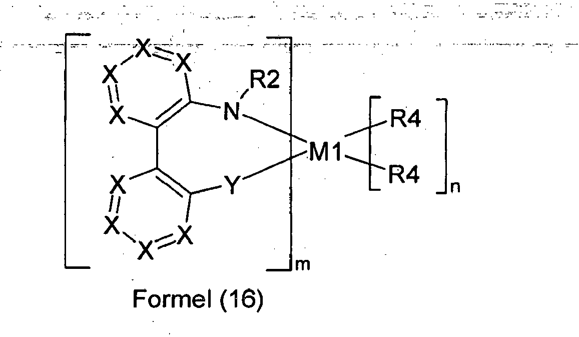 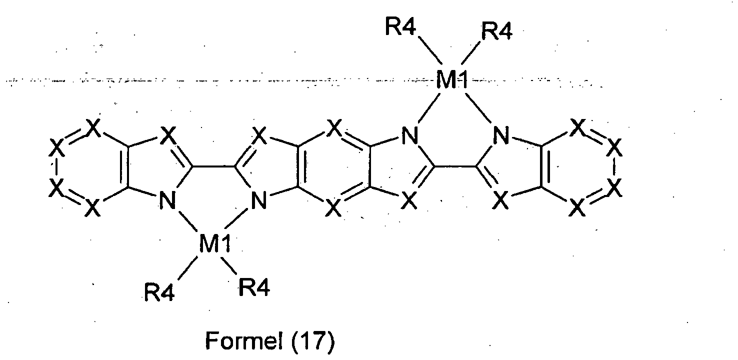 worin M1, R1, R2, R3, R4, Y, m und n wie in Anspruch 1 definiert sind, X gleich oder verschieden bei jedem Auftreten ausgewählt ist aus der Gruppe bestehend aus CR1 und N, und p eine ganze Zahl von 1 bis 100.000, bevorzugt 1 bis 10.000, besonders bevorzugt 1 bis 100, ganz besonders bevorzugt 1 ist.

3. Verbindungen nach Anspruch 1 oder 2, **dadurch gekennzeichnet, dass** m = 2 und n = 0 ist.

4. Verbindungen nach einem oder mehreren der Ansprüche 1 bis 3, **dadurch gekennzeichnet, dass** M1 für Si oder Ge steht, insbesondere für Si.

5. Verbindungen nach einem oder mehreren der Ansprüche 1 bis 4, **dadurch gekennzeichnet, dass** Y für NR2 oder O steht, insbesondere NR2.

6. Verbindungen nach einem oder mehreren der Ansprüche 2 bis 5, **dadurch gekennzeichnet, dass** X für CR1 steht.

7. Verbindungen nach einem oder mehreren der Ansprüche 1 bis 6, **dadurch gekennzeichnet, dass** R4 bei jedem Auftreten gleich oder verschieden ausgewählt ist aus der Gruppe bestehend aus einer geradkettigen Alkylgruppe mit 1 bis 20 C-Atomen oder einer verzweigten oder cyclischen Alkylgruppe mit 3 bis 20 C-Atomen, die jeweils mit einem oder mehreren Resten R3 substituiert sein kann, wobei eine oder mehrere nicht-benachbarte CH₂-Gruppen durch R3C=CR3, C=C, Si(R3)₂, Ge(R3)₂, Sn(R3)₂, C=O, C=S, C=Se, C=NR3, P(=O)(R3), SO, SO₂, NR3, O, S oder CONR3 ersetzt sein können und wobei ein oder mehrere H-Atome durch F, Cl, Br, I, CN oder NO₂ ersetzt sein können, einem aromatischen oder heteroaromatischen Ringsystem mit 5 bis 60 aromatischen Ringatomen, das jeweils mit einem oder mehreren Resten R3 substituiert sein kann, und einer Kombination dieser Systeme, wobei optional zwei oder mehr Substituenten R4 ein monocyclisches oder polycyclisches, gerade oder angular anelliertes, aliphatisches, aromatisches oder heteroaromatisches Ringsystem bilden können, das mit einem oder mehreren Resten R3 substituiert sein kann.

8. Verbindungen nach einem oder mehreren der Ansprüche 1 bis 7, in denen:
M1 ausgewählt ist aus der Gruppe bestehend aus Si, Ge, bevorzugt Si;
R1 wie in Anspruch 1 definiert ist;
R2 bei jedem Auftreten gleich oder verschieden ein aromatisches oder heteroaromatisches Ringsystem mit 5 bis 30 aromatischen Ringatomen ist, in dem optional ein oder mehrere H-Atome durch F-Atome ersetzt sind, welches jeweils durch einen oder mehrere Reste R3 substituiert sein kann;
X gleich CR1 ist;
Y gleich NR2 ist.

9. Verfahren zur Herstellung von Verbindungen nach einem oder mehreren der Ansprüche 1 bis 8 durch Umsetzung von M1(Hal)₂ₘ(R4)₂ₙ, insbesondere M1Hal₄, wobei M1, m und n die in Anspruch 1 genannte Bedeutung haben und Hal für Cl, Br oder I stehet, mit einem entsprechenden Diamin, einem Aminoalkohol, einem Aminothiol oder der jeweiligen deprotonierten Verbindung.

10. Oligomere, Polymere oder Dendrimere enthaltend eine oder mehrere Verbindungen nach einem oder mehreren der Ansprüche 1 bis 8, wobei ein oder mehrere Bindungen der ertndungsgemäßen Verbindung zum Polymer, Oligomer oder Dendrimer vorhanden sind.

11. Verwendung einer Verbindung gemäß Formel (9*), 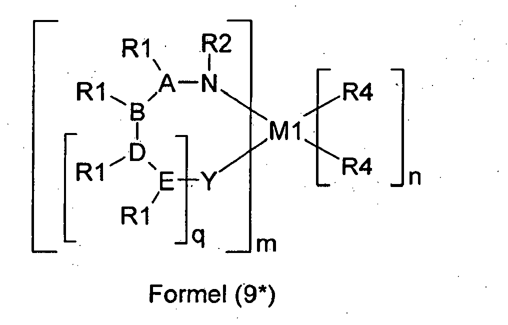 worin gilt:
M1 ist ausgewählt ist aus Si, Ge, Sn, Ti, Zr, Hf, Cr, Mo und W,
m ist 1 oder 2 für M1 = Si, Ge, Sn, Ti, Zr oder Hf, und 1, 2 oder 3 für M1 = Cr, Mo oder W;
n ist (2 - m) für M1 = Si, Ge, Sn, Ti, Zr oder Hf, und (3 - m) für M1 = Cr, Mo oder W;
R2 ist bei jedem Auftreten gleich oder verschieden eine geradkettige Alkylgruppe mit 1 bis 40 C-Atomen oder eine verzweigten oder cyclische Alkylgruppe mit 3 bis 40 C-Atomen, die jeweils mit einem oder mehreren Resten R3 substituiert sein kann, wobei eine oder mehrere nicht-benachbarte CH₂-Gruppen durch R3C=CR3, C=C oder C=O ersetzt sein können und wobei ein oder mehrere H-Atome durch D, F, CI, Br, I, CN oder NO₂ ersetzt sein können, ein aromatisches oder heteroaromatisches Ringsystem mit 5 bis 60 aromatischen Ringatomen, das jeweils mit einem oder mehreren Resten R3 substituiert sein kann, und einer Kombination dieser Systeme; mit der Maßgabe, dass in der Struktur gemäß Formel (9*) mindestens eine Gruppe R2 vorhanden ist, welche ein aromatisches oder hetero-aromatisches Ringsystem darstellt, das jeweils mit einem oder mehreren Resten R3 substituiert sein kann; dabei können optional solche R1 und R2, die in der Verbindung gemäß Formel (9*) in 1,2-Position zueinander benachbart stehen, ein monocyclisches oder polycyclisches, gerade oder angular anelliertes, aliphatisches, aromatisches oder heteroaromatisches Ringsystem bilden, das mit einem oder mehreren Resten R3 substituiert sein kann;
die weiteren verwendeten Symbole und Indizes haben die in Anspruch 1 genannten Bedeutungen;
oder eines Oligomers, Polymers oder Dendrimers enthaltend diese Teilstruktur in organischen elektronischen Bauteilen.

12. Elektronische Vorrichtung, insbesondere organische ElektrolumineszenzVorrichtung (OLEDs), organische integrierte Schaltung (O-ICs), organischer Feld-Effekt-Transistor (O-FETs), organischer Dünnfilmtransistor (O-TFTs), organischer lichtemittierender Transistor (O-LETs), organische Solarzelle (O-SCs), organischer optischer Detektor, organischer Photorezeptor, organisches Feld-Quench-Device (O-FQDs), lichtemittierende elektrochemische Zelle (LECs), organische Laserdiode (O-Laser) und "organic plasmon emitting device", enthaltend eine oder mehrere Verbindungen gemäß Formel (9*) bzw. Oligomere, Polymere oder Dendrimere enthaltend diese Teilstruktur gemäß Anspruch 10, 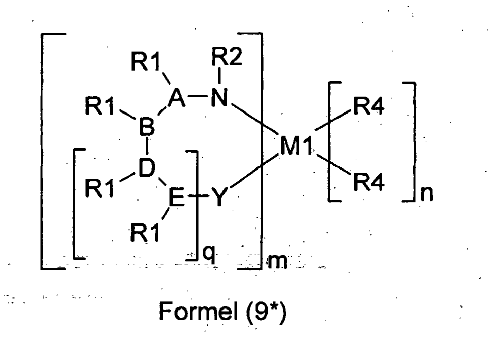 wobei die verwendeten Symbole und Indizes die in Anspruch 11 genannten Bedeutungen aufweisen.

13. Elektronische Vorrichtung nach Anspruch 12, **dadurch gekennzeichnet, dass** die Verbindung gemäß Formel (9*) ausgewählt ist aus den Formeln (10*) bis (17*), 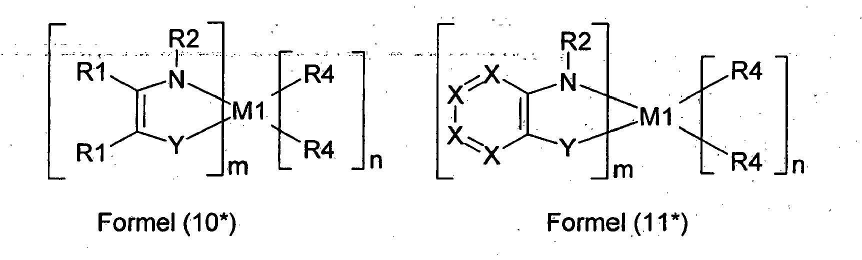 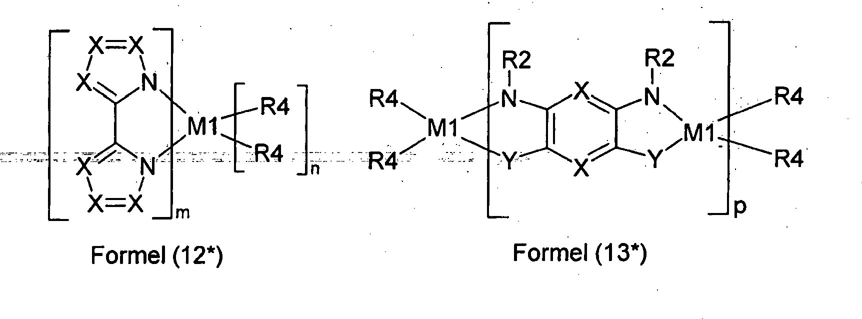 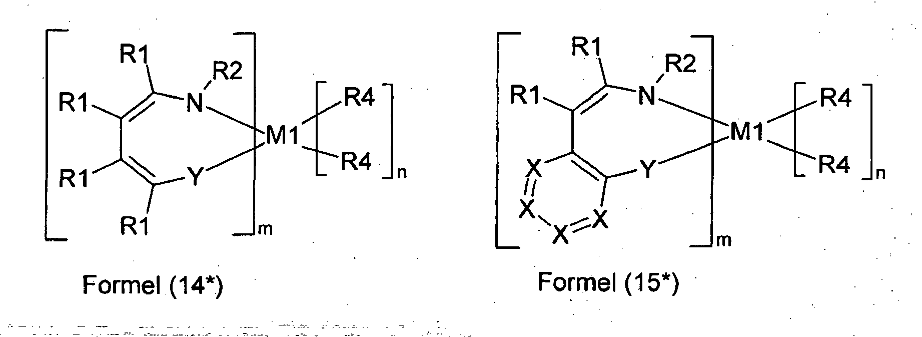 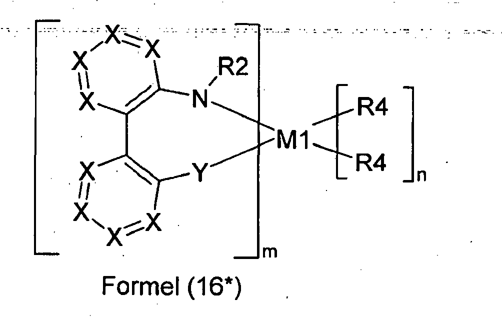 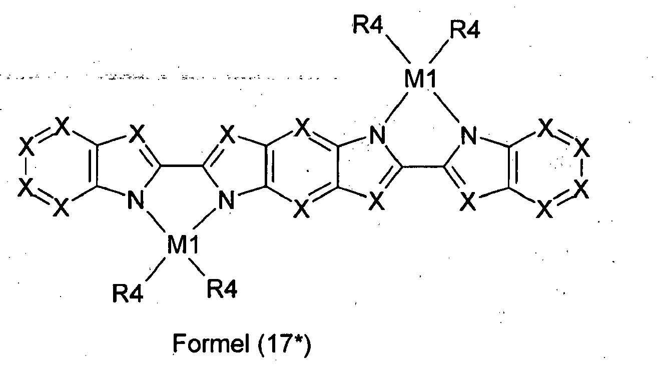 wobei die verwendeten Symbole und Indizes die in Anspruch 11 genannten Bedeutungen aufweisen.

14. Organische Elektrolumineszenzvorrichtung nach Anspruch 12 oder 13, **dadurch gekennzeichnet, dass** die Verbindung gemäß Formel (9*) bis (17*) in einer elektronenblockierenden bzw. exzitonenblockierenden Schicht und/oder in einer Lochtransportschicht und/oder in einer Lochinjektionsschicht und/oder als Matrixmaterial für fluorenzierende oder phosphoreszierende Emitter und/oder als Matrixmaterial für fluoreszierende oder phosphoreszierende Emitter in Kombination mit einem weiteren Matrixmaterial eingesetzt wird.

## Claims

1. Compounds of the formula (9), 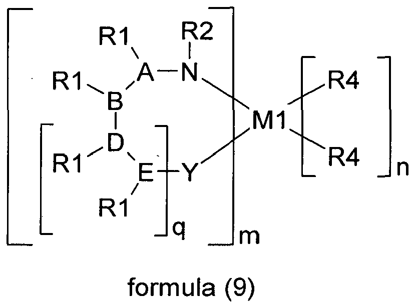 in which
M1 is Si, Ge or Sn;
q is 0 or 1;
A, B, D and E are each a C atom; a double bond or aromatic bond is present between A and B if A does not form an aromatic system with N, and a single bond is present between A and B if A forms an aromatic system with N; furthermore, a double bond or aromatic bond is present between D and E if E does not form an aromatic system with Y, and a single bond is present between D and E if E forms an aromatic system with Y;
Y is selected from the group consisting of NR2, O and S;
R1 is identical or different on each occurrence and is selected from the group consisting of H, D, F, Cl, Br, I, CN, NO₂, N(R3)₂, a straight-chain alkyl, alkoxy or thioalkyl group having 1 to 40 C atoms or a branched or cyclic alkyl, alkoxy or thioalkyl group having 3 to 40 C atoms or an alkenyl group having 2 to 40 C atoms, each of which may be substituted by one or more radicals R3, where one or more non-adjacent CH₂ groups may be replaced by R3C=CR3, C=C, Si(R3)₂, Ge(R3)₂, Sn(R3)₂, C=O, C=S, C=Se, C=NR3, P(=O)(R3), SO, SO₂, NR3, O, S or CONR3 and where one or more H atoms may be replaced by D, F, Cl, Br, I, CN or NO₂, an aromatic or heteroaromatic ring system having 5 to 60 aromatic ring atoms, which may in each case be substituted by one or more radicals R3, an aryloxy or heteroaryloxy group having 5 to 60 aromatic ring atoms, which may be substituted by one or more radicals R3, or a combination of these systems, where two substituents R1 which are adjacent to one another in the 1,2-position in the moiety of the formula (9) may in each case optionally form a monocyclic or polycyclic, aliphatic, aromatic or heteroaromatic ring system which is condensed in a linear or angular manner and which may be substituted by one or more radicals R3;
R2 is identical or different on each occurrence and is selected from the group consisting of a straight-chain alkyl group having 1 to 40 C atoms or a branched or cyclic alkyl group having 3 to 40 C atoms, each of which may be substituted by one or more radicals R3, where one or more non-adjacent CH₂ groups may be replaced by R3C=CR3, C=C or C=O and where one or more H atoms may be replaced by F, Cl, Br, I, CN or NO₂, an aromatic or heteroaromatic ring system having 5 to 60 aromatic ring atoms, which may in each case be substituted by one or more radicals R3, or a combination of these systems; with the proviso that the structure of the formula (9) contains at least one group R2 which represents an aromatic or heteroaromatic ring system, which may in each case be substituted by one or more radicals R3; R1 and R2 which are adjacent to one another in the 1,2-position in the moiety of the formula (9) may optionally form a monocyclic or polycyclic,aliphatic, aromatic or heteroaromatic ring system which is condensed in a linear or angular manner and which may be substituted by one or more radicals R3;
R4 is identical or different on each occurrence and is selected from the group consisting of N(R3)₂, a straight-chain alkyl, alkoxy or thioalkyl group having 1 to 40 C atoms or a branched or cyclic alkyl, alkoxy or thioalkyl group having 3 to 40 C atoms or an alkenyl group having 2 to 40 C atoms, each of which may be substituted by one or more radicals R3, where one or more non-adjacent CH₂ groups may be replaced by R3C=CR3, C≡C, Si(R3)₂, Ge(R3)₂, Sn(R3)₂, C=O, C=S, C=Se, C=NR3, P(=O)(R3), SO, SO₂, NR3, O, S or CONR3 and where one or more H atoms may be replaced by D, F, Cl, Br, I, CN or NO₂, an aromatic or heteroaromatic ring system having 5 to 60 aromatic ring atoms, which may in each case be substituted by one or more radicals R3, an aryloxy or heteroaryloxy group having 5 to 60 aromatic ring atoms, which may be substituted by one or more radicals R3, or a combination of these systems, where two or more substituents R4 may optionally form a monocyclic or polycyclic, aliphatic, aromatic or heteroaromatic ring system which is condensed in a linear or angular manner and which may be substituted by one or more radicals R3;
R3 is identical or different on each occurrence and is selected from the group consisting of H, D, an aliphatic hydrocarbon radical having 1 to 20 C atoms, an aromatic or heteroaromatic ring system having 5 to 30 aromatic ring atoms, in which one or more H atoms may be replaced by D, F, Cl, Br, I, CN or NO₂;
m is 1 or 2;
n is (2 - m);
the following compounds are excluded from the invention:

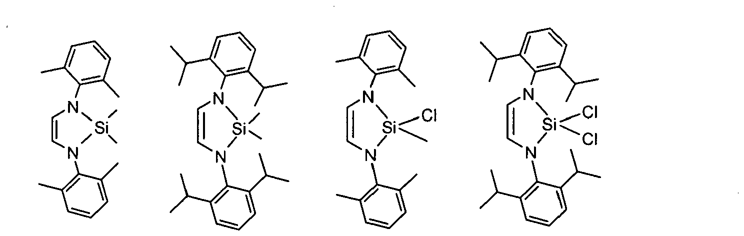

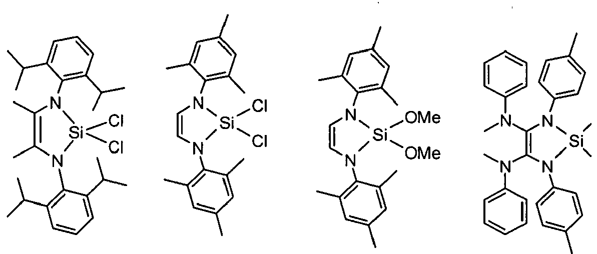

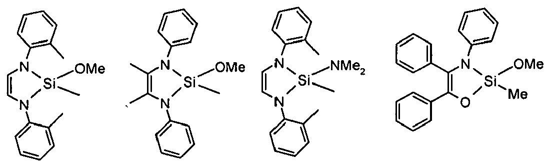

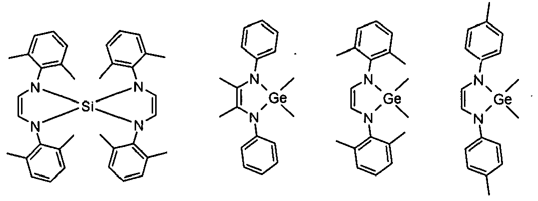

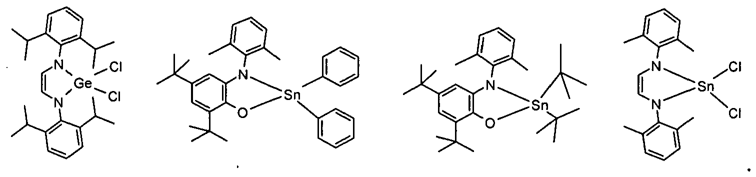

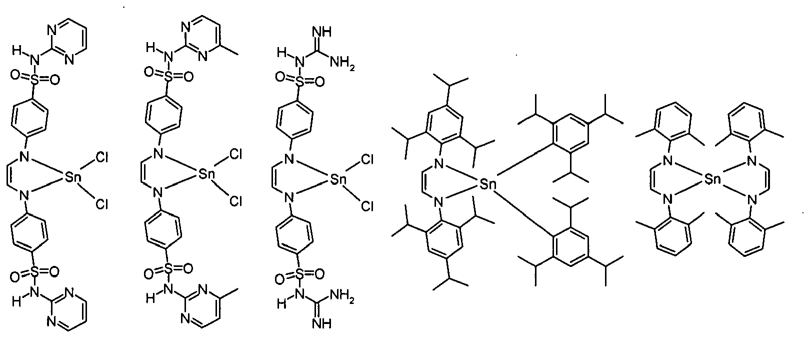

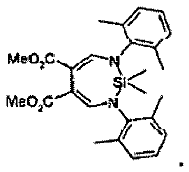

2. Compounds according to Claim 1 of one of the formulae (10) to (17), 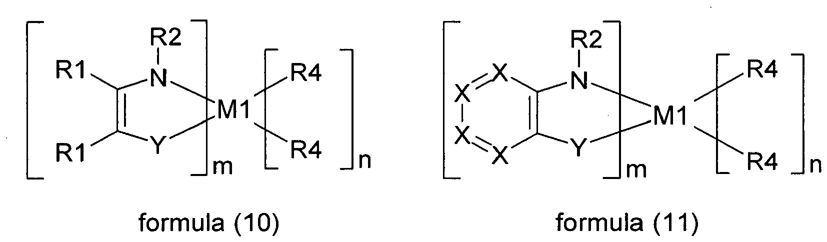 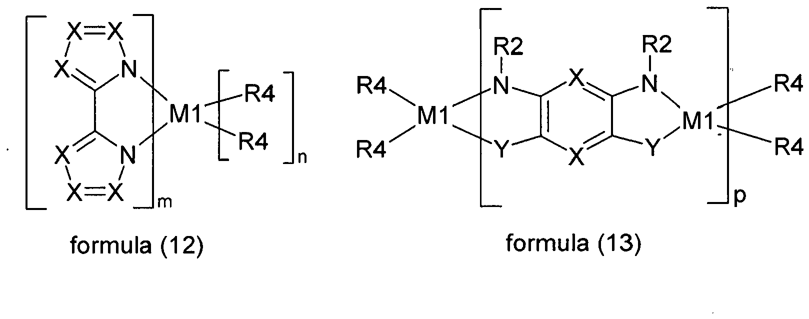 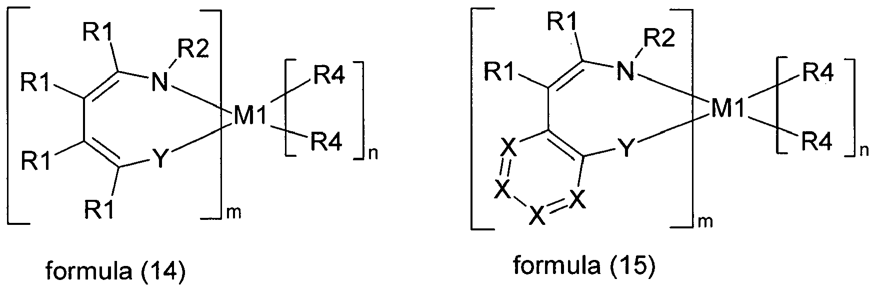 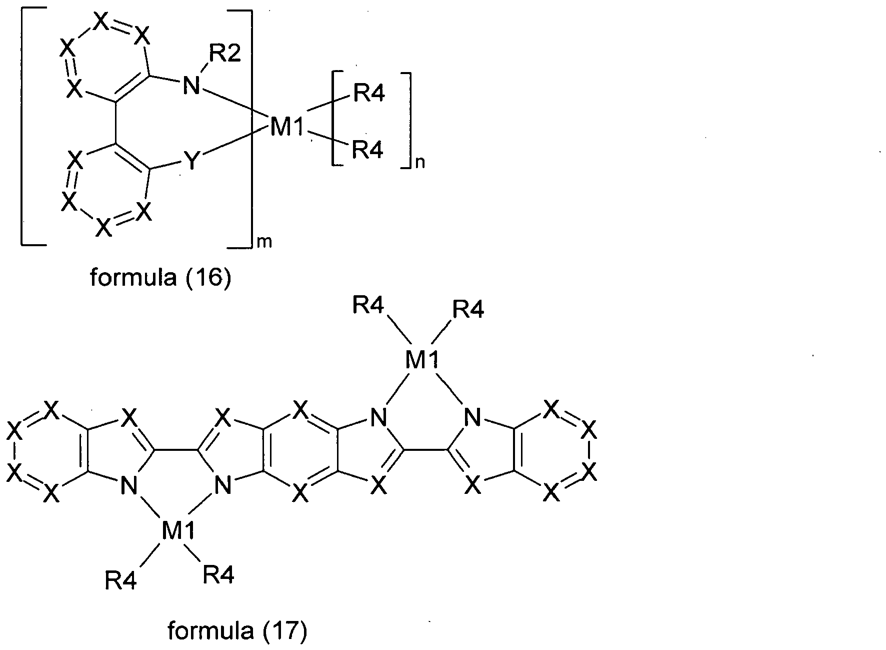 in which M1, R1, R2, R3, R4, Y, m and n are as defined in Claim 1, X is selected, identically or differently on each occurrence, from the group consisting of CR1 and N, and p is an integer from 1 to 100,000, preferably 1 to 10,000, particularly preferably 1 to 100, very particularly preferably 1.

3. Compounds according to Claim 1 or 2, **characterised in that** m = 2 and n = 0.

4. Compounds according to one or more of Claims 1 to 3, **characterised in that** M1 stands for Si or Ge, in particular for Si.

5. Compounds according to one or more of Claims 1 to 4, **characterised in that** Y stands for NR2 or O, in particular NR2.

6. Compounds according to one or more of Claims 2 to 5, **characterised in that** X stands for CR1.

7. Compounds according to one or more of Claims 1 to 6, **characterised in that** R4 is selected on each occurrence, identically or differently, from the group consisting of a straight-chain alkyl group having 1 to 20 C atoms or a branched or cyclic alkyl group having 3 to 20 C atoms, each of which may be substituted by one or more radicals R3, where one or more non-adjacent CH₂ groups may be replaced by R3C=CR3, C=C, Si(R3)₂, Ge(R3)₂, Sn(R3)₂, C=O, C=S, C=Se, C=NR3, P(=O)(R3), SO, SO₂, NR3, O, S or CONR3 and where one or more H atoms may be replaced by F, Cl, Br, I, CN or NO₂, an aromatic or heteroaromatic ring system having 5 to 60 aromatic ring atoms, which may in each case be substituted by one or more radicals R3, or a combination of these systems, where two or more substituents R4 may optionally form a monocyclic or polycyclic aliphatic, aromatic or heteroaromatic ring system which is condensed in a linear or angular manner and which may be substituted by one or more radicals R3.

8. Compounds according to one or more of Claims 1 to 7, in which:
M1 is selected from the group consisting of Si, Ge, preferably Si;
R1 is as defined in Claim 1;
R2 is on each occurrence, identically or differently, an aromatic or heteroaromatic ring system having 5 to 30 aromatic ring atoms, in which one or more H atoms are optionally replaced by F atoms and which may in each case be substituted by one or more radicals R3;
X is equal to CR1;
Y is equal to NR2.

9. Process for the preparation of compounds according to one or more of Claims 1 to 8 by reaction of M1(Hal)₂ₘ(R4)₂ₙ, in particular M1Hal₄, where M1, m and n have the meaning given in Claim 1 and Hal stands for Cl, Br or I, with a corresponding diamine, an aminoalcohol, an aminothiol or the respective deprotonated compound.

10. Oligomers, polymers or dendrimers containing one or more compounds according to one or more of Claims 1 to 8, where one or more bonds are present from the compound according to the invention to the polymer, oligomer or dendrimer.

11. Use of a compound of the formula (9*), 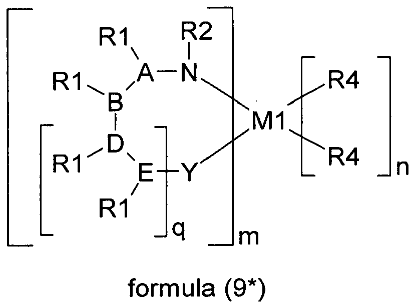 in which:
M1 is selected from Si, Ge, Sn, Ti, Zr, Hf, Cr, Mo and W;
m is 1 or 2 for M1 = Si, Ge, Sn, Ti, Zr or Hf, and 1, 2 or 3 for M1 = Cr, Mo or W;
n is (2 - m) for M1 = Si, Ge, Sn, Ti, Zr or Hf, and (3 - m) for M1 = Cr, Mo or W;
R2 is on each occurrence, identically or differently, a straight-chain alkyl group having 1 to 40 C atoms or a branched or cyclic alkyl group having 3 to 40 C atoms, each of which may be substituted by one or more radicals R3, where one or more non-adjacent CH₂ groups may be replaced by R3C=CR3, C=C or C=O and where one or more H atoms may be replaced by D, F, Cl, Br, I, CN or NO₂, an aromatic or heteroaromatic ring system having 5 to 60 aromatic ring atoms, which may in each case be substituted by one or more radicals R3, or a combination of these systems; with the proviso that the structure of the formula (9*) contains at least one group R2 which represents an aromatic or heteroaromatic ring system, which may in each case be substituted by one or more radicals R3; R1 and R2 which are adjacent to one another in the 1,2-position in the compound of the formula (9*) may optionally form a monocyclic or polycyclic, aliphatic, aromatic or heteroaromatic ring system which is condensed in a linear or angular manner and which may be substituted by one or more radicals R3;
the other symbols and indices used have the meanings given in Claim 1;
or of an oligomer, polymer or dendrimer containing this moiety in organic electronic components.

12. Electronic device, in particular organic electroluminescent device (OLED), organic integrated circuit (O-IC), organic field-effect transistor (O-FET), organic thin-film transistor (O-TFT), organic light-emitting transistor (O-LET), organic solar cell (O-SC), organic optical detector, organic photoreceptor, organic field-quench device (O-FQD), light-emitting electrochemical cell (LEC), organic laser diode (O-laser) or organic plasmon emitting device, comprising one or more compounds of the formula (9*) or oligomers, polymers or dendrimers containing this moiety according to Claim 10, 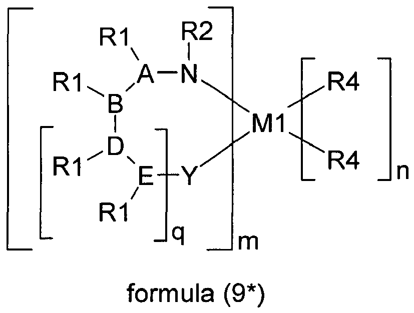 where the symbols and indices used have the meanings given in Claim 11.

13. Electronic device according to Claim 12, **characterised in that** the compound of the formula (9*) is selected from the formulae (10*) to (17*), 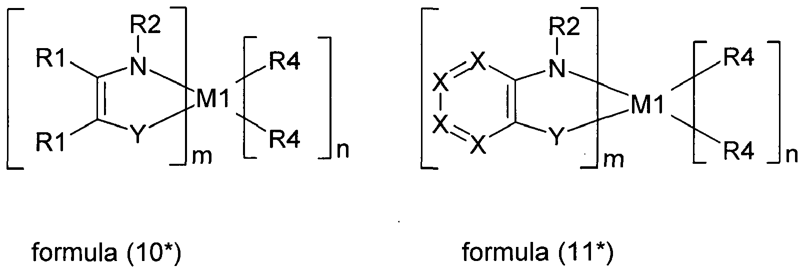 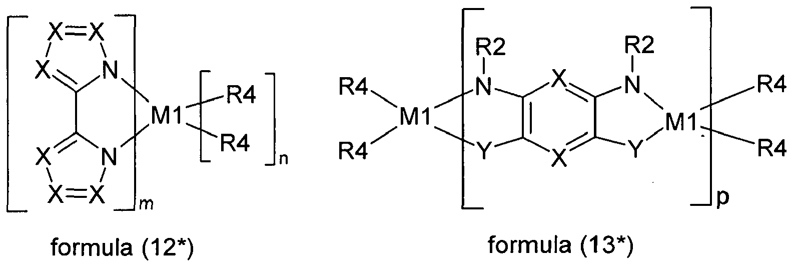 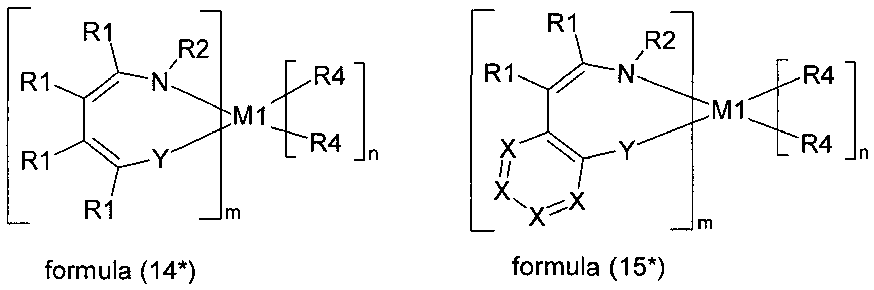 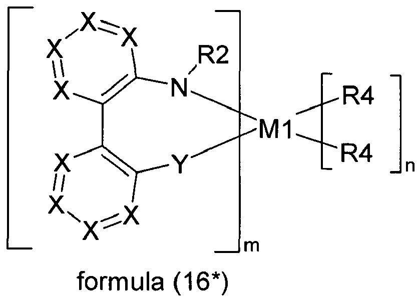 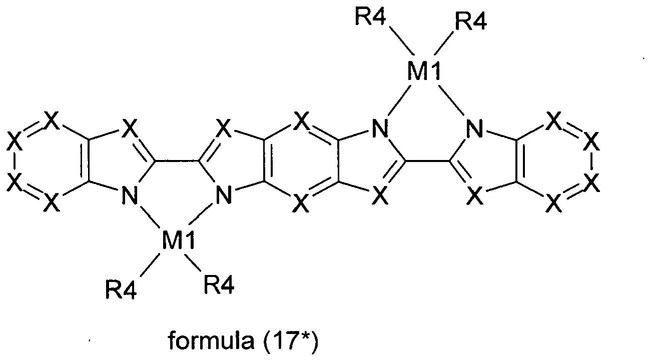 where the symbols and indices used have the meanings given in Claim 11.

14. Organic electroluminescent device according to Claim 12 or 13, **characterised in that** the compound of the formulae (9*) to (17*) is employed in an electron-blocking or exciton-blocking layer and/or in a hole-transport layer and/or in a hole-injection layer and/or as matrix material for fluorescent or phosphorescent emitters and/or as matrix material for fluorescent or phosphorescent emitters in combination with a further matrix material.

## Revendications

1. Composés de la formule (9), 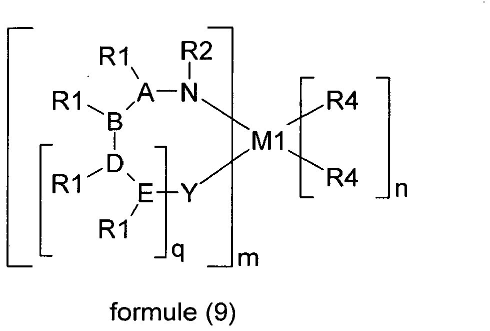 dans laquelle :
M1 est Si, Ge ou Sn ;
q est 0 ou 1 ;
A, B, D et E sont chacun un atome de C ; une liaison double ou une liaison aromatique est présente entre A et B si A ne forme pas un système aromatique avec N, et une liaison simple est présente entre A et B si A forme un système aromatique avec N ; en outre, une liaison double ou une liaison aromatique est présente entre D et E si E ne forme pas un système aromatique avec Y, et une liaison simple est présente entre D et E si E forme un système aromatique avec Y ;
Y est choisi parmi le groupe constitué par NR2, O et S ;
R1 est identique ou différent pour chaque occurrence et est choisi parmi le groupe constitué par H, D, F, CI, Br, I, CN, NO₂, N(R3)₂, un groupe alkyle, alcoxy ou thioalkyle en chaîne droite comportant de 1 à 40 atome(s) de C ou un groupe alkyle, alcoxy ou thioalkyle ramifié ou cyclique comportant de 3 à 40 atomes de C ou un groupe alkényle comportant de 2 à 40 atomes de C, dont chacun peut être substitué par un radical ou plusieurs radicaux R3, où un ou plusieurs groupes CH₂ non adjacents peuvent être remplacés par R3C=CR3, C=C, Si(R3)₂, Ge(R3)₂, Sn(R3)₂, C=O, C=S, C=Se, C=NR3, P(=O)(R3), SO, SO₂, NR3, O, S ou CONR3 et où un ou plusieurs atome(s) de H peut/peuvent être remplacé(s) par D, F, CI, Br, I, CN ou NO₂, un système de cycle aromatique ou hétéroaromatique comportant de 5 à 60 atomes de cycle aromatique, lequel peut dans chaque cas être substitué par un radical ou plusieurs radicaux R3, un groupe aryloxy ou hétéroaryloxy comportant de 5 à 60 atomes de cycle aromatique, lequel peut être substitué par un radical ou plusieurs radicaux R3, ou une combinaison de ces systèmes, où deux substituants R1 qui sont adjacents l'un à l'autre à la position 1,2 dans la moitié de la formule (9) peuvent dans chaque cas en option former un système de cycle aliphatique, aromatique ou hétéroaromatique monocyclique ou polycyclique qui est condensé d'une manière linéaire ou angulaire et qui peut être substitué par un radical ou plusieurs radicaux R3 ;
R2 est identique ou différent pour chaque occurrence et est choisi parmi le groupe constitué par un groupe alkyle en chaîne droite comportant de 1 à 40 atome(s) de C ou un groupe alkyle ramifié ou cyclique comportant de 3 à 40 atomes de C, dont chacun peut être substitué par un radical ou plusieurs radicaux R3, où un ou plusieurs groupes CH₂ non adjacents peuvent être remplacés par R3C=CR3, C=C ou C=O et où un ou plusieurs atome(s) de H peut/peuvent être remplacé(s) par F, CI, Br, I, CN ou NO₂, un système de cycle aromatique ou hétéroaromatique comportant de 5 à 60 atomes de cycle aromatique, lequel peut dans chaque cas être substitué par un radical ou plusieurs radicaux R3, ou une combinaison de ces systèmes ; étant entendu que la structure de la formule (9) contient au moins un groupe R2 qui représente un système de cycle aromatique ou hétéroaromatique, lequel peut dans chaque cas être substitué par un radical ou plusieurs radicaux R3 ; R1 et R2 qui sont adjacents l'un à l'autre à la position 1,2 dans la moitié de la formule (9) peuvent en option former un système de cycle aliphatique, aromatique ou hétéroaromatique monocyclique ou polycyclique qui est condensé d'une manière linéaire ou angulaire et qui peut être substitué par un radical ou plusieurs radicaux R3 ;
R4 est identique ou différent pour chaque occurrence et est choisi parmi le groupe constitué par N(R3)₂, un groupe alkyle, alcoxy ou thioalkyle en chaîne droite comportant de 1 à 40 atome(s) de C ou un groupe alkyle, alcoxy ou thioalkyle ramifié ou cyclique comportant de 3 à 40 atomes de C ou un groupe alkényle comportant de 2 à 40 atomes de C, dont chacun peut être substitué par un radical ou plusieurs radicaux R3, où un ou plusieurs groupes CH₂ non adjacents peuvent être remplacés par R3C=CR3, C=C, Si(R3)₂, Ge(R3)₂, Sn(R3)₂, C=O, C=S, C=Se, C=NR3, P(=O)(R3), SO, SO₂, NR3, O, S ou CONR3 et où un ou plusieurs atome(s) de H peut/peuvent être remplacé(s) par D, F, Cl, Br, I, CN ou NO₂, un système de cycle aromatique ou hétéroaromatique comportant de 5 à 60 atomes de cycle aromatique, lequel peut dans chaque cas être substitué par un radical ou plusieurs radicaux R3, un groupe aryloxy ou hétéroaryloxy comportant de 5 à 60 atomes de cycle aromatique, lequel peut être substitué par un radical ou plusieurs radicaux R3, ou une combinaison de ces systèmes, où deux substituants R4 ou plus peuvent en option former un système de cycle aliphatique, aromatique ou hétéroaromatique monocyclique ou polycyclique qui est condensé d'une manière linéaire ou angulaire et qui peut être substitué par un radical ou plusieurs radicaux R3;
R3 est identique ou différent pour chaque occurrence et est choisi parmi le groupe constitué par H, D, un radical hydrocarbone aliphatique comportant de 1 à 20 atome(s) de C, un système de cycle aromatique ou hétéroaromatique comportant de 5 à 30 atomes de cycle aromatique, où un ou plusieurs atome(s) de H peut/peuvent être remplacé(s) par D, F, Cl, Br, I, CN ou NO₂ ;
m est 1 ou 2 ;
n est (2 - m) ;
les composés qui suivent sont exclus de l'invention :

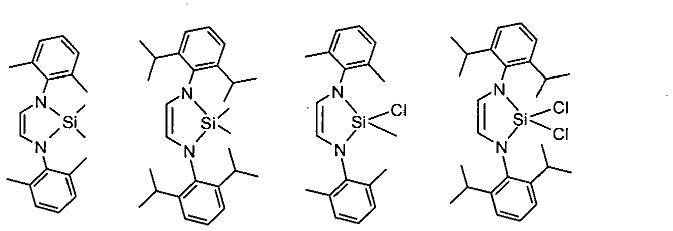

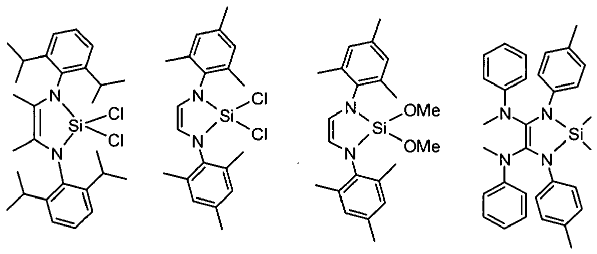

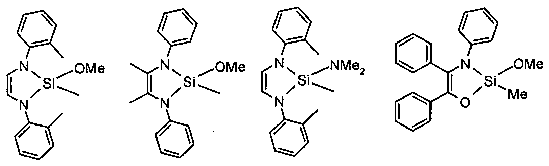

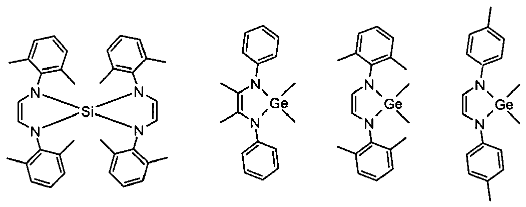

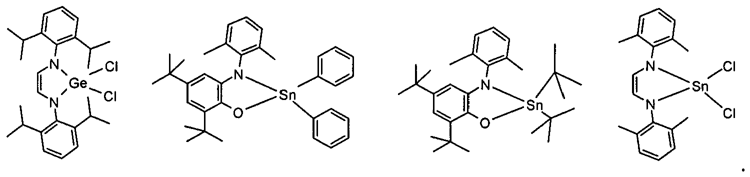

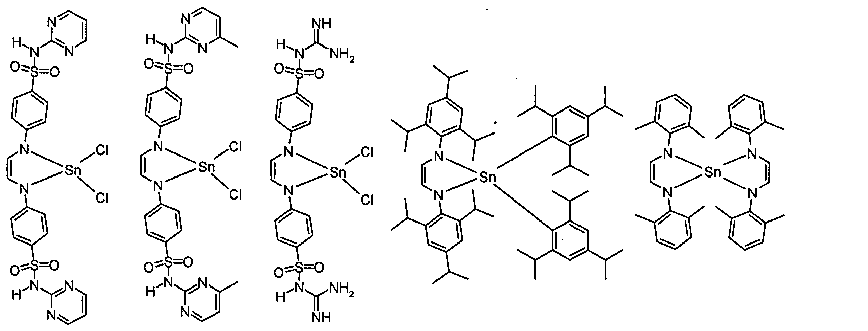

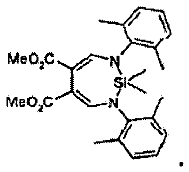

2. Composés selon la revendication 1 de l'une des formules (10) à (17) : 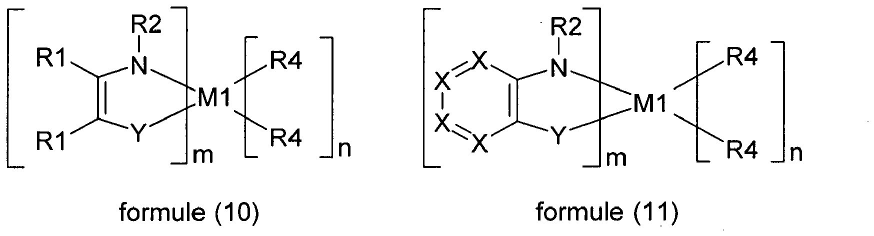 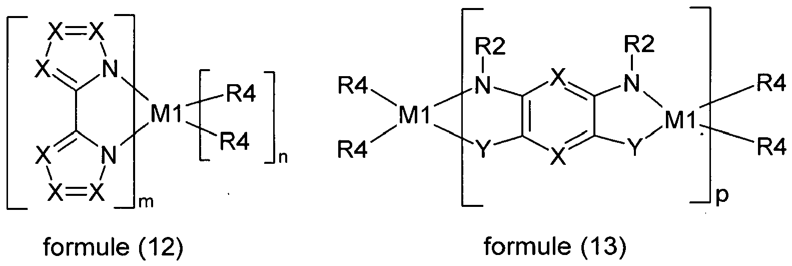 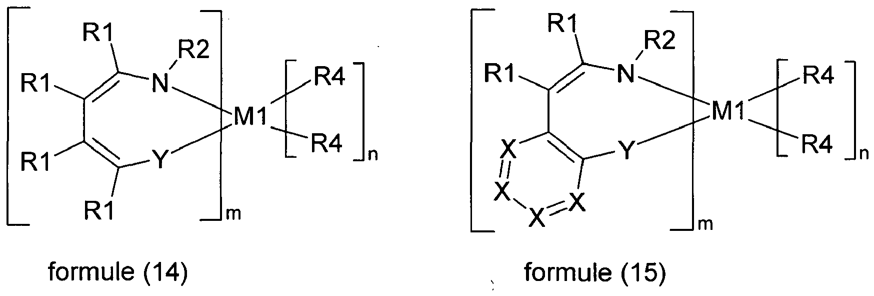 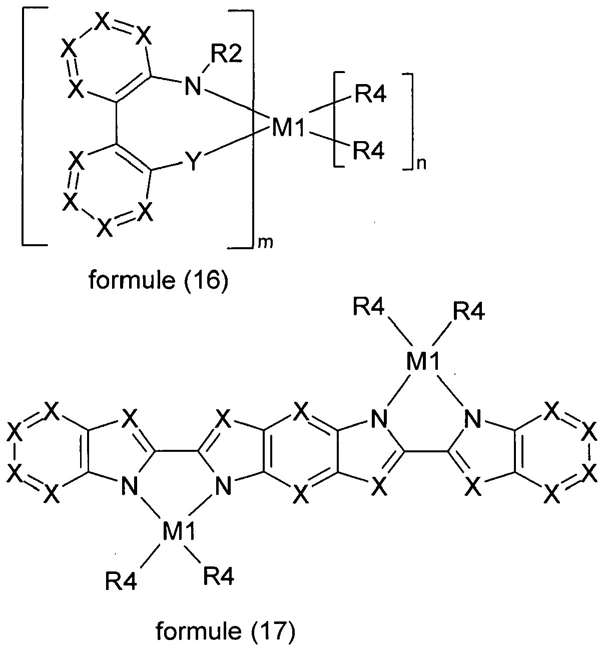 dans lesquelles M1, R1, R2, R3, R4, Y, m et n sont comme défini selon la revendication 1, X est choisi, de manière identique ou différente pour chaque occurrence, parmi le groupe constitué par CR1 et N, et p est un entier de 1 à 100 000, de façon préférable de 1 à 10 000, de façon particulièrement préférable, de 1 à 100, de façon très particulièrement préférable, 1.

3. Composés selon la revendication 1 ou 2, **caractérisés en ce que** m = 2 et n = 0.

4. Composés selon une ou plusieurs des revendications 1 à 3, **caractérisés en ce que** M1 représente Si ou Ge, en particulier Si.

5. Composés selon une ou plusieurs des revendications 1 à 4, **caractérisés en ce que** Y représente NR2 ou O, en particulier NR2.

6. Composés selon une ou plusieurs des revendications 2 à 5, **caractérisés en ce que** X représente CR1.

7. Composés selon une ou plusieurs des revendications 1 à 6, **caractérisés en ce que** R4 est choisi, pour chaque occurrence, de manière identique ou différente, parmi le groupe constitué par un groupe alkyle en chaîne droite comportant de 1 à 20 atome(s) de C ou un groupe alkyle ramifié ou cyclique comportant de 3 à 20 atomes de C, dont chacun peut être substitué par un radical ou plusieurs radicaux R3, où un ou plusieurs groupes CH₂ non adjacents peuvent être remplacés par R3C=CR3, C=C, Si(R3)₂, Ge(R3)₂, Sn(R3)₂, C=O, C=S, C=Se, C=NR3, P(=O)(R3), SO, SO₂, NR3, O, S ou CONR3 et où un ou plusieurs atome(s) de H peut/peuvent être remplacé(s) par F, Cl, Br, I, CN ou NO₂, un système de cycle aromatique ou hétéroaromatique comportant de 5 à 60 atomes de cycle aromatique, lequel peut dans chaque cas être substitué par un radical ou plusieurs radicaux R3, ou une combinaison de ces systèmes, où deux substituants R4 ou plus peuvent en option former un système de cycle aliphatique, aromatique ou hétéroaromatique monocyclique ou polycyclique qui est condensé d'une manière linéaire ou angulaire et qui peut être substitué par un radical ou plusieurs radicaux R3.

8. Composés selon une ou plusieurs des revendications 1 à 7, dans lesquels :
M1 est choisi parmi le groupe constitué par Si, Ge, de façon préférable Si ;
R1 est comme défini selon la revendication 1 ;
R2 est, pour chaque occurrence, de manière identique ou différente, un système de cycle aromatique ou hétéroaromatique comportant de 5 à 30 atomes de cycle aromatique, où un ou plusieurs atome(s) de H est/sont en option remplacé(s) par des atomes de F et lequel peut dans chaque cas être substitué par un radical ou plusieurs radicaux R3 ;
X est égal à CR1 ;
Y est égal à NR2.

9. Procédé pour la préparation de composés selon une ou plusieurs des revendications 1 à 8 par réaction de M1 (Hal)₂ₘ(R4)₂ₙ, en particulier de M1Hal₄, où M1, m et n présentent la signification donnée selon la revendication 1 et Hal représente Cl, Br ou I, avec un diamine correspondant, un aminoalcool, un aminothiol ou le composé déprotonaté respectif.

10. Oligomères, polymères ou dendrimères contenant un ou plusieurs composé(s) selon une ou plusieurs des revendications 1 à 8, où une ou plusieurs liaison(s) est/sont présente(s) depuis le composé selon l'invention jusqu'au polymère, oligomère ou dendrimère.

11. Utilisation d'un composé de la formule (9*) : 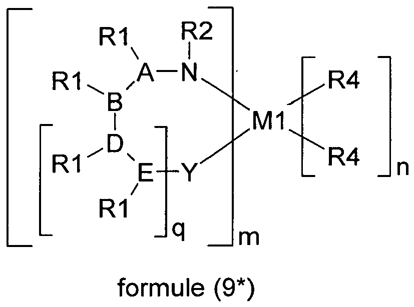 dans laquelle :
M1 est choisi parmi Si, Ge, Sn, Ti, Zr, Hf, Cr, Mo et W ;
m est 1 ou 2 pour M1 = Si, Ge, Sn, Ti, Zr ou Hf, et 1, 2 ou 3 pour M1 = Cr, Mo ou W ;
n est (2 - m) pour M1 = Si, Ge, Sn, Ti, Zr ou Hf, et (3 - m) pour M1 = Cr, Mo ou W ;
R2 est, pour chaque occurrence, de manière identique ou différente, un groupe alkyle en chaîne droite comportant de 1 à 40 atome(s) de C ou un groupe alkyle ramifié ou cyclique comportant de 3 à 40 atome(s) de C, dont chacun peut être substitué par un radical ou plusieurs radicaux R3, où un ou plusieurs groupes CH₂ non adjacents peuvent être remplacés par R3C=CR3, C=C ou C=O et où un ou plusieurs atome(s) de H peut/peuvent être remplacé(s) par D, F, Cl, Br, I, CN ou NO₂, un système de cycle aromatique ou hétéroaromatique comportant de 5 à 60 atomes de cycle aromatique, lequel peut dans chaque cas être substitué par un radical ou plusieurs radicaux R3, ou une combinaison de ces systèmes ; étant entendu que la structure de la formule (9*) contient au moins un groupe R2 qui représente un système de cycle aromatique ou hétéroaromatique, lequel peut dans chaque cas être substitué par un radical ou plusieurs radicaux R3 ; R1 et R2 qui sont adjacents l'un à l'autre à la position 1,2 dans le composé de la formule (9*) peuvent en option former un système de cycle aliphatique, aromatique ou hétéroaromatique monocyclique ou polycyclique qui est condensé d'une manière linéaire ou angulaire et qui est substitué par un radical ou plusieurs radicaux R3 ;
les autres symboles et indices utilisés présentent les significations données selon la revendication 1 ;
ou d'un oligomère, polymère ou dendrimère contenant cette moitié dans des composants électroniques organiques.

12. Dispositif électronique, en particulier dispositif électroluminescent organique (OLED), circuit intégré organique (O-IC), transistor à effet de champ organique (O-FET), transistor à film mince organique (O-TFT), transistor à émission de lumière organique (O-LET), cellule solaire organique (O-SC), détecteur optique organique, photorécepteur organique, dispositif à extinction de champ organique (O-FQD), cellule électrochimique à émission de lumière (LEC), diode laser organique (O-laser) ou dispositif à émission de plasmon organique, comprenant un ou plusieurs composé(s) de la formule (9*) ou des oligomères, polymères ou dendrimères contenant cette moitié selon la revendication 10, 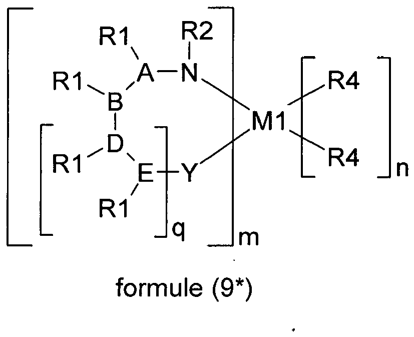 dans laquelle les symboles et indices utilisés présentent les significations données selon la revendication 11.

13. Dispositif électronique selon la revendication 12, **caractérisé en ce que** le composé de la formule (9*) est choisi parmi les formules (10*) à (17*) : 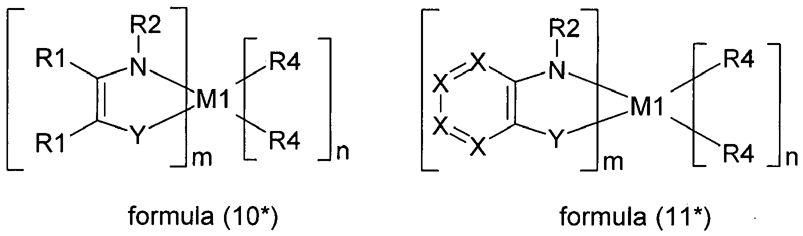 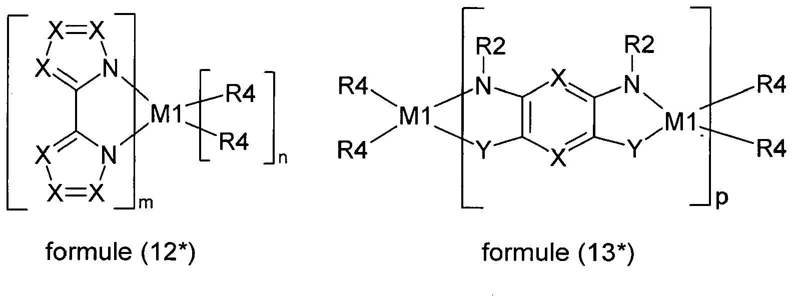 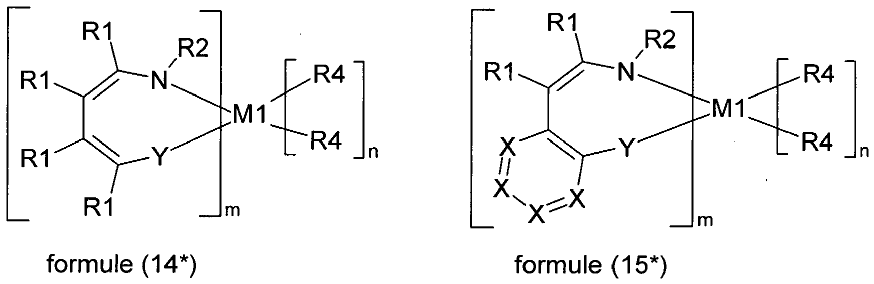 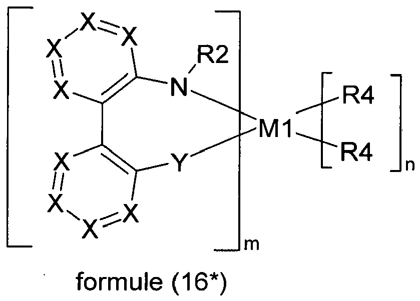 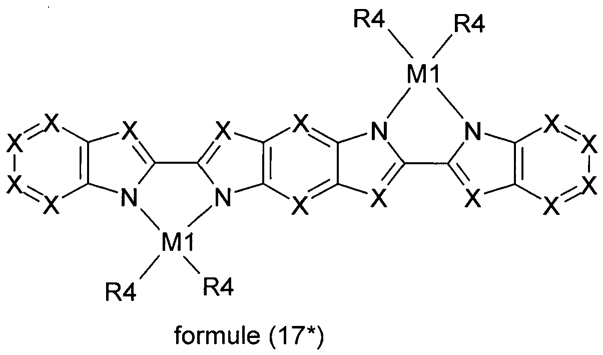 dans lesquelles les symboles et indices utilisés présentent les significations données selon la revendication 11.

14. Dispositif électroluminescent organique selon la revendication 12 ou 13, **caractérisé en ce que** le composé des formules (9*) à (17*) est utilisé dans une couche de blocage d'électrons ou de blocage d'excitons et/ou dans une couche de transport de trous et/ou dans une couche d'injection de trous et/ou en tant que matériau de matrice pour des émetteurs fluorescents ou phosphorescents et/ou en tant que matériau de matrice pour des émetteurs fluorescents ou phosphorescents en combinaison avec un autre matériau de matrice.
